(19) Europäisches Patentamt
European Patent Office
Office européen des brevets

(11) **EP 2 541 763 B1**

(12) **EUROPEAN PATENT SPECIFICATION**

(45) Date of publication and mention
of the grant of the patent:
**05.12.2018 Bulletin 2018/49**

(21) Application number: **10846596.4**

(22) Date of filing: **26.10.2010**

(51) Int Cl.:
*H03F 1/26* (2006.01)     *H03F 1/00* (2006.01)
*H03F 1/30* (2006.01)     *H03F 1/52* (2006.01)
*H03F 3/195* (2006.01)

(86) International application number:
**PCT/JP2010/068991**

(87) International publication number:
**WO 2011/104933 (01.09.2011 Gazette 2011/35)**

(54) **BIAS CIRCUIT, LNA, LNB, RECEIVER FOR COMMUNICATION, TRANSMITTER FOR COMMUNICATION, AND SENSOR SYSTEM**

BIAS-SCHALTUNG, LNA, LNB, KOMMUNIKATIONSEMPFÄNGER, KOMMUNIKATIONSSENDER UND SENSORENSYSTEM

CIRCUIT DE POLARISATION, LNA, LNB, RÉCEPTEUR DE COMMUNICATIONS, ÉMETTEUR DE COMMUNICATION ET SYSTÈME DE DÉTECTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.08.2010 JP 2010191220**
**25.02.2010 JP 2010040887**

(43) Date of publication of application:
**02.01.2013 Bulletin 2013/01**

(73) Proprietor: **Sharp Kabushiki Kaisha**
**Osaka-shi, Osaka 545-8522 (JP)**

(72) Inventor: **MARUYAMA, Masahiko**
**Osaka 545-8522 (JP)**

(74) Representative: **Müller Hoffmann & Partner**
**Patentanwälte mbB**
**St.-Martin-Strasse 58**
**81541 München (DE)**

(56) References cited:
**JP-A- 2 141 110**     **JP-A- 4 120 906**
**JP-A- 60 119 107**     **JP-A- 62 248 015**
**JP-A- 2000 295 128**     **JP-A- 2003 088 103**
**JP-A- 2004 109 048**     **JP-A- 2005 011 133**
**JP-A- 2006 081 009**     **JP-U- H03 117 930**
**US-A1- 2003 038 679**

**Description**

Technical Field

The present invention relates to a bias circuit for supplying a bias voltage to an FET (Field Effect Transistor), an LNA (Low Noise Amplifier), LNB (Low Noise Block Converter), a receiver for communication, a transmitter for communication, and a sensor system, especially to a bias circuit for HEMT (High Electron Mobility Transistor) for use in LNA for satellite broadcast receiver.

Moreover, the present invention also relates to a bias circuit, an LNA, and an LNB, each of which is capable of switching whether to supply a bias to an FET, especially to a technique by which an HEMT for use in an LNA of an LNB for receiving satellite broadcast is protected in switching whether to perform the supply of the bias.

Background Art

Conventionally, satellite broadcasting is carried out by transmitting a minute signal of Ku band (12 GHz to 18 GHz) from a communication satellite to a receiving side such as an individual house. In the receiving side, the signal received from the communication satellite is amplified and down-converted by an LNB. The signal thus processed by the LNB is then transmitted to a tuner.

For good reception of a minute signal, the LNB is required to be such that the LNA for amplifying the signal received from an antenna should have a low NF (Noise Figure). Thus, the LNA is usually provided with an HEMT. The HEMT is capable of receiving signals of Ku bands, and has a low NF. In order to design an LNA with an HEMT so as to give desired gain and NF to the LNA, the HEMT should be designed to have optimal drain voltage and drain current.

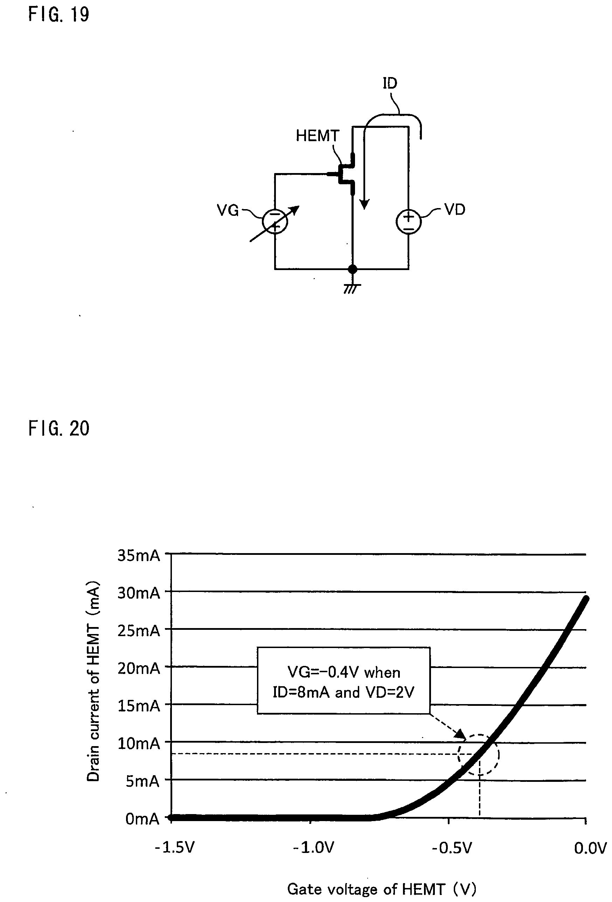

A drain current characteristics of the HEMT is explained below. Fig. 19 is a circuit diagram for explaining a bias of the HEMT. Fig. 20 is a graph illustrating a relationship between a gate voltage and the drain current of the HEMT.

In HEMT, an ampere value of a drain current ID is dependent on a volt value of a gate voltage VG. For example, in case where it is designed that an optimal drain voltage VD is 2V and an optimal drain current ID is 8 mA, a necessary gate voltage VG is approximately -0.4 V, as illustrated in Fig. 20. Thus, it is necessary to apply a predetermined bias on the HEMT (FET) for the LNA in order to attain the desired drain voltage VD and the desired drain current ID at the same time. For this reason, a bias circuit is used to supply the predetermined bias, so as to drive the HEMT at an appropriate operation point. The bias circuit is configured to automatically find out and determines such a gate voltage VG of approximately -0.4 V that allows to attain VD = 2 V and ID = 8 mA at the same time.

Conventionally such bias circuits have been proposed that are, as described above, configured to automatically control the gate voltage so as to determine the designed drain voltage and the designed drain current at the same time. One of them is a bias circuit disclosed in Patent Literature 1, which is a fundamental one among such bias circuits.

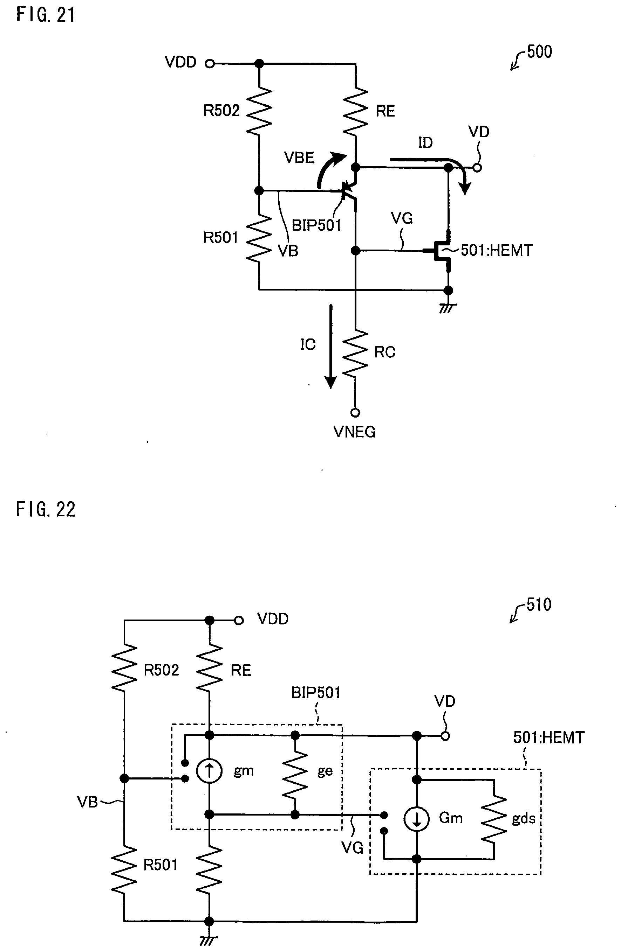

Fig. 21 is a circuit diagram illustrating a conventional HEMT bias circuit 500 disclosed in Patent Literature 1. The HEMT bias circuit 500 is a bias circuit for an HEMT 501 whose source terminal is grounded. As illustrated in Fig. 21, the HEMT bias circuit 500 includes a bipolar transistor BIP 501, an emitter-side resistor RE, a collector-side resistor RC, a resistor R 501, and a resistor R 502.

The bipolar transistor BIP 501 has an emitter terminal connected to a drain terminal of the HEMT 501 and connected to a power supply voltage VDD via the emitter-side resistor RE. The bipolar transistor BIP 501 has a collector terminal connected to a gate terminal of the HEMT 501 and connected to a negative power supply voltage VNEG via the collector-side resistor RC. The bipolar transistor BIP 501 has a base terminal connected to a source terminal of the HEMT 501 via the resistor R 501 and connected to the power supply voltage VDD via the transistor R 502.

In the HEMT bias circuit 500, the HEMT 501 is part of a negative feedback loop. By this, the drain voltage VD and the drain current ID of the HEMT 501 are automatically determined as expressed by approximation formulae (1) and (2) below.

[Math. 1]

$$V_D \approx V_B + V_{BE} = \frac{R_1}{R_1 + R_2} * VDD + V_{BE} \qquad \ldots (1)$$

$$I_D \approx \frac{VDD - V_D}{R_E} = \frac{1}{R_E}\left(\frac{R_2}{R_1 + R_2} * VDD - V_{BE}\right) \qquad \ldots (2)$$

where the values in the approximation formulae (1) and (2) are as follows.

$V_D$: Volt value of the drain voltage VD
$I_D$: Ampere value of the drain current ID
$V_B$: Volt value of the base voltage VB
$V_{BE}$: Volt value of a base-emitter voltage VBE
VDD: Volt value of the power supply voltage VDD
$R_E$: Resistance value of the emitter-side resistor RE
$R_1$: Resistance value of the resistor R 501
$R_2$: Resistance value of the resistor R 502

Citation List

Patent Literatures

Patent Literature 1
Japanese Patent Application Publication, Tokukaisho, No. 59-194522 A (published on November 5, 1984)

Summary of Invention

Technical Problem

However, the conventional HEMT bias circuit 500 has the following four problems: (1) temperature dependency; (2) power source voltage dependency; (3) noises from the power supply voltage and the negative power supply voltage; and (4) restrictions in production process. The HEMT bias circuit 500 should maintain the desired drain voltage and the desired drain current regardless of a surrounding temperature or the power supply voltage. Moreover, it is necessary to avoid to transmit, to the drain terminal and the gate terminal of the HEMT 501, the noise on the power from the power supply.

(1) Temperature dependencies

The HEMT bias circuit 500 as illustrated in Fig. 21 is configured such that the drain voltage VD and the drain current ID of the HEMT 501 is determined by using a potential difference caused due to the base-emitter voltage VBE of the bipolar transistor BIP 501. This leads to a problem that the drain voltage VD and the drain current ID are dependent on a surrounding temperature.
The base-emitter voltage VBE is expressed by the following formulae (3) and (4):
[Math. 2]

$$V_{BE} = \frac{k*T}{q} * \ln\left(\frac{I_C}{I_S}\right) \qquad \ldots(3)$$

$$I_S = b*T^{4+m} * \exp\left(-\frac{E_g}{k*T}\right) \quad \ldots(4)$$

where the values in the formulae are as follows.

$V_{BE}$: Volt value of the base-emitter voltage VBE
k: Boltzmann constant
T: Absolute temperature
q: Elementary Electric Charge Amount
$I_C$: Collector current
b: Proportional constant

m: constant
Eg: Bandgap energy of silicon

The temperature dependencies of the drain voltage VD and the drain current ID can be worked out by differentiating the formulae (1) and (2) with the temperature T, and can be expressed as the following formulae (5) and (6).
[Math. 3]

$$\frac{\partial V_D}{\partial T} = \frac{V_{BE} - (4+m)*V_T - E_g/q}{T} \dots (5)$$

$$\frac{\partial I_D}{\partial T} = -\frac{V_{BE} - (4+m)*V_T - E_g/q}{R_E*T} \dots (6)$$

Here, for example, consider a case of setting such that ID = 8 mA, VD= 2V, and VDD = 3.3V. In this case, the following formulae (7) and (8) can be obtained from the formulae (5) and (6) where parameters of the HEMT bias circuit 500 of Fig. 21 are selected such that R 501 = 1 kΩ, R 502 = 1.75 kΩ, and RE = 50 Ω, and where VBE = 0.8 V, Eg = 1.12 eV, and m = -3/2.
[Math. 4]

$$\frac{\partial V_D}{\partial T} = -1.28mV/^\circ C \dots (7)$$

$$\frac{\partial I_D}{\partial T} = 25.6\mu A/^\circ C \dots (8)$$

That is, a temperature change of 100 °C reduces the drain voltage VD by about 0.1 V and increases the drain current ID by about 2 mA. Especially, the temperature dependency of the drain current ID is problematic. When the drain current ID increases in association with an increase in the surrounding temperature, the drain current ID causes heat generation in the HEMT 501, thereby further increasing the temperature. This results in a further increase in the drain current ID. Thereafter, thermal positive feedback takes place until a thermal equilibrium between the heat release and the heat generation is reached. Because of this, the HEMT bias circuit 500 has such a restriction that its surrounding temperature should be kept low.

(2) Power supply voltage dependency

An output signal of the LNA is dependent on the drain voltage VD and the gate voltage VG of the HEMT 501. As expressed in the formulae (1) and (2), the drain voltage VD of the HEMT bias circuit 500 of Fig. 21 is a linear function of the power supply voltage VDD. From this, it can be understand that the drain voltage VD of the HEMT bias circuit 500 strongly correlates to the change (noise-caused change) in the power supply voltage VDD.

(3) Noises from the power supply voltage and negative power supply voltage

When the power supply voltage VDD or the negative power supply voltage VNEG has a noise, a PSRR (Power Supply Rejection Ratio) becomes important. The PSRR is an index indicating how much a noise from a certain power supply voltage (here, the power supply voltage VDD and a negative power supply voltage VNEG) is attenuated at a terminal of interest.

(3-1) PSRR against power supply voltage VDD

In order to know details of the dependencies of the drain voltage VD and the gate voltage VG on the power supply voltage VDD, it is necessary to solve a small-signal equivalent circuit. Therefore, a PSRR against the power supply voltage VDD in the HEMT bias circuit 500 of Fig. 21 is shown here in Fig. 22. Fig. 22 shows a small-signal equivalent circuit 510 for the power supply voltage VDD of the HEMT bias circuit 500. From the Kirchhoff's current law on current, the following formulae (9) and (10) are obtained.
[Math. 5]

$$gm * \left(V_D - V_B\right) + ge * \left(V_D - V_G\right) + \frac{V_D - VDD}{R_E} + V_G * Gm + V_D * gds = 0 \dots (9)$$

$$gm * \left(V_B - V_D\right) + ge * \left(V_G - V_D\right) + \frac{V_G}{R_C} = 0 \dots (10)$$

where the values in the formulae are as follows.

gm: Mutual conductance of bipolar transistor BIP 501
ge: Collector-emitter conductance of bipolar transistor BIP 501
Gm: Mutual conductance of HEMT 501
gds: drain-source conductance of HEMT 501
VDD: Volt value of power supply voltage VDD
$V_D$: Volt value of drain voltage VD
$V_G$: Volt value of gate voltage VG
$V_B$: Volt value of base voltage VB
$R_E$: Resistance value of emitter-side resistor RE
$R_C$: Resistance value of collector-side resistor RC

The drain voltage VD and the gate voltage VG found out by solving a simultaneous linear equation for formulae (9) and (10) are differentiated with the power supply voltage VDD and expressed in decibel to find the PSRRs of the drain voltage VD and the gate voltage VG for the power supply VDD as shown in the following formulae (11) and (12). Note that the calculations were simplified by approximations of sufficiently small terms therein.
[Math. 6]

$$PSRR_{V_D}\Big|_{VDD} \approx 20 * \log\left(\frac{R_1}{R_1 + R_2}\right) \dots (11)$$

$$PSRR_{V_G}\Big|_{VDD} \approx 20 * \log\left(\frac{1}{R_E * Gm} * \left(\frac{R_2}{R_1 + R_2}\right)\right) \dots (12)$$

The formulae (11) and (12) demonstrate that the noise almost not attenuated is transmitted to the drain voltage VD and the gate voltage VG from the power supply voltage VDD.
Next, the following discusses as to whether or not an attenuation amount caused by the attenuation is sufficient for LNA application. For example, suppose that it is designed to achieve that ID = 8 mA, VD= 2 V, and VDD = 3.3 V. In this case, if it is set that Gm = 50 mS, R 501 = 1 kΩ, R 502 = 1.75 kΩ, and RE = 50 Ω, the PSRRs of the drain voltage VD and the gate voltage VG for the power supply voltage VDD are expressed by the following formulae (13) and (14).
[Math. 7]

$$PSRR_{V_D}\big|_{VDD} \approx -8.8dB \ldots (13)$$

$$PSRR_{V_G}\big|_{VDD} \approx -12dB \ldots (14)$$

The PSRRs thus obtained are not sufficient for LNA application and cause a problem when the power supply voltage VDD has a noise. In this case, if the signal power is - 90 dBm, it is necessary that a noise power superimposing on the negative power supply voltage VNEG should be kept at such a very low level of at most -90 dBm in order.

(3-2) PSRR against the negative power supply voltage VNEG

As illustrated in Fig. 20, the gate voltage of the HEMT should negative. That is, the HEMT for use in the LNA should have a positive power supply voltage and a negative power supply voltage.

In general, the LNB provided to a parabola antenna is connected with a television or a video set via a coaxial cable, thereby being supplied with power via the coaxial cable from the television or the video set. In this case, the LNB receives the power only from a power supply of a positive voltage. Therefore, a charge pump is used to create a negative power supply voltage from the positive power supply voltage.

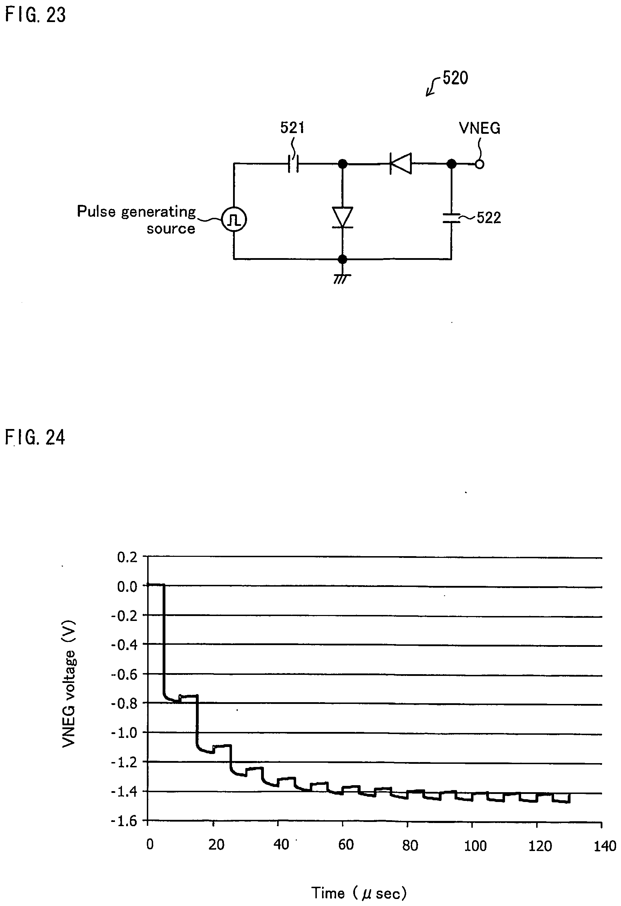

Fig. 23 is a circuit diagram illustrating a configuration of a negative voltage generating circuit 520. Fig. 24 is a waveform diagram illustrating a voltage waveform of a negative voltage VNEG.

As illustrated in Fig. 23, the negative voltage generating circuit 520 is realized by a charge pump circuit. In the charge pump circuit, pulsed voltages are applied to capacitors 521 and 522. By charging and discharging an electric charge between the capacitors 521 and 522, an output at an output terminal is gradually approximated to the negative voltage VNEG. The negative voltage VNEG has such a voltage waveform that, as illustrated in Fig. 24, a negative DC voltage is superimposed with a pulsed noise.

In order to supply a negative voltage to the gate terminal of the HEMT 501 in the HEMT bias circuit 500 of Fig. 21, the VNEG terminal is connected with an output terminal of the negative voltage generating circuit 520 of Fig. 23. In this configuration, if the pulsed noise superimposing on the negative DC voltage as illustrated in Fig. 24 is leaked to the gate terminal and the drain terminal of the HEMT 501, this leads to deterioration in output signal quality of the LNA.

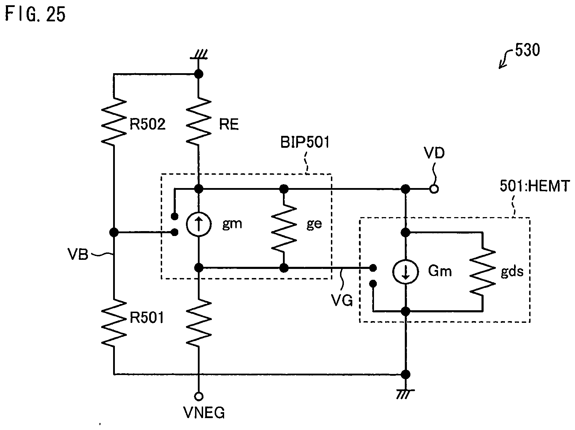

A PSRR against the negative power supply voltage VNEG in the HEMT bias circuit 500 of Fig. 21 is described below, referring to Fig. 25. Fig. 25 illustrates a small-signal equivalent circuit 530 for the negative power supply voltage VNEG in the HEMT bias circuit 500. From the Kirchhoff's current law on current, the following formulae (15) and (16) are obtained.

[Math. 8]

$$gm*(V_D - V_B) + ge*(V_D - V_G) + \frac{V_D}{R_E} + V_G*Gm + V_D*gds = 0 \ldots (15)$$

$$gm*(V_B - V_D) + ge*(V_G - V_D) + \frac{V_G - VNEG}{R_C} = 0 \ldots (16)$$

In formulae (15) and (16), the values are identical with the formulae (9) and (10), except that VNEG is a volt value of the negative power supply voltage VNEG.

The drain voltage VD and the gate voltage VG found out by solving a simultaneous linear equation of formulae (15) and (16) are differentiated with the negative power supply voltage VNEG and expressed in decibel to find the PSRRs of the drain voltage VD and the gate voltage VG for negative power supply voltage VNEG as shown in the following formulae (17) and (18). Note that the calculations were simplified by approximations of sufficiently small terms therein.

[Math. 9]

$$PSRR_{V_D}\Big|_{VNEG} \approx 20*\log\left(\frac{1}{1+gm*R_C}\right)...(17)$$

$$PSRR_{V_G}\Big|_{VNEG} \approx 20*\log\left(\frac{1}{1+Gm*R_C}\right)...(18)$$

The formulae (17) and (18) demonstrate that an attenuated noise is transmitted to the drain voltage VD and the gate voltage VG from the negative power supply voltage VNEG.

Next, the following discusses as to whether or not an attenuation amount caused by the attenuation is sufficient for LNA application. For example, suppose that it is designed to achieve that ID = 8 mA, VD= 2 V, and VDD = 3.3 V. In this case, if it is set that Gm = 50 mS, R 501 = 1 kΩ, R 502 = 1.75 kΩ, RE = 50 Ω, RC = 40 kΩ, and gm = 1 mS, the PSRRs of the drain voltage VD and the gate voltage VG for the negative power supply voltage VNEG are expressed by the following formulae (19) and (20).

[Math. 10]

$$PSRR_{V_D}\Big|_{VNEG} \approx -32dB...(19)$$

$$PSRR_{V_G}\Big|_{VNEG} \approx -66dB...(20)$$

This attenuation amount is not sufficient for the LNA application. In the case of this example, if the signal power is -90 dBm, it is necessary to keep the noise power superimposed on the negative power supply voltage VNEG to at most -70 dBm in order.

(4) Restriction in production process.

If the HEMT bias circuit 500 of Fig. 21 is realized in the form of integrated circuit (IC), a production process thereof is restricted, even though such restriction in production process does not exist in a case where the HEMT bias circuit 500 of Fig. 21 is realized by using individual devices.

As illustrated in Fig. 21, in order to control the drain voltage VD and the drain current ID of the HEMT 501 by using a VBE potential difference of the bipolar transistor BIP 501, the bipolar transistor BIP 501 should be a PNP bipolar transistor. In this case, however, the conventional HEMT bias circuit 500 cannot be integrated by, for example, a cheap CMOS process.

The present invention was accomplished in view of the aforementioned problems, and objects of the present inventions are to provide a bias circuit, an LAN, an LNB, a receiver for communication, a transmitter for communication, and a sensor system, each of which can attain lower temperature dependencies, lower power supply voltage dependencies, sufficient attenuation of noises superimposed on the power supply voltage and negative voltage (that is, improvement in PSRRs against the power supply voltage and negative voltage), and improvement in degree of freedom in selecting a production process.

From JP 2006 081009 A, it is known to use a dual supply differential amplifier in a device for setting an optimum operating point on a wafer. JP 60 119107 A as well discloses a bias power supply circuit including a dual supply differential amplifier. JP 4 120906 A relates to a gain control broadband application device including a dual supply differential amplifier. JP H03 117930 U and US 2003/0038679 A1 equally disclose use of such dual supply differential amplifiers when setting an operating point of a device.

Solution to Problem

The above problems are solved by the subject-matter of the independent claim.

In accordance with the invention, a bias circuit is provided as a bias circuit comprising an amplification FET whose source terminal is grounded, including: a first single supply differential amplifier; a second single supply differential amplifier; a first transistor; a second transistor; a first

resistor; a second resistor; a third resistor; a fourth resistor; a fifth resistor; a reference voltage source; and a negative power supply voltage source, the first transistor having a first conduction terminal, a second conduction terminal, and a control terminal, the second transistor having a first conduction terminal, a second conduction terminal, and a control terminal, the first differential amplifier having a first input terminal, a second input terminal, and an output terminal, the first input terminal being connected with the second conduction terminal of the second transistor via the fifth resistor, the second input terminal being connected with a drain terminal of the amplification FET, and the output terminal being connected with the control terminal of the first transistor; the second differential amplifier having a first input terminal, a second input t terminal, and an output terminal, the first input terminal being connected with the second conduction terminal of the second transistor via the fourth resistor and the fifth resistor, the second input terminal being connected with the reference voltage source, and the output terminal being connected with the control terminal of the second transistor, the first transistor being configured such that the first conduction terminal is connected with a power supply voltage and the second conduction terminal is connected with a gate terminal of the amplification FET, the second transistor being configured such that the first conduction terminal is connected with a power supply voltage and the second conduction terminal is connected with ground via the fifth resistor, the fourth resistor, and the third resistor in this order, the first resistor having a terminal being connected with the drain terminal of the amplification FET and another terminal being connected with the second conduction terminal of the second transistor, and the second resistor having a terminal being connected with the gate terminal of the amplification FET, and another terminal being connected with the negative power supply voltage source.

With this configuration, it becomes possible (i) to set both of the drain current and drain voltage of the amplification FET to desired values, (ii) to eliminate the temperature dependency and the power supply voltage dependency, and (iii) to attain a very high noise canceling efficiency. Moreover, the differential amplifier can be structured without requiring a special production process, thereby attaining a greater degree of freedom in the production process.

In order to attain the object, an LNA is configured as an LNA, including an amplification FET whose source terminal is grounded; any one of the bias circuits above, the gate terminal of the amplification FET serving as an input terminal of the LNA and the drain terminal of the amplification FET serving as an output terminal of the LNA.

In order to attain the object, an LNB is configured as an LNB receiving a signal via an antenna, amplifying and down-converting the signal, and transmitting the amplified and down-converted signal to a later stage following the LNB, including at least one LNA for performing the amplification of the signal, the LNA being the Aforementioned LNA above.

In order to attain the object, a receiver is configured as a receiver for communication, including: a receiver device for receiving a signal from a communication channel; an LNA for amplifying a signal outputted from the receiver device, the LNA being and the aforementioned LNA above.

In order to attain the object, a transmitter is configured as a transmitter for communication, including: an LNA for amplifying a signal to transmit; and a transmitter device for transmitting to a communication channel the signal amplified by the LNA, the LNA being the aforementioned LNA above.

In order to attain the object, a sensor is configured as a sensor system, including: a sensing device for detecting a change in an object and generating a signal based on the detected change; an LNA for amplifying the signal outputted from the sensing device, the LNA being the aforementioned LNA above.

With this configuration, by adjusting the timings of the switching-over of the first switch and the second switch, timings of performing voltage application to the gate terminal of the amplification FET and fading out the voltage applied to the gate terminal of the amplification FET, and timings of performing voltage application to the drain terminal of the amplification FET and fading out the voltage applied to the drain terminal of the amplification FET, can be controlled in such a manner that a large shoot-through current will not flow.

For example, the switching-over of the bias circuit from not biasing to biasing is carried out by switching over the first switch so as to connect the negative power supply terminal of the differential amplifier with the negative power supply voltage source instead of the ground, and then switching over the second switch so as to connect the second terminal of the first resistor with the first reference voltage source instead of the ground. By this, the voltage application to the drain terminal of the amplification FET is carried out after the voltage application to the gate terminal of the amplification FET. Therefore, carriers present in a channel of the amplification FET are decreased in a period between start of the voltage application to the gate terminal of the amplification FET and start of the voltage application to the drain terminal of the amplification FET. This can make it difficult for the shoot through electrode to flow.

Moreover, the switching-over of the bias circuit from biasing to not biasing is carried out by switching over the second switch so as to connect the second terminal of the first resistor with the ground instead of the first reference voltage source, and then switching over the first switch so as to connect the negative power supply terminal of the differential amplifier with the ground instead of the negative power supply voltage source. By this, the fading-out of the voltage applied to the gate terminal of the amplification FET is carried out after the fading-out of the voltage applied to the drain terminal of the amplification FET. Thus, the gate terminal still has a negative voltage in a period between the fading-out the voltage at the drain terminal of the amplification FET and the fading-out of the voltage at the gate terminal of the amplification FET. This makes it possible to prevent an excess drain current from flowing.

Therefore, it becomes possible to prevent an excess shoot-through current from flowing in switching over from not biasing to biasing, or from biasing to not biasing.

In order to attain the object, a bias switching circuit is configured as a bias circuit for biasing an amplification FET which is for amplifying an input signal and whose source terminal is grounded, including: a first single supply differential amplifier; a second single supply differential amplifier; a first transistor; a second transistor; a first resistor; a second resistor; a third resistor; a fourth resistor; a fifth resistor; a first switch; a second switch; a reference voltage source; and a negative power supply voltage source, the first transistor having a first conduction terminal, a second conduction terminal, and a control terminal, the second transistor having a first conduction terminal, a second conduction terminal, and a control terminal, the first differential amplifier having a first input terminal, a second input terminal, and an output terminal, the first input terminal being connected with the second conduction terminal of the second transistor via the fifth resistor, the second input terminal being connected with a drain terminal of the amplification FET, and the output terminal being connected with the control terminal of the first transistor, the second differential amplifier having a first input terminal, a second input terminal, and an output terminal, the first input terminal being connected with the second conduction terminal of the second transistor via the fourth resistor and the fifth resistor in this order, the second input terminal being connected with the reference voltage source, and the output terminal being connected with the control terminal of the second transistor, the first transistor being configured such that the first conduction terminal is connected with a power supply voltage, and the second conduction terminal is connected with a gate terminal of the amplification FET, the second transistor being configured such that the first conduction terminal is connected with the power supply voltage, and the second conduction terminal is connected with ground via the fifth resistor, the fourth resistor, and the third resistor in this order, the first resistor having a first terminal and a second terminal, the first terminal being connected with the drain terminal of the amplification FET and the second terminal being connected with the second conduction terminal of the second transistor, the second resistor having a third terminal and a fourth terminal, the third terminal being connected with the gate terminal of the amplification FET, and the fourth terminal being connected with the negative power supply voltage source, the first switch being connectable with the gate terminal of the amplification FET, the first switch switching over to connect or disconnect the gate terminal of the amplification FET with ground, and the second switch being connectable with the control terminal of the second transistor, the second switch switching over to connect or disconnect the control terminal of the second transistor with the first conduction terminal of the second transistor.

In performing the biasing by switching over the first switch so as to disconnect the gate terminal of the amplification FET with the ground, and switching over the second switch so as to disconnect the control terminal of the second transistor with the first conduction terminal of the second transistor, this configuration makes it possible (i) to set both of the drain current and drain voltage of the amplification FET to desired values, (ii) to eliminate the temperature dependency and the power supply voltage dependency, and (iii) to attain a very high noise canceling efficiency. Moreover, the differential amplifier can be structured without requiring a special production process, thereby attaining a greater degree of freedom in the production process.

With this configuration, by adjusting the timings of the switching-over of the first switch and the second switch, timings of performing voltage application to the gate terminal of the amplification FET and fading out the voltage applied to the gate terminal of the amplification FET, and timings of performing voltage application to the drain terminal of the amplification FET and fading out the voltage applied to the drain terminal of the amplification FET, can be controlled in such a manner that a large shoot-through current will not flow.

For example, the switching-over of the bias circuit from not biasing to biasing is carried out by switching over the first switch so as to disconnect the gate terminal of the amplification FET with the ground, and then switching over the second switch so as to disconnect the control terminal of the second transistor with the first conduction terminal of the second transistor. By this, the voltage application to the drain terminal of the amplification FET is carried out after the voltage application to the gate terminal of the amplification FET. Therefore, carriers present in a channel of the amplification FET are decreased in a period between start of the voltage application to the gate terminal of the amplification FET and start of the voltage application to the drain terminal of the amplification FET. This can make it difficult for the shoot through electrode to flow.

Moreover, the switching-over of the bias circuit from biasing to not biasing is carried out by switching over the second switch so as to connect the control terminal of the second transistor with the first conduction terminal of the second transistor, and then switching over the first switch so as to connect the gate terminal of the amplification FET with the ground. By this, the fading-out of the voltage applied to the gate terminal of the amplification FET is carried out after the fading-out of the voltage applied to the drain terminal of the amplification FET. Thus, the gate terminal still has a negative voltage in a period between the fading-out the voltage at the drain terminal of the amplification FET and the fading-out of the voltage at the gate terminal of the amplification FET. This makes it possible to prevent an excess drain current from flowing.

Therefore, it becomes possible to prevent an excess shoot-through current from flowing in switching over from not biasing to biasing, or from biasing to not biasing.

An LNA is configured as an LNA including: an amplification FET for amplifying an input signal, the amplification FET having a source terminal being grounded; the aforementioned bias circuit above; an input terminal being provided to the gate terminal of the amplification FET; and an output terminal being provided to the drain terminal of the amplification FET.

With this configuration, in which the LNA provided with the bias circuit, the LNA can drive the amplification FET at a proper operation point, and can bring about an effect similar to that of the bias circuit.

An LNB is configured as an LNB for receiving a signal via an antenna, amplifying and down-converting the signal, and transmitting the amplified and down-converted signal to a later stage following the LNB, including: a first polarized wave antenna for receiving a first polarized wave and converting the first polarized wave into a first polarized wave signal; a second polarized wave antenna for receiving a second polarized wave and converting the second polarized wave into a second polarized wave signal; a first polarized wave amplifier for amplifying the first polarized wave signal; a second polarized wave amplifier for amplifying the second polarized wave signal; and a polarized wave selector for selecting which one of the first polarized wave and the second polarized wave the LNB receives, the first polarized wave and the second polarized wave are a horizontally-polarized wave and a vertically-polarized wave, respectively, or a left-handed circularly polarized wave and a right-handed circularly polarized wave, respectively, the first polarized wave amplifier and the second polarized wave amplifier being the aforementioned LNAs above, the first polarized wave amplifier and the second polarized wave amplifier switching over the first switch and the second switch according to a polarized wave selecting signal indicating which one of the first polarized wave and the second polarized wave the LNB receives, the polarized wave selecting signal being outputted from the polarized wave selector.

With this configuration, in which the LNAs are provided, gains and NFs of the first polarized wave amplifier and the second polarized wave amplifier can be optimized in the LNB. This makes it possible for the LNB to excellently receive a minute signal received via the first polarized wave antenna and the second polarized wave antenna.

Advantageous Effects of Invention

As described above, a bias circuit is configured as a bias circuit comprising an amplification FET whose source terminal is grounded, including: a dual supply differential amplifier; a first resistor; a first reference voltage source; and a second reference voltage source, the differential amplifier having a positive input terminal, a negative input terminal, and an output terminal, the positive input terminal being connected with a drain terminal of the amplification FET, the negative input terminal being connecting with the second reference voltage source, and the output terminal being connected with a gate terminal of the amplification FET, and the first resistor having a terminal being connected with the drain terminal of the amplification FET, and another terminal being connected with the first reference voltage source.

Moreover, a bias circuit is configured as a bias circuit for an amplification FET whose source terminal is grounded, including: a single supply differential amplifier; a first reference voltage source; a second reference voltage source; a first transistor; a first resistor; a second resistor; and a negative power supply voltage source, the first transistor having a first conduction terminal, a second conduction terminal, and a control terminal, the differential amplifier having a first input terminal, a second input terminal, and an output terminal, the first input terminal being connected with the second reference voltage source, the second input terminal being connected with a drain terminal of the amplification FET, and the output terminal being connected with the control terminal of the first transistor, the first transistor being configured such that the first conduction terminal is connected with a power supply voltage and the second conduction terminal is connected with a gate terminal of the amplification FET, the first resistor having a terminal being connected with the drain terminal of the amplification FET, and another terminal being connected with the first reference voltage source, and the second resistor having a terminal being connected with the gate terminal of the amplification FET, and another terminal being connected with the negative power supply voltage source.

Furthermore, a bias circuit is configured as a bias circuit comprising an amplification FET whose source terminal is grounded, including: a first single supply differential amplifier; a second single supply differential amplifier; a first transistor; a second transistor; a first resistor; a second resistor; a third resistor; a fourth resistor; a fifth resistor; a reference voltage source; and a negative power supply voltage source, the first transistor having a first conduction terminal, a second conduction terminal, and a control terminal, the second transistor having a first conduction terminal, a second conduction terminal, and a control terminal, the first differential amplifier having a first input terminal, a second input terminal, and an output terminal, the first input terminal being connected with the second conduction terminal of the second transistor via the fifth resistor, the second input terminal being connected with a drain terminal of the amplification FET, and the output terminal being connected with the control terminal of the first transistor; the second differential amplifier having a first input terminal, a second input t terminal, and an output terminal, the first input terminal being connected with the second conduction terminal of the second transistor via the fourth resistor and the fifth resistor, the second input terminal being connected with the reference voltage source, and the output terminal being connected with the control terminal of the second transistor, the first transistor being configured such that the first conduction terminal is connected with a power supply voltage and the second conduction terminal is connected with a gate terminal of the amplification FET, the second transistor being configured such that the first conduction terminal is connected with a power supply voltage and the second conduction terminal is connected with ground via the fifth resistor, the fourth resistor, and the third resistor in this order, the first resistor having a terminal being connected with the drain terminal of the amplification FET, and another terminal being connected with the second conduction terminal of the second transistor, and the second resistor having a terminal being connected with the gate terminal of the amplification FET, and another terminal being connected with the negative power supply voltage source.

With any of these configurations, it becomes possible (i) to set both of the drain current and drain voltage of the amplification FET to desired values, (ii) to eliminate the temperature dependency and the power supply voltage dependency, and (iii) to attain a very high noise canceling efficiency. In addition, the differential amplifier can be structured without requiring a special production process, thereby attaining a greater degree of freedom in the production process.

An LNA is configured as an LNA, including an amplification FET whose source terminal is grounded; any one of the bias circuits above, the gate terminal of the amplification FET serving as an input terminal of the LNA and the drain terminal of the amplification FET serving as an output terminal of the LNA.

Therefore, by providing the LNA with the bias circuit, the LNA can drive the amplification FET at a proper operation point, and can bring about an effect similar to that of the bias circuit.

An LNB is configured as an LNB receiving a signal via an antenna, amplifying and down-converting the signal, and transmitting the amplified and down-converted signal to a later stage following the LNB, including at least one LNA for performing the amplification of the signal, the LNA being the Aforementioned LNA above.

Therefore, by providing the LNA to the LNB, gains and NFs of an amplifier for amplifying the received signal can be optimized in the LNB. This makes it possible for the LNB to excellently receive a minute signal received via the antenna.

A receiver is configured as a receiver for communication, including: a receiver device for receiving a signal from a communication channel; an LNA for amplifying a signal outputted from the receiver device, the LNA being and the aforementioned LNA above. A transmitter is configured as a transmitter for communication, including: an LNA for amplifying a signal to transmit; and a transmitter device for transmitting to a communication channel the signal amplified by the LNA, the LNA being the aforementioned LNA above. A sensor is configured as a sensor system, including: a sensing device for detecting a change in an object and generating a signal based on the detected change; an LNA for amplifying the signal outputted from the sensing device, the LNA being the aforementioned LNA above.

Therefore, by providing the LNA to these devices, gains and NFs of an amplifier for amplifying the received signal can be optimized in these devices. This makes it possible for these devices to excellently receive a minute signal received via the antenna.

Moreover, a bias circuit is configured to include a dual supply differential amplifier; a first resistor; a first switch; a second switch; a first reference voltage source; a second reference voltage source; and a negative power supply voltage source, the differential amplifier having a positive input terminal, a negative input terminal, an output terminal, and a negative power supply terminal, the positive input terminal being connected with a drain terminal of the amplification FET, the negative input terminal being connected with the second reference voltage source, the output terminal being connected with a gate terminal of the amplification FET, and the negative power source terminal being connectable with the negative power supply voltage source or with ground according to switching-over of the first switch, and the first resistor having a first terminal and a second terminal, the first terminal being connected with the drain terminal of the amplification FET, and the second terminal being connectable with the first reference voltage source or with ground according to switching-over of the second switch.

A bias circuit is configured to include: a first single supply differential amplifier; a second single supply differential amplifier; a first transistor; a second transistor; a first resistor; a second resistor; a third resistor; a fourth resistor; a fifth resistor; a first switch; a second switch; a reference voltage source; and a negative power supply voltage source, the first transistor having a first conduction terminal, a second conduction terminal, and a control terminal, the second transistor having a first conduction terminal, a second conduction terminal, and a control terminal, the first differential amplifier having a first input terminal, a second input terminal, and an output terminal, the first input terminal being connected with the second conduction terminal of the second transistor via the fifth resistor, the second input terminal being connected with a drain terminal of the amplification FET, and the output terminal being connected with the control terminal of the first transistor, the second differential amplifier having a first input terminal, a second input terminal, and an output terminal, the first input terminal being connected with the second conduction terminal of the second transistor via the fourth resistor and the fifth resistor in this order, the second input terminal being connected with the reference voltage source, and the output terminal being connected with the control terminal of the second transistor, the first transistor being configured such that the first conduction terminal is connected with a power supply voltage, and the second conduction terminal is connected with a gate terminal of the amplification FET, the second transistor being configured such that the first conduction terminal is connected with the power supply voltage, and the second conduction terminal is connected with ground via the fifth resistor, the fourth resistor, and the third resistor in this order, the first resistor having a first terminal and a second terminal, the first terminal being connected with the drain terminal of the amplification FET and the second terminal being connected with the second conduction terminal of the second transistor, the second resistor having a third terminal and a fourth terminal, the third terminal being connected with the gate terminal of the amplification FET, and the fourth terminal being connected with the negative power supply voltage source, the first switch being connectable with the gate terminal of the amplification FET, the first switch switching over to connect or disconnect the gate terminal of the amplification FET with ground, and the second switch being connectable with the control terminal of the second transistor, the second switch switching over to connect or disconnect the control terminal of the second transistor with the first conduction terminal of the second transistor.

In performing the biasing any of these configurations makes it possible (i) to set both of the drain current and drain voltage of the amplification FET to desired values, (ii) to eliminate the temperature dependency and the power supply voltage dependency, and (iii) to attain a very high noise canceling efficiency. Moreover, the differential amplifier can be structured without requiring a special production process, thereby attaining a greater degree of freedom in the production process.

Moreover, by adjusting the timings of the switching-over of the first switch and the second switch, timings of performing voltage application to the gate terminal of the amplification FET and fading out the voltage applied to the gate terminal of the amplification FET, and timings of performing voltage application to the drain terminal of the amplification FET and fading out the voltage applied to the drain terminal of the amplification FET, can be controlled in such a manner that a large shoot-through current will not flow. Because of this, it becomes possible to prevent an excess shoot-through current from flowing in switching over from not biasing to biasing or from biasing to not biasing.

An LNA is configured as an LNA including: an amplification FET for amplifying an input signal, the amplification FET having a source terminal being grounded; the aforementioned bias circuit above; an input terminal being provided to a gate terminal of the amplification FET; and an output terminal being provided to a drain terminal of the amplification FET.

Therefore, by providing the LNA with the bias circuit, the LNA can drive the amplification FET at a proper operation point, and can bring about an effect similar to that of the bias circuit.

An LNB is configured to include: a first polarized wave antenna for receiving a first polarized wave and converting the first polarized wave into a first polarized wave signal; a second polarized wave antenna for receiving a second polarized wave and converting the second polarized wave into a second polarized wave signal; a first polarized wave amplifier for amplifying the first polarized wave signal; a second polarized wave amplifier for amplifying the second polarized wave signal; and a polarized wave selector for selecting which one of the first polarized wave and the second polarized wave the LNB receives, the first polarized wave and the second polarized wave are a horizontally-polarized wave and a vertically-polarized wave, respectively, or a left-handed circularly polarized wave and a right-handed circularly polarized wave, respectively, the first polarized wave amplifier and the second polarized wave amplifier being the aforementioned LNAs above, the first polarized wave amplifier and the second polarized wave amplifier switching over the first switch and the second switch according to a polarized wave selecting signal indicating which one of the first polarized wave and the second polarized wave the LNB receives, the polarized wave selecting signal being outputted from the polarized wave selector.

By providing the LNAs to the LNB, gains and NFs of the first polarized wave amplifier and the second polarized wave amplifier can be optimized in the LNB. This makes it possible for the LNB to excellently receive a minute signal received via the first polarized wave antenna and the second polarized wave antenna.

Brief Description of Drawings

Fig. 1

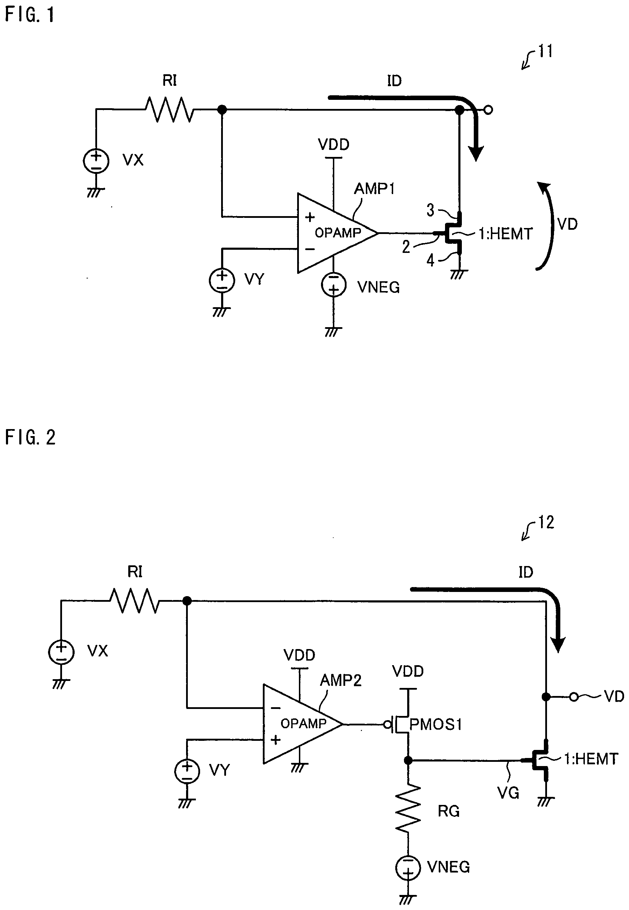

Fig. 1 is a circuit diagram illustrating Example 1 of a bias circuit.
Fig. 2
Fig. 2 is a circuit diagram illustrating Example 2 of the bias circuit.
Fig. 3

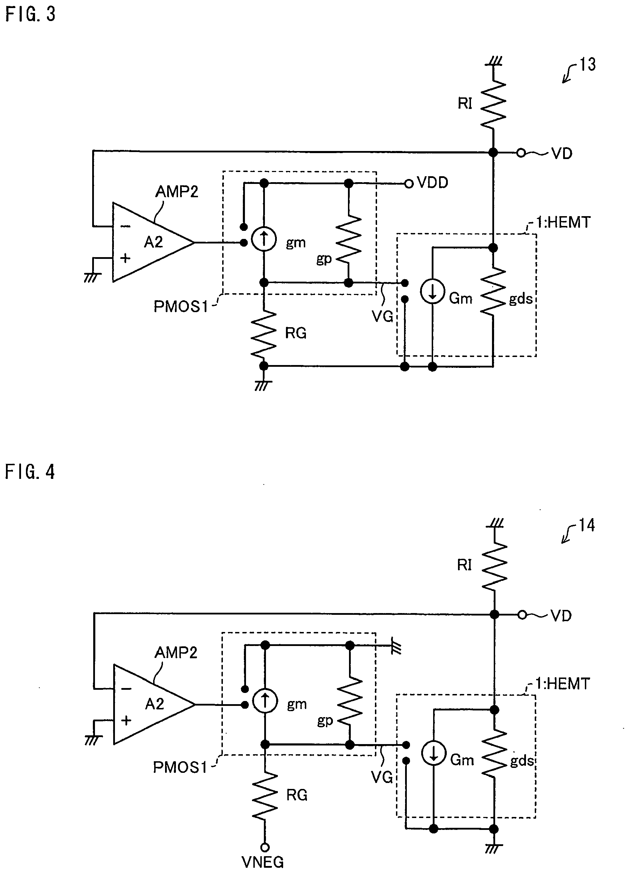

Fig. 3 is a small-signal equivalent circuit for a power supply voltage VDD of the bias circuit of Fig. 2.
Fig. 4
Fig. 4 is a small-signal equivalent circuit for a negative power supply voltage source VNEG of the bias circuit of Fig. 2.
Fig. 5

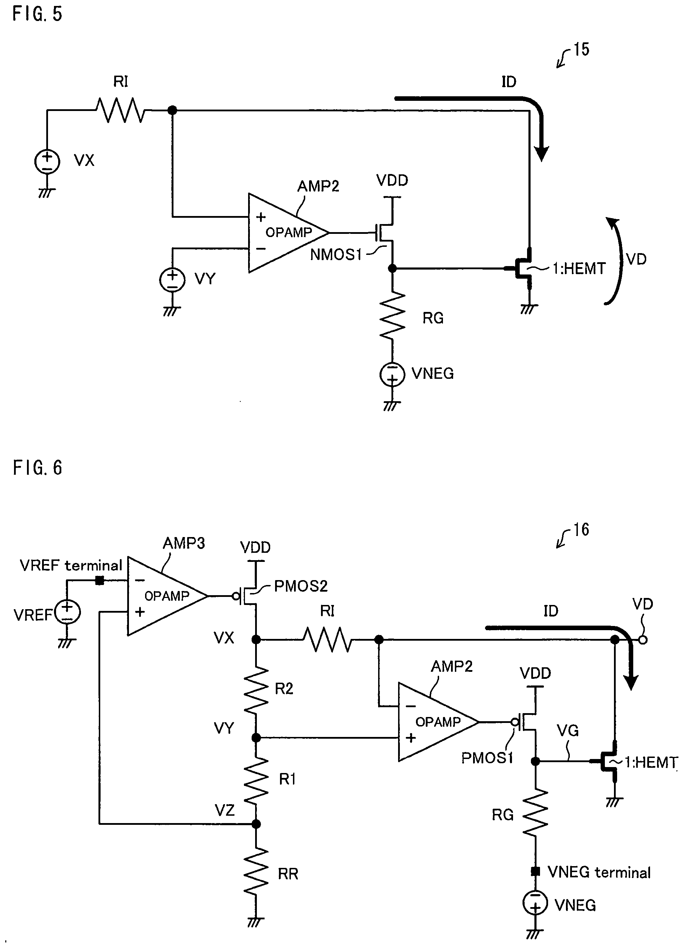

Fig. 5 is a circuit diagram illustrating Example 3 of the bias circuit.
Fig. 6
Fig. 6 is a circuit diagram illustrating Embodiment 6 of the bias circuit according to the present invention.
Fig. 7

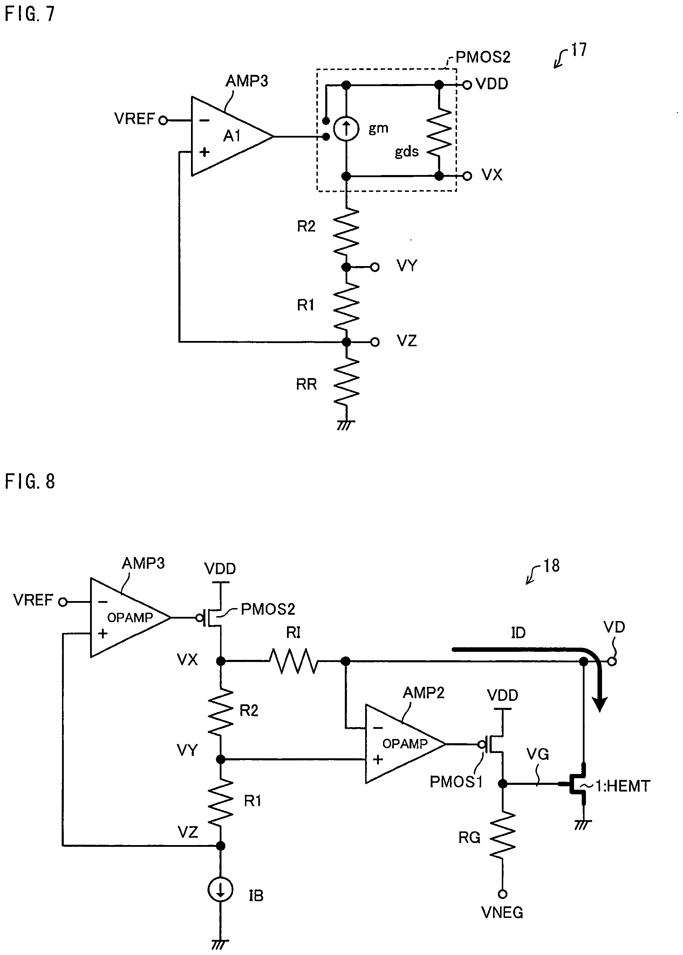

Fig. 7 is a small-signal equivalent circuit for the power supply voltage VDD in a first negative feedback comprising an operational amplifier AMP 3 in the bias circuit of Fig. 6.

Fig. 8

Fig. 8 is a circuit diagram illustrating Example 7 of the bias circuit according to the present invention.

Fig. 9

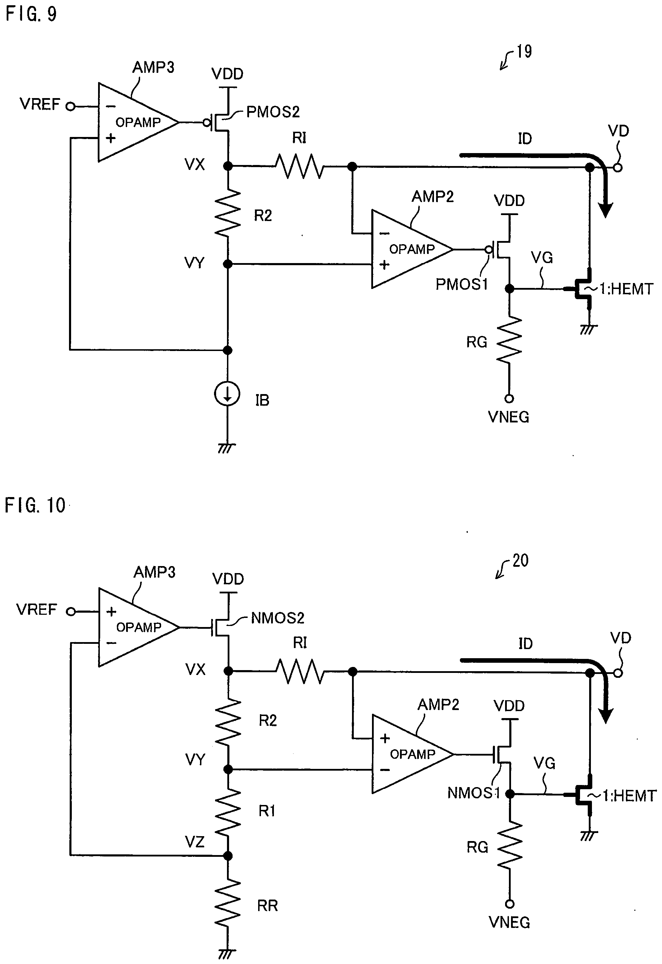

Fig. 9 is a circuit diagram illustrating Example 8 of the bias circuit.

Fig. 10

Fig. 10 is a circuit diagram illustrating Embodiment 9 of the bias circuit according to the present invention.

Fig. 11

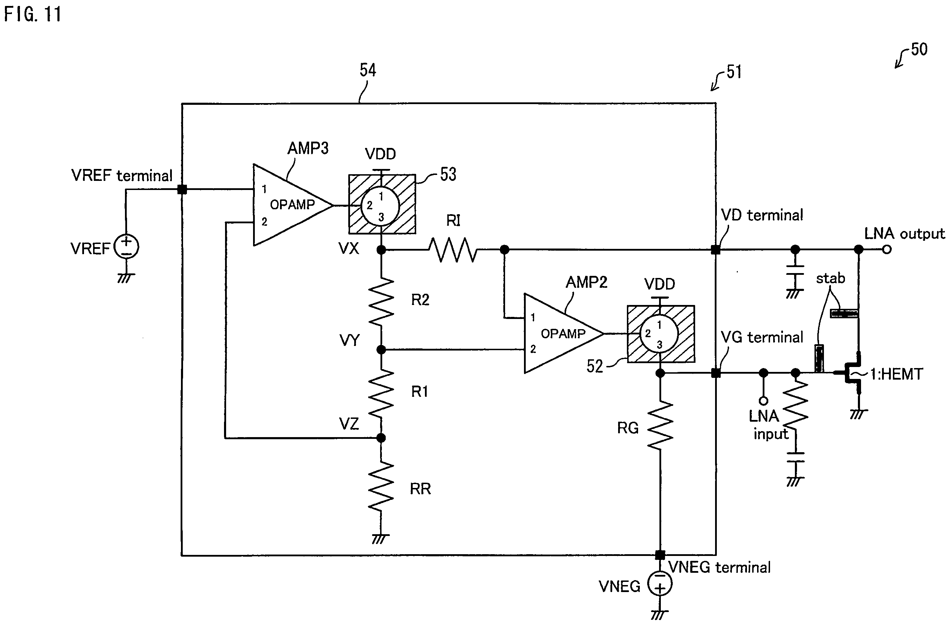

Fig. 11 is a circuit diagram illustrating one embodiment of an LNA according to the present invention.

Fig. 12

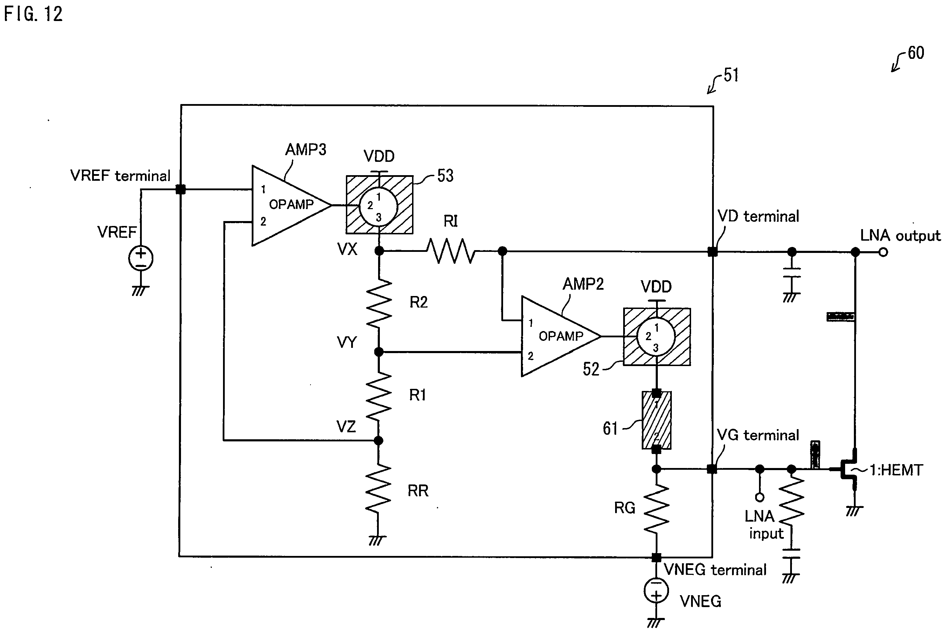

Fig. 12 is a circuit diagram illustrating another embodiment of the LNA according to the present invention.

Fig. 13

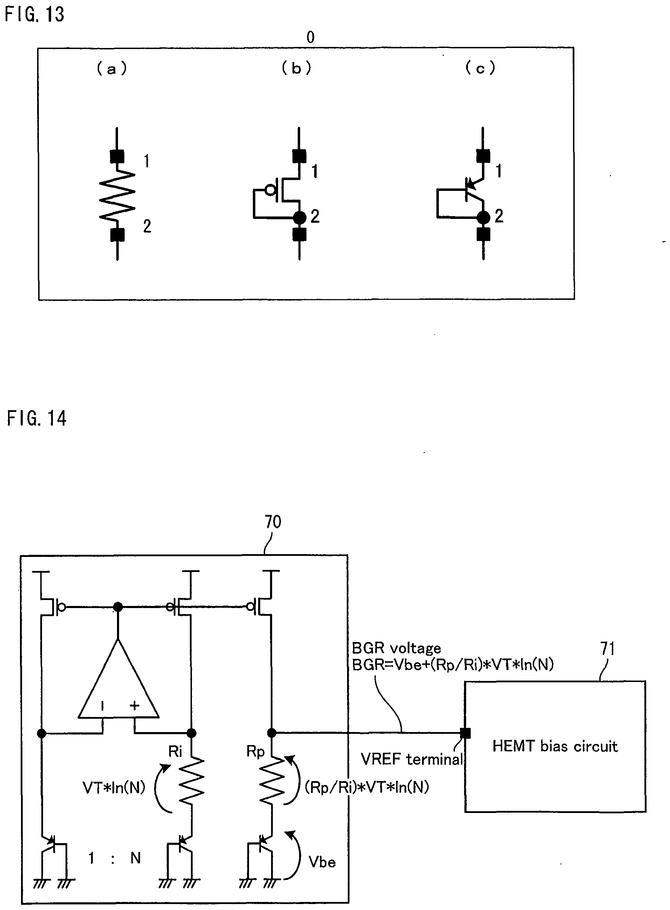

Fig. 13 is a view illustrating one exemplary configuration of a protection element.

Fig. 14

Fig. 14 is a circuit diagram illustrating one exemplary configuration of a bandgap reference circuit.

Fig. 15

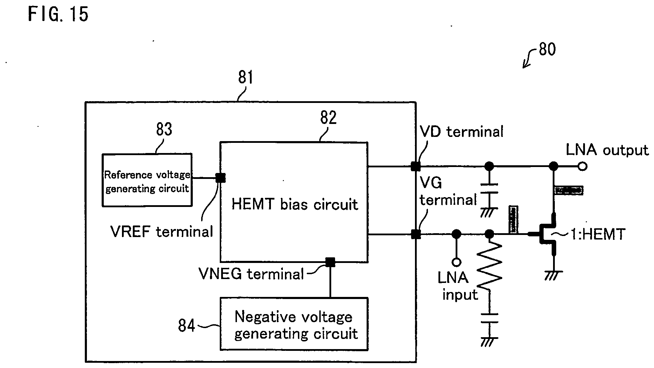

Fig. 15 is a circuit block diagram illustrating a still another embodiment of the LNA according to the present invention.

Fig. 16

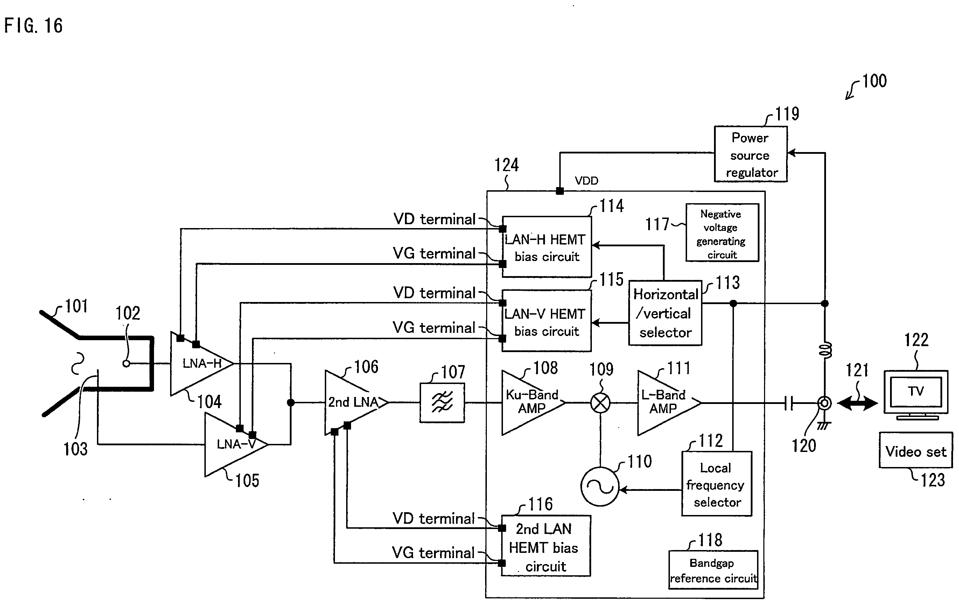

Fig. 16 is a circuit block diagram illustrating one embodiment of an LNB according to the present invention.

Fig. 17

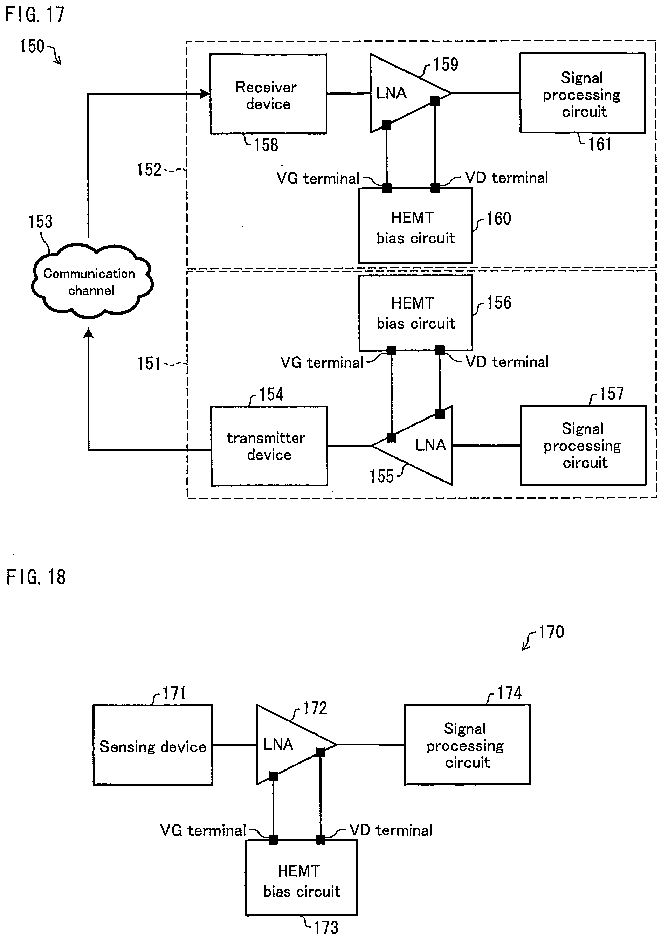

Fig. 17 is a block diagram illustrating one embodiment of a receiver and a transmitter according to the present invention for communication.

Fig. 18

Fig. 18 is a block diagram illustrating one embodiment of a sensor system according to the present invention.

Fig. 19

Fig. 19 is a circuit diagram for explaining a bias for an HEMT.

Fig. 20

Fig. 20 is a graph illustrating a relationship between a gate voltage and a drain current of the HEMT.

Fig. 21

Fig. 21 is a circuit diagram illustrating a conventional HEMT bias circuit.

Fig. 22

Fig. 22 is a small-signal equivalent circuit for a power supply voltage VDD of the conventional HEMT bias circuit of Fig. 21.

Fig. 23

Fig. 23 is a circuit diagram illustrating a configuration of a negative voltage generating circuit.

Fig. 24

Fig. 24 is a waveform diagram illustrating a voltage waveform of a negative voltage VNEG.

Fig. 25

Fig. 25 is a small-signal equivalent circuit for a negative power supply voltage VNEG of the conventional HEMT bias circuit of Fig. 21.

Fig. 26

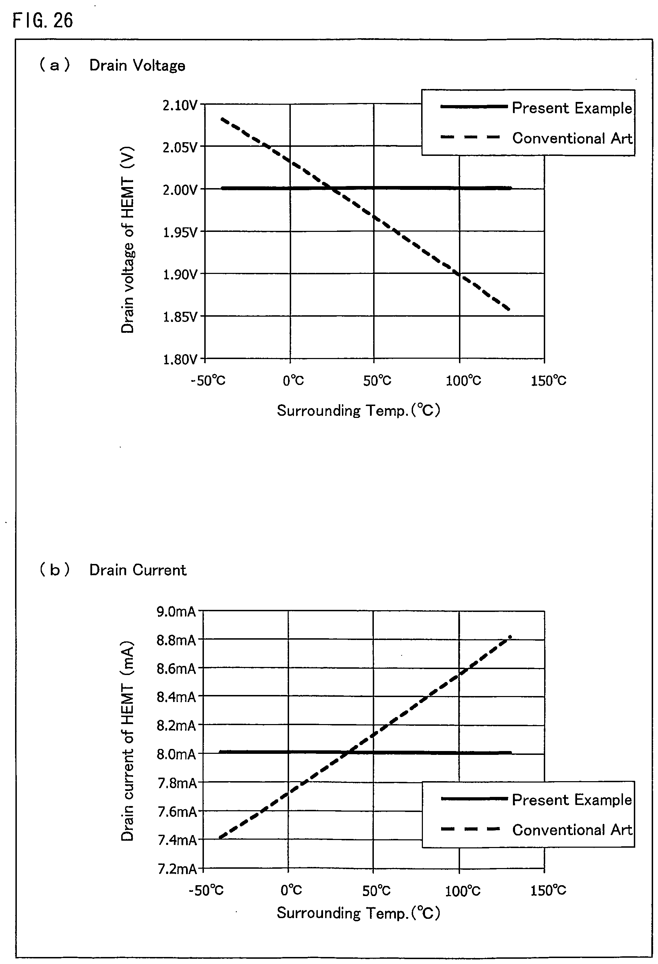

Fig. 26 is a graph plotting, against a temperature change, (a) drain voltages of the HEMTs and (b) drain currents of the HEMTs in the bias circuit of Fig. 6 and the conventional HEMT bias circuit of Fig. 21.

Fig. 27

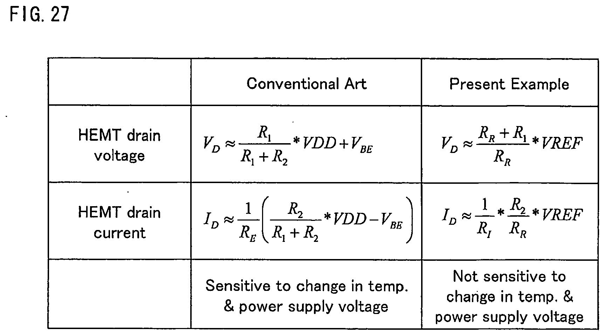

Fig. 27 is a table showing formulae for the drain voltage and drain current of an HEMT, which follow the curves illustrated in Fig. 26.

Fig. 28

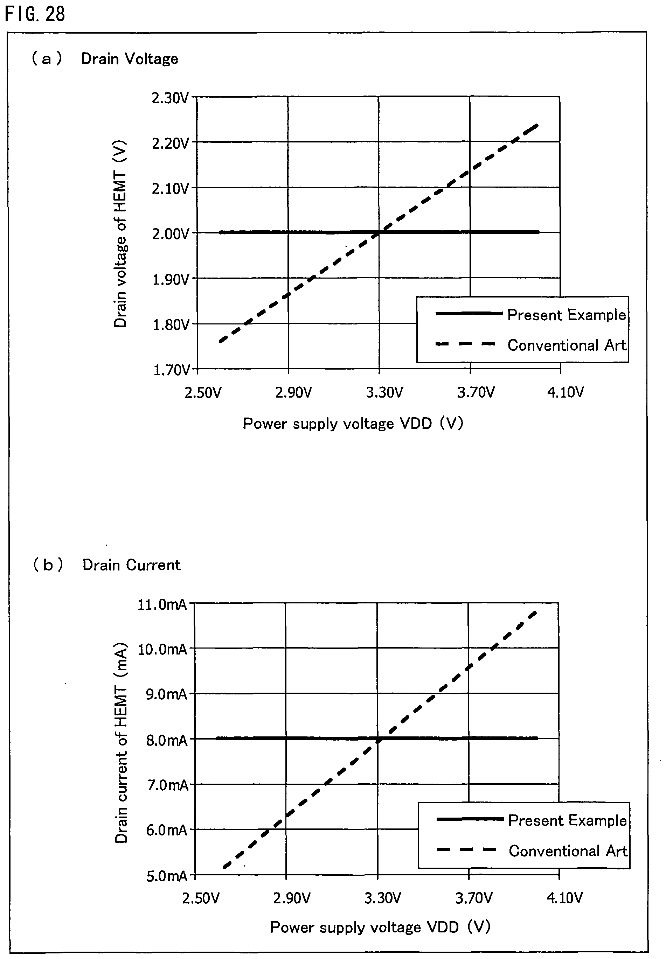

Fig. 28 is a graph plotting, against a power supply voltage change, (a) drain voltages of the HEMTs and (b) drain currents of the HEMTs in the bias circuit of Fig. 6 and the conventional HEMT bias circuit of Fig. 21.

Fig. 29

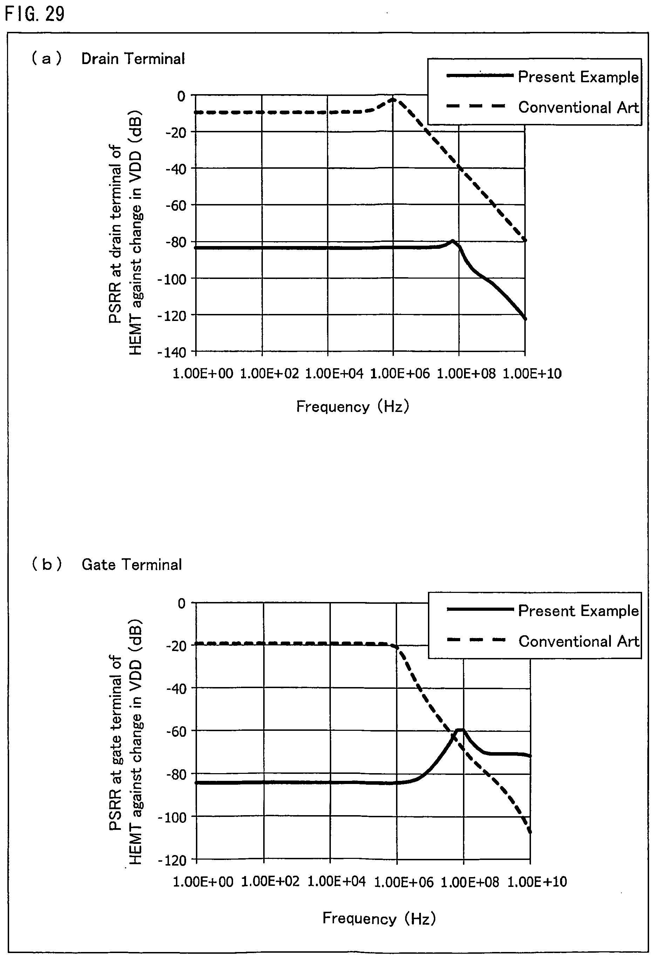

Fig. 29 is a graph plotting, against a power supply voltage VDD, (a) PSRR at a drain terminal of the HEMTs and (b) PSRR at a gate terminal of the HEMTs in the bias circuit of Fig. 6 and the conventional HEMT bias circuit of Fig. 21.

Fig. 30

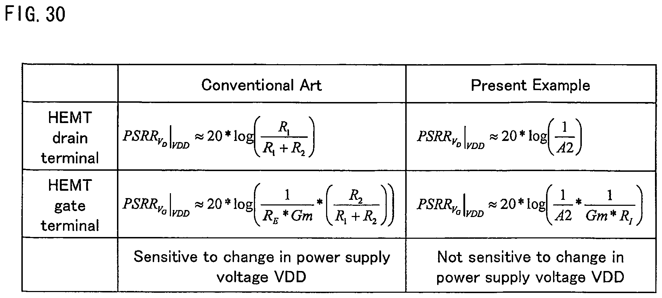

Fig. 30 is a table showing formulae for calculating PSRRs at the drain terminal and gate terminal of an HEMT, which follow the curves illustrated in Fig. 29.

Fig. 31

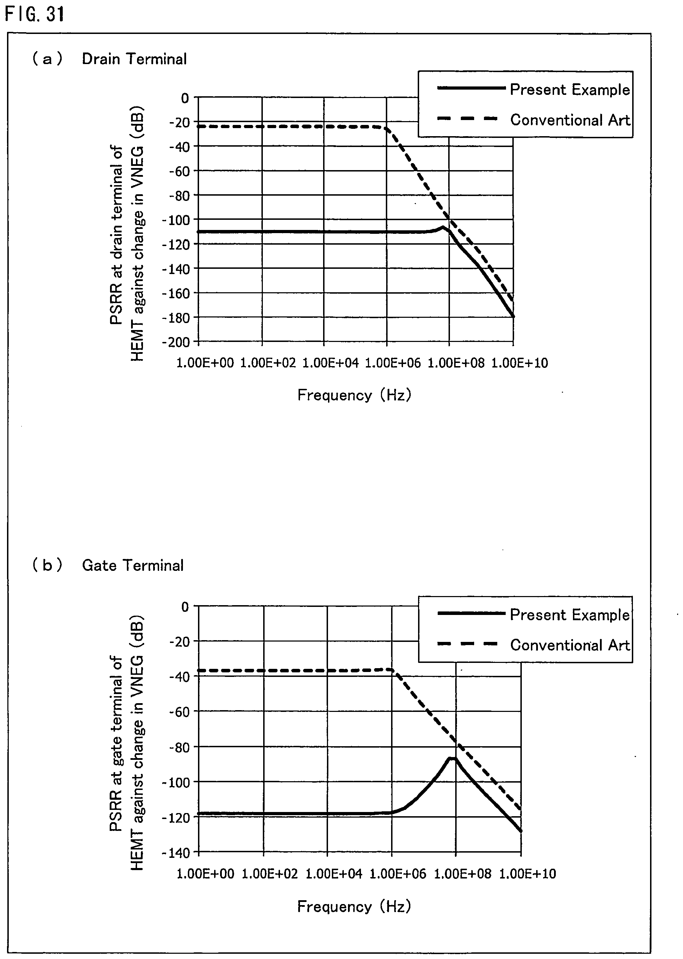

Fig. 31 is a graph plotting, against a negative power supply voltage VNEG, (a) PSRR at a drain terminal of the HEMTs and (b) PSRR at a gate terminal of the HEMTs in the bias circuit of Fig. 6 and the conventional HEMT bias circuit of Fig. 21.

Fig. 32

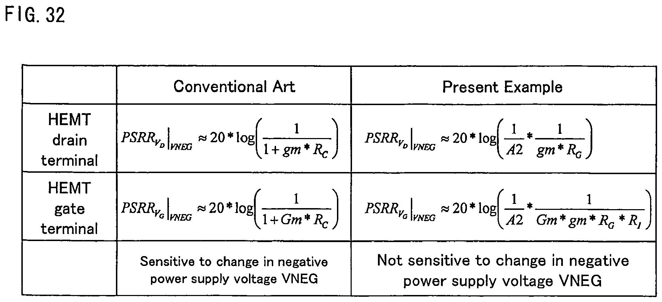

Fig. 32 is a table showing formulae for calculating PSRRs at the drain terminal and gate terminal of an HEMT, which follow the curves illustrated in Fig. 31.

Fig. 33

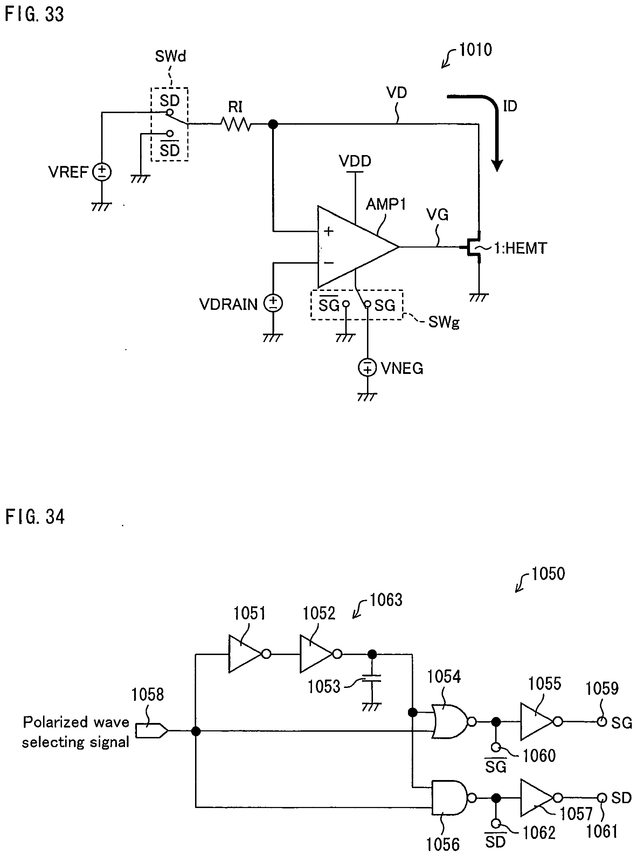

Fig. 33 is a circuit diagram illustrating one example of a bias circuit.

Fig. 34

Fig. 34 is a circuit diagram illustrating one exemplary configuration of a control signal generating circuit for supplying a control signal to the bias circuit of Fig. 33.

Fig. 35

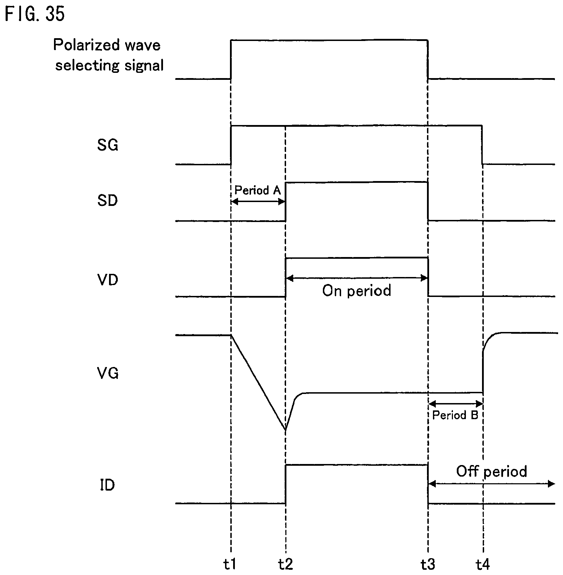

Fig. 35 is a timing chart illustrating signal waveforms in switching whether to supply a bias in an LNA provided with the bias circuit of Fig. 33.

Fig. 36

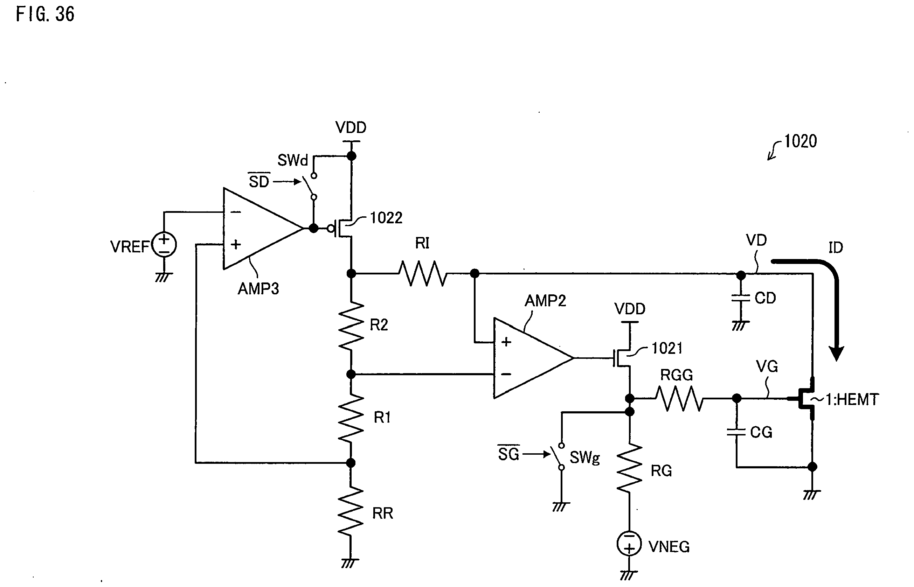

Fig. 36 is a circuit diagram illustrating another embodiment of a bias circuit according to the present invention.

Fig. 37

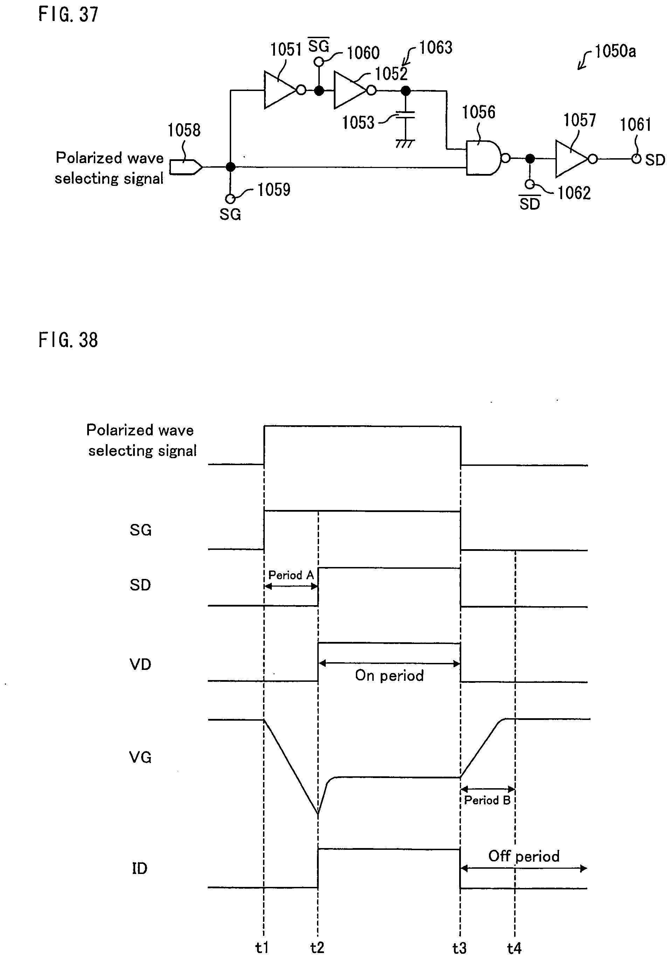

Fig. 37 is a circuit diagram illustrating one exemplary configuration of a control signal generating circuit for supplying a control signal to the bias circuit of Fig. 36.

Fig. 38

Fig. 38 is a timing chart illustrating signal waveforms in switching whether to supply a bias in an LNA provided with the bias circuit of Fig. 36.

Fig. 39

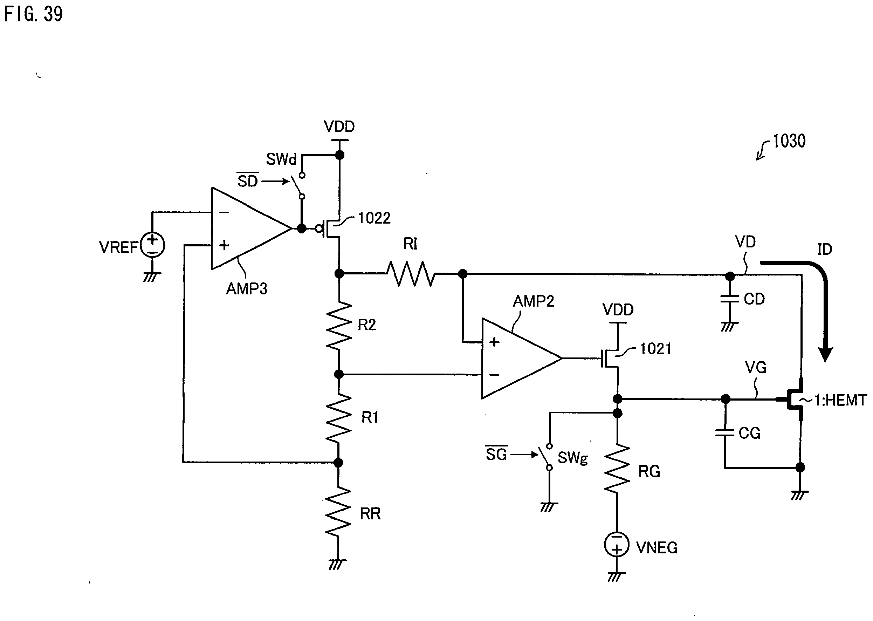

Fig. 39 is a circuit diagram illustrating another embodiment of the bias circuit according to the present invention.

Fig. 40

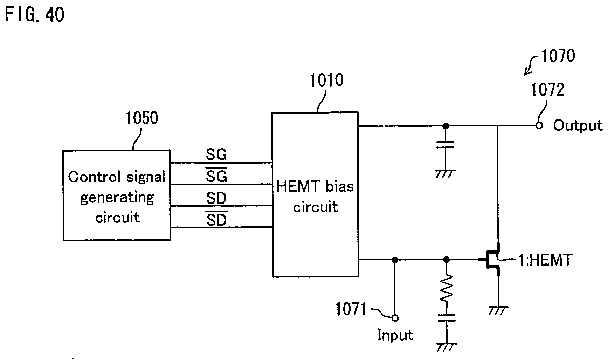

Fig. 40 is a circuit block diagram illustrating one embodiment of an LNA according to the present invention.

Fig. 41

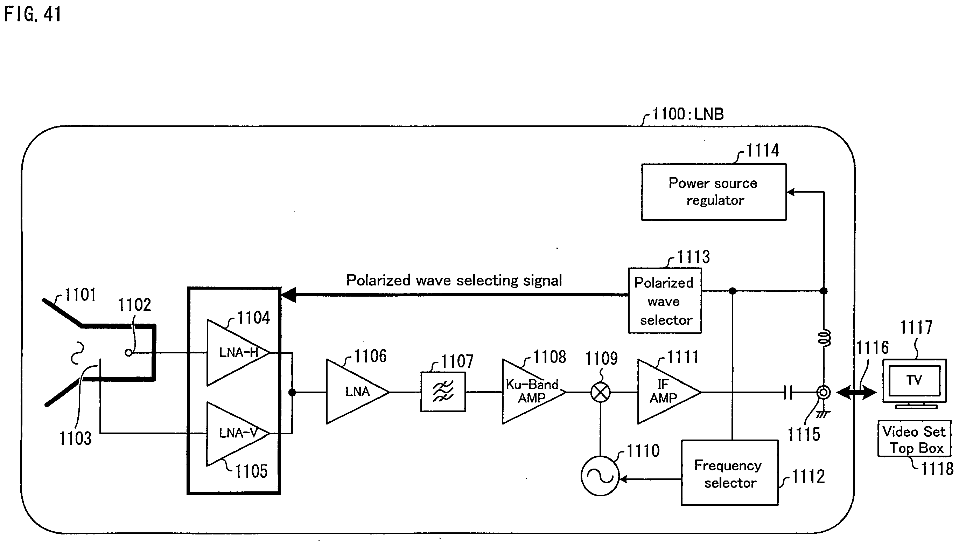

Fig. 41 is a circuit block diagram illustrating a configuration of a conventional LNB.

Fig. 42

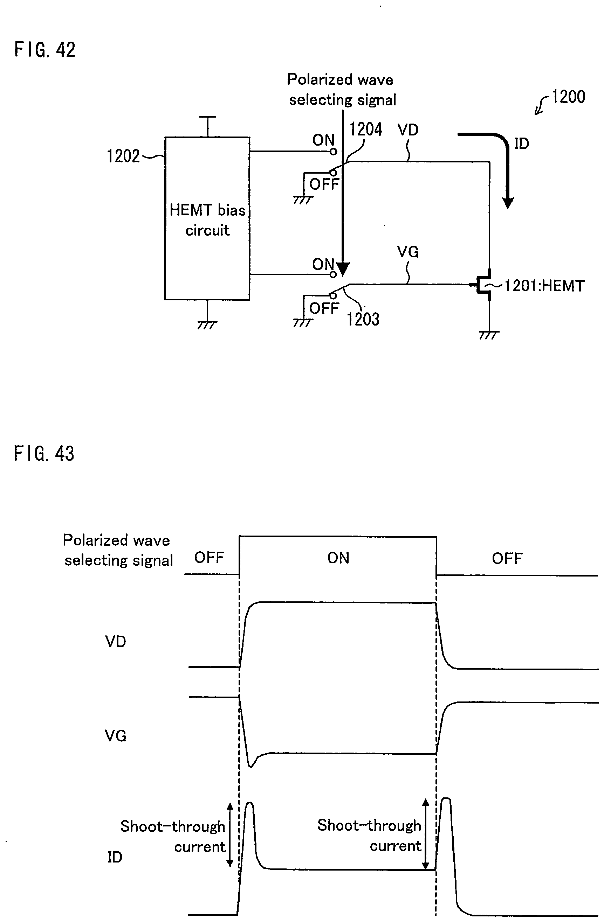

Fig. 42 is a circuit block diagram illustrating a schematic configuration of an LNA for use in the conventional LNB.

Fig. 43

Fig. 43 is a timing chart illustrating signal waveforms in switching whether to supply a bias in an LNA provided with the bias circuit of Fig. 42.

Description of Examples and Embodiments

Embodiments of the present invention and examples are described below, referring to drawings. The embodiments are explained in such a way that later embodiments are identical with their preceding embodiments except what is explained in the embodiments. For easy explanation, like members in each embodiment are labeled in the same manner and their explanation is omitted if the members in the embodiments and corresponding members illustrated in drawing for their preceding embodiments have like functions.

[Example 1]

Fig. 1 is a circuit diagram illustrating one exemplary configuration of an HEMT bias circuit 11.

The HEMT bias circuit 11 (bias circuit) according to the present example is a bias circuit for an HEMT 1 (Amplification FET) whose source terminal 4 is grounded. The HEMT bias circuit 11 includes, as illustrated in Fig. 1, an operational amplifier AMP 1 (dual supply differential amplifier), a resistor RI (first resistor), a first reference voltage source VX, a second reference voltage source VY, and a negative power supply voltage source VNEG.

The operational amplifier AMP 1 is an dual supply operational amplifier, and is configured as a differential amplifier. The operational amplifier AMP 1 is connected with a power supply voltage VDD and a negative power supply voltage source VNEG via a positive power supply terminal and a negative supply terminal thereof, respectively. A positive input terminal (non-reversing input terminal) of the operational amplifier AMP 1 is connected with a drain terminal 3 of the HEMT 1. A negative input terminal (reversing input terminal) of the operational AMP 1 is connected with a second reference voltage source VY. An output terminal of the operational amplifier AMP 1 is connected with a gate terminal 2 of the HEMT 1.

The resistor RI has two terminals, one of which is connected with a drain terminal 3 of the HEMT and the other of which is connected with the first reference voltage source VX.

The first reference voltage source VX and the second reference voltage source VY are voltage sources for providing positive voltages. The first reference voltage source VX and the second reference voltage source VY are totally independent of changes in a temperature T and a change in the power supply voltage VDD. The negative power supply voltage source VNEG is a voltage source for providing a negative power supply voltage (also called a negative power supply voltage VNEG). The power supply voltage VDD is a positive power supply voltage that can be shared with another component not within the circuit.

The HEMT bias circuit 11 is configured such that the HEMT 1 is part of a negative loop of the operational amplifier AMP 1. By this, the HEMT bias circuit 11 is configured such that the drain voltage VD and the drain current ID of the HEMT 1 are automatically determined as expressed by approximation formulae (21) and (22) below.

[Math. 11]

$$V_D \approx V_Y \ldots (21)$$

$$I_D \approx \frac{V_X - V_Y}{R_I} \ldots (22)$$

where the values in the formulae are as follows:

$V_D$: Volt value of drain voltage VD
$I_D$: Volt value of drain current ID
$V_X$: Volt value of first reference voltage source VX
$V_Y$: Volt value of second reference voltage source VY
$R_I$: Resistance of resistor RI

That is, the reference voltage VY of the second reference voltage source VY is inputted to an input terminal of the operational AMP 1, thereby to obtain a predetermined voltage VY at the drain terminal 3 of the HEMT 1. Moreover, by providing the resistor RI between the first reference voltage source VX and the drain terminal 3 of the HEMT 1, a potential different between the reference voltage VX and the reference voltage VY is obtained across the resistor RI, thereby obtaining a desired drain current ID.

The formulae (21) and (22) are not functions of the temperature T and the power supply voltage VDD. Therefore, the drain voltage VD and the drain current ID of the HEMT 1 is independent of the changes in the temperature T and the power supply voltage VDD. Hence, it is possible to eliminate temperature dependency and power supply voltage dependency from the HEMT bias circuit 11.

Moreover, PSRRs from the power supply voltage VDD and the negative power supply voltage VNEG to the gate terminal 2 of the HEMT 1 become identical with a PSRR of the operational amplifier AMP 1, thereby making it possible to attain a very high noise canceling efficiency.

Further, the operational amplifier AMP 1 can be configured without a special production process. Therefore, the HEMT bias circuit 11 can be formed with any kind of transistor, while the conventional HEMT bias circuit 500 as illustrated in Fig. 21 requires a PNP bipolar transistor. Therefore, the HEMT bias circuit 11 is high in degree of freedom in selecting a production process, and can be produced as an integrated circuit by various processes such a CMOS process, MOS process, bipolar process, BiCMOS process, and the like.

However, recently, operational amplifiers (differential amplifiers) are provided with a single power supply in most of cases. Moreover, the operational amplifier AMP 1 illustrated in Fig. 1 disadvantageously requires two power supplies whose powers are positive and negative respectively in reference with a GND level.

[Example 2]

Fig. 2 is a circuit diagram illustrating one exemplary configuration of an HEMT bias circuit 12.

The HEMT bias circuit 12 (bias circuit) according to the present example is a bias circuit for a HEMT 1 whose source terminal is grounded. The HEMT bias circuit 12 includes, as illustrated in Fig. 2, an operational amplifier AMP 2 (a single supply differential amplifier; a first differential amplifier), a resistor RI, a first reference voltage supply VX, a second reference voltage supply VY, a negative power supply voltage source VNEG, a P-channel MOSFET (hereinafter, referred to as PMOS transistor) PMOS 1 (first transistor), and a resistor RG (second resistor).

The operational amplifier AMP 2 is a single supply operational amplifier and is configured as a differential amplifier. A positive power supply terminal of the operational amplifier AMP 2 is connected with the power supply voltage VDD. A positive input terminal (non-reversing input terminal, a first input terminal) of the operational AMP 2 is connected with the second reference voltage source VY. A negative input terminal (reversing input terminal, a second input terminal) of the operational amplifier AMP 2 is connected with a drain terminal of the HEMT 1. The output terminal of the operational AMP 2 is connected with a gate terminal (control terminal) of the PMOS transistor PMOS 1.

A source terminal (first conduction terminal) of the PMOS transistor PMOS 1 is connected with the power supply voltage VDD. A drain terminal (second conduction terminal) of the PMOS transistor PMOS 1 is connected with a gate terminal of the HEMT 1.

The resistor RG has two terminals, one of which is connected with the gate terminal of the HEMT 1, and the other one of which is connected with the negative power supply voltage source VNEG.

The HEMT bias circuit 12 is configured such that the HEMT 1 is part of a negative feedback loop of the operational amplifier AMP 2. By this, the HEMT bias circuit 12 is configured such that the drain voltage VD and the drain current ID of the HEMT 1 are automatically determined as expressed by the approximation formulae (21) and (22). The formulae (21) and (22) are not functions of the temperature T and the power supply voltage VDD. Therefore, the drain voltage VD and the drain current ID of the HEMT 1 is independent of the changes in the temperature T and the power supply voltage VDD. Hence, it is possible to eliminate temperature dependency and power supply voltage dependency from the HEMT bias circuit 12.

<PSRR against power supply voltage VDD>

Referring to Fig. 3, the following explains how much PSRRs against the power supply voltage VDD are attained in the drain voltage VD and the gate voltage VG of the HEMT 1 to which a bias is applied to the HEMT bias circuit 12. Fig. 3 is a small-signal equivalent circuit 13 for the power supply voltage VDD of the HEMT bias circuit 12 of Fig. 2. Based on the Kirchhoff's current law, the following formulae (23) and (24) are obtained.
[Math. 12]

$$gm*\left[A2*\left(0-V_D\right)-VDD\right]+gp*\left(V_G-VDD\right)+\frac{V_G}{R_G}=0\ldots(23)$$

$$Gm*V_G+V_D*gds+\frac{V_D}{R_I}=0\ldots(24)$$

where the values in the formulae are as follows.

  gm: Mutual conductance of PMOS transistor PMOS 1
  gp: Drain-source conductance of PMOS transistor PMOS 1
  Gm: Mutual conductance of HEMT 1
  gds: Drain-source conductance of HEMT 1
  VDD: Volt value of power supply voltage VDD
  A2: DC gain of operational amplifier AMP 2
  $V_D$: Volt value of drain voltage VD
  $V_G$: Volt value of gate voltage VG
  $R_I$: Resistance of resistor RI
  $R_G$: Resistance of resistor RG

The drain voltage VD and the gate voltage VG found out by solving a simultaneous linear equation of formulae (23) and (24) are differentiated with the power supply voltage VDD and expressed in decibel to find the PSRRs of the drain voltage VD and the gate voltage VG for the power supply VDD as shown in the following formulae (25) and (26). Note that the calculations were simplified by approximations of sufficiently small terms therein.
[Math. 13]

$$PSRR_{V_D}\big|_{VDD}\approx 20*\log\left(\frac{1}{A2}\right)\ldots(25)$$

$$PSRR_{V_G}\Big|_{VDD} \approx 20*\log\left(\frac{1}{A2}*\frac{1}{Gm*R_I}\right)...(26)$$

The formulae (25) and (26) demonstrate that the attenuated noise of the power supply voltage VDD is transmitted to the drain voltage VD and the gate voltage VG.

Next, the following discusses as to whether or not an attenuation amount caused by the attenuation is sufficient for LNA application. For example, suppose that it is designed to achieve that ID = 8 mA, VD= 2 V, VDD = 3.3 V, and A2 = 10000. In this case, if it is set that Gm = 40 mS, and RI = 62.5 Ω, the PSRRs of the drain voltage VD and the gate voltage VG for the power supply voltage VDD are expressed by the following formulae (27) and (28).

[Math. 14]

$$PSRR_{V_D}\Big|_{VDD} \approx -80dB...(27)$$

$$PSRR_{V_G}\Big|_{VDD} \approx -90dB...(28)$$

The PSRRs thus obtained attain sufficient attenuation amounts for the LNA application. For example, in case where a signal power of - 90 dBm is to be inputted to the LNA, the LNA can perform good signal amplification even if the power supply voltage VDD is superimposed with a noise power of - 20 dBm.

<PSRR against negative power supply voltage VNEG>

Referring to Fig. 4, the following explains how much PSRRs against the negative power supply voltage source VNEG are attained in the drain voltage VD and the gate voltage VG of the HEMT 1 to which the bias is applied to the HEMT bias circuit 12.

The negative power supply voltage source VNEG of the HEMT bias circuit 12 may be a negative voltage generating circuit 520 as illustrated in Fig. 23. In this case, one terminal of the resistor RG is connected with an output terminal of the negative voltage generating circuit 520 of Fig. 23. In this case, an output signal quality of the LNA would be deteriorated if a pulsed noise superimposed on a negative DC voltage of a negative power supply voltage source VNEG is leaked to the gate terminal and the drain terminal of the HEMT 1.

Fig. 4 is a small-signal equivalent circuit 14 for the negative power supply voltage source VNEG of the HEMT bias circuit 12 of Fig. 2. Based on the Kirchhoff's current laws, the following formulae (29) and (30) are obtained.

[Math. 15]

$$gm*[A2*(0-V_D)]+gp*V_G+\frac{V_G-VNEG}{R_G}=0...(29)$$

$$Gm*V_G+V_D*gds+\frac{V_D}{R_I}=0...(30)$$

where the values in the formulae (29) and (30) are identical with those in the formulae (23) and (24) except that VNEG is a volt value of the negative power supply voltage VNEG.

The drain voltage VD and the gate voltage VG found out by solving a simultaneous linear equation of formulae (29) and (30) are differentiated with the negative power supply voltage VNEG and expressed in decibel to find the PSRRs of the drain voltage VD and the gate voltage VG for the negative power supply voltage VNEG as shown in the following formulae (31) and (32). Note that the calculations were simplified by approximations of sufficiently small terms therein.

[Math. 16]

$$PSRR_{V_D}\Big|_{VNEG} \approx 20*\log\left(\frac{1}{A2}*\frac{1}{gm*R_G}\right)...(31)$$

$$PSRR_{V_G}\Big|_{VNEG} \approx 20*\log\left(\frac{1}{A2}*\frac{1}{Gm*gm*R_G*R_I}\right)...(32)$$

The formulae (31) and (32) demonstrate that the attenuated noise of the negative power supply voltage VNEG is transmitted to the drain voltage VD and the gate voltage VG.

Next, the following discusses as to whether or not an attenuation amount caused by the attenuation is sufficient for LNA application. For example, suppose that it is designed to achieve that ID = 8 mA, VD= 2 V, VDD = 3.3 V, and A2 = 10000. In this case, if it is set that Gm = 40 mS, gm = 1 mS, RI = 62.5 $\Omega$, and RG = 40 k$\Omega$, the PSRRs of the drain voltage VD and the gate voltage VG for the negative power supply voltage VNEG are expressed by the following formulae (33) and (34).

[Math. 17]

$$PSRR_{V_D}\Big|_{VNEG} \approx -112dB...(33)$$

$$PSRR_{V_G}\Big|_{VNEG} \approx -122dB...(34)$$

The PSRRs thus obtained attain sufficient attenuation amounts for the LNA application. For example, in case where the signal power is - 90 dBm, the noise power superimposing the negative power supply voltage VNEG is allowable to be as large as + 10 dBm.

As described above, the HEMT bias circuit 12 can attain sufficiently small PSRRs of the drain voltage VD and the gate voltage VG for the power supply voltage VDD and the negative power supply voltage VNEG. Hence, it is possible to attain a very high noise canceling efficiency.

[Example 3]

Fig. 5 is a circuit diagram illustrating one exemplary configuration of the HEMT bias circuit 15.

The HEMT bias circuit 15 (bias circuit) according to the present example is identical with the HEMT bias circuit 12 of Embodiment 2 except that the PMOS transistor PMOS 1 is replaced with an N-channel MOSFET (hereinafter, referred to as NMOS transistor) NMOS 1 (first transistor), and the positive input terminal of the operational amplifier AMP 2 is connected with what the negative input terminal of the operational amplifier AMP 2 is connected with in Embodiment 2, and vice versa.

That is, the positive input terminal (second input terminal) of the operational amplifier AMP 2 is connected with a drain terminal of an HEMT 1. Meanwhile, the negative input terminal (first input terminal) of the operational amplifier AMP 2 is connected with a second reference voltage source VY. An output terminal of the operational amplifier AMP 2 is connected with a gate terminal (control terminal) of the NMOS transistor NMOS 1. A drain terminal (first conduction terminal) of the NMOS transistor NMOS 1 is connected with a power supply voltage VDD. A source terminal (second conduction terminal) of the NMOS transistor NMOS 1 is connected with a gate terminal of the HEMT 1.

As illustrated in Fig. 5, the HEMT bias circuit 15 has a configuration very similar to that of the HEMT bias circuit 12 of Example 2 in Fig. 2. Hence, the HEMT bias circuit 15 can attain effects very similar to those attained by the HEMT bias circuit 12 in terms of the temperature dependency, power supply voltage dependency, and the PSRRs.

[Example 4]

An HEMT bias circuit according to the present example is identical with the HEMT bias circuit 12 of Example 2 except that the PMOS transistor PMOS 1 is replaced with a PNP bipolar transistor (not illustrated). Thus, the source terminal, the drain terminal, and the gate terminal of the PMOS transistor PMOS 1 correspond to an emitter terminal, a collector terminal, and a base terminal of the PNP bipolar transistor, respectively. The HEMT bias circuit according to the present example has a configuration very similar to that of the HEMT bias circuit 12 of Example 2 and brings about an effect very similar to that of the HEMT bias circuit 12 of Example 2.

[Example 5]

An HEMT bias circuit according to the present example is identical with the HEMT bias circuit 15 of Example 3 except that the NMOS transistor NMOS 1 is replaced with a NPN bipolar transistor (not illustrated). Thus, the drain terminal, the source terminal, and the gate terminal of the NMOS transistor NMOS 1 correspond to a collector terminal, an emitter terminal, and a base terminal of the NPN bipolar transistor, respectively. The HEMT bias circuit according to the present example has a configuration very similar to that of the HEMT bias circuit 15 of Example 3 and brings about an effect very similar to that of the HEMT bias circuit 15 of Example 3.

[Embodiment 6]

Fig. 6 is a circuit diagram illustrating one exemplary configuration of a HEMT bias circuit 16 according to the present embodiment.

The HEMT bias circuit 16 (bias circuit) according to the present embodiment is a bias circuit according to the HEMT 1 whose source terminal is grounded. The HEMT bias circuit 16 includes, as illustrated in Fig. 6, an operational amplifier AMP 2, an operational amplifier AMP 3 (a second differential amplifier), a resistor element RI, a resistor element RG, a resistor element R1 (fourth resistor), a resistor R2 (fifth resistor), resistor RR (third resistor), PMOS transistor POMS 1, PMOS transistor PMOS 2 (second transistor), a reference voltage source VREF, and a negative power supply voltage source VNEG.

The HEMT bias circuit 16 is configured such that the voltages, which are supplied from the first reference voltage source VX and the second reference voltage source VY used in Embodiments 1 to 5, are generated by a circuit including the operational amplifier AMP 3, the PMOS transistor PMOS 2, the resistor R2, the resistor R1, and the resistor RR.

A positive input terminal (first input terminal) of the operational amplifier AMP 3 is connected with a drain terminal of the PMOS transistor PMOS 2 via the resistor R1 and the resistor R2. A negative input terminal (second input terminal) of the operational amplifier AMP 3 is connected with the reference voltage source VREF. An output terminal of the operational amplifier AMP 3 is connected with a gate terminal (control terminal) of the PMOS transistor PMOS 2.

A source terminal (first conduction terminal) of the PMOS transistor PMOS 2 is connected with the power supply voltage VDD. A drain terminal (second conduction terminal) of the PMOS transistor PMOS 2 is connected with ground via the resistor R2, the resistor R1, and the resistor RR in this order.

As described above, the PMOS transistor PMOS 2, resistor R2, and the resistor R1 are part of a negative feedback loop of the operational amplifier AMP 3. Here, a potential VX between the drain terminal of the PMOS transistor PMOS 2 and the resistor element R2, corresponds to the voltage supplied from the first reference voltage source VX. A potential VY between the resistor R2 and the resistor R1 corresponds to the voltage supplied from the second reference voltage source VY. VZ is a potential between the resistor R1 and the resistor RR.

A positive input terminal of the operational amplifier AMP 2 is connected to the potential VY, that is, is connected with a node between the resistor R2 and the resistor R1. Another terminal of the resistor RI is connected to the potential VX, that is, is connected with a node between the drain terminal of the PMOS transistor PMOS 2 and the resistor R2.

The reference voltage source VREF is a potential voltage source for generating a positive voltage, and is totally independent of the change in the temperature T and the power supply voltage VDD.

In the HEMT bias circuit 16, a first negative feedback loop including the operational amplifier AMP 3, and a second negative feedback loop including the operational amplifier AMP 2. The HEMT bias circuit 16 uses the two negative feedback loops in order to automatically control a gate voltage VG to be supplied to the HEMT 1. Thereby, HEMT bias circuit 16 attains a desired drain voltage VD and a desired drain current ID of the HEMT 1.

<Drain voltage VD and drain current ID>

The HEMT bias circuit 16 is configured such that the HEMT 1 is part of the negative feedback of the operational amplifier AMP 2. By this, the HEMT bias circuit 15 is configured such that the drain voltage VD and the drain current ID of the HEMT 1 are automatically determined as expressed by approximation formulae (35) and (36) below.
[Math. 18]

$$V_D \approx \frac{R_R + R_1}{R_R} * VREF \ldots (35)$$

$$I_D = \frac{1}{R_I} * \frac{R_2}{R_R} * VREF \ldots (36)$$

where the values in the formulae are as follows:

$V_D$: Volt value of drain voltage VD
$I_D$: Ampere value of drain current ID
VREF: Volt value of reference voltage source VREF
$R_I$: Resistance of resistor RI
$R_R$: Resistance of resistor RR
$R_1$: Resistance of resistor R1
$R_2$: Resistance of resistor R2

<Temperature dependency of drain voltage VD and drain current ID>

The temperature coefficients of the drain voltage VD and the drain current ID can be obtained as expressed in the following formulae (37) and (38) by differentiating the formulae (35) and (36) with the temperature T:
[Math. 19]

$$\frac{\partial V_D}{\partial T} = 0 \ldots (37)$$

$$\frac{\partial I_D}{\partial T} = 0 \ldots (38)$$

As understood from the formulae (37) and (38), the temperature coefficients of the drain voltage VD and the drain current ID are zero. Thus, it is possible to perfectly eliminate the temperature dependency in the HEMT bias circuit 16.

<Power supply voltage dependencies of drain voltage and drain current ID>

The coefficients of change in the drain voltage VD and the drain current ID against the power supply voltage VDD can be obtained as expressed in the following formulae (39) and (40) by differentiating the formulae (35) and (36) with the power supply voltage VDD:
[Math. 20]

$$\frac{\partial V_D}{\partial VDD} = 0 \ldots (39)$$

$$\frac{\partial I_D}{\partial VDD} = 0 \ldots (40)$$

As understood from the formulae (39) and (40), the coefficients of the change in the drain voltage VD and the drain current ID against the power supply voltage VDD are zero. Thus, it is possible to perfectly eliminate the power supply voltage dependency in the HEMT bias circuit 16.

<PSRR against power supply voltage VDD>

In the following, explained are the PSRRs against the power supply voltage VDD, which PSRRs are attained in the drain voltage VD and the gate voltage VG of the HEMT 1 to which a bias is applied by the HEMT bias circuit 16.

The formulae (39) and (40) expressing the dependency on the change in the power supply voltage VDD are obtained by differentiating the approximation formulae (35) and (36) with the power supply voltage VDD. Therefore, the formulae (39) and (40) are not so strict. In order to attain the PSRR for indicating how much the noise is attenuated at the VD terminal and the VG terminal when the power supply voltage VDD is superimposed with the noise, a small-signal equivalent circuit is used in general.

However, in the HEMT bias circuit 16 as illustrated in Fig. 6, the first negative feedback loop including the operational amplifier AMP 3 and the second feedback loop including the operational amplifier AMP 2 affect each other. This complicates the analysis of the small-signal equivalent circuit very much. Thus, in order to simplify the analysis, the two feedback loops are individually discussed.

(First negative feedback loop)

To begin with, discussed is how the power supply voltage VDD affects the output potentials VX, VY, and VZ of the first negative feedback loop containing the operational amplifier AMP 3.

Fig. 7 illustrates a small-signal equivalent circuit 17, for the power supply voltage VDD, of the first feedback loop including the operational amplifier AMP 3. Based on the Kirchhoff's current laws, the formulae (41), (42), and (43) are obtained.

[Math. 21]

$$gm * \left[ A1 * \left( V_Z - VREF \right) - VDD \right] + gds * \left( V_X - VDD \right) + \frac{V_X - V_Y}{R_2} = 0 \ldots (41)$$

$$\frac{V_Y - V_X}{R_2} + \frac{V_Y - V_Z}{R_1} = 0 \ldots (42)$$

$$\frac{V_Z}{R_R} + \frac{V_Z - V_Y}{R_1} = 0 \ldots (43)$$

where the values in the formulae are as follows: gm: Mutual conductance of PMOS transistor PMOS 2 gds: Drain-source conductance

of PMOS transistor PMOS 2
A1: DC gain of operational amplifier AMP 3
VDD: Volt value of power supply voltage VDD
VREF: Volt value of reference voltage source VREF
$V_X$: Volt value of potential VX
$V_Y$: Volt value of potential VY
$V_Z$: Volt value of potential VZ
$R_R$: Resistance of resistor RR
$R_1$: Resistance of resistor R1
$R_2$: Resistance of resistor R2

The potentials VX, VY, and VZ found out by solving a simultaneous linear equation of formulae (41), (42) and (43) are differentiated with the power supply voltage VDD and expressed in decibel to find the PSRRs for the power supply VDD as to the potentials VX, VY, and VZ as shown in the following formulae (44), (45) and (46). Note that the calculations were simplified by approximations of sufficiently small terms therein.

[Math. 22]

$$PSRR_{V_X}\Big|_{VDD} \approx 20 * \log\left(\frac{1}{A1} * \frac{R_1 + R_2 + R_R}{R_R}\right)\dots(44)$$

$$PSRR_{V_Y}\Big|_{VDD} \approx 20 * \log\left(\frac{1}{A1} * \frac{R_1 + R_R}{R_R}\right)\dots(45)$$

$$PSRR_{V_Z}\Big|_{VDD} \approx 20 * \log\left(\frac{1}{A1}\right)\dots(46)$$

The formulae (44), (45), and (46) demonstrates that the attenuated noise of the power supply voltage VDD is transmitted to the potentials VX, VY, and VZ.

Next, the following discusses as to whether or not an attenuation amount caused by the attenuation is sufficient for a voltage source. For example, suppose that it is designed to achieve that ID = 8 mA, VD= 2 V, VDD = 3.3 V, and A1 = 10000. In this case, if it is set that RR = 12 kΩ, R1 = 8 kΩ, and R2 = 5 kΩ, the PSRRs of the potentials VX, VY, and VZ for the power supply voltage VDD are expressed by the following formulae (47), (48) and (49).

[Math. 23]

$$PSRR_{V_X}\Big|_{VDD} \approx -74dB\dots(47)$$

$$PSRR_{V_Y}\Big|_{VDD} \approx -77dB\dots(48)$$

$$PSRR_{V_Z}\Big|_{VDD} \approx -80dB\dots(49)$$

This PSRRs thus obtained provide sufficient attenuation amount for the voltage source.

(Second negative feedback loop)

Next, explained is the second negative feedback loop including the operational amplifier AMP 2.

The values expressed by the formulae (47), (48), and (49) can be approximated to a ground level when they are considered in small-signal scale. That is, in the small-signal analysis of the second negative feedback loop including the operational amplifier AMP 2, it is possible to finally bring the potentials VX, VY, an VZ to the GND level.

Therefore, an equivalent circuit for finding the PSRR against the power supply voltage VDD to the drain voltage VD and the gate voltage VG of the HEMT 1 of the second negative feedback loop becomes identical with the small-signal equivalent circuit 13 illustrated in Fig. 3. The small-signal equivalent circuit 13 of Fig. 3 is an equivalent circuit of the HEMT bias circuit 12 of Embodiment 2. Therefore, the PSRR against the power supply voltage VDD to the drain voltage VD and the gate voltage VG of the HEMT 1 can bring about an effect similar to that of the HEMT bias circuit 12 of Example 2.

<PSRR against negative power supply voltage VNEG>

As described above, the potential VX, VY, and VZ can be finally brought to the GND level in the small-signal analysis of the second negative feedback loop including the operational amplifier AMP 2.

Therefore, the equivalent circuit established based on the negative power supply voltage source VNEG becomes identical with the small-signal equivalent circuit 14 illustrated in Fig. 4. Therefore, the small-signal equivalent circuit 14 of Fig. 4 is an equivalent circuit of the HEMT bias circuit 12 of Example 2. Hence, the PSRRs against the negative power supply voltage VNEG to the drain voltage VD and the gate voltage VG of the HEMT 1 can bring about an effect similar to that of the HEMT bias circuit 12 of Example 2.

As described above, the HEMT circuit 16 can attain sufficiently small PSRRs against the power supply voltage VDD and the negative power supply voltage VNEG to the drain voltage VD and the gate voltage VG. Therefore, it is possible to attain a very high noise canceling efficiency.

[Example 7]

Fig. 8 is a circuit diagram illustrating one exemplary configuration of an HEMT bias circuit 18.

The HEMT bias circuit 18 (bias circuit) of the present example is identical with the HEMT bias circuit 16 of Embodiment 6 except that the resistor RR is replaced with a constant current source IB. With this configuration, a drain voltage VD and a drain current ID of the HEMT 1 becomes as expressed in the following formulae (50) and (51):

[Math. 24]

$$V_D \approx VREF + IB * R_1 \dots (50)$$

$$I_D \approx \frac{R_2}{R_1} * IB \dots (51)$$

where each values in the formulae are the same as those in the formulae (35) and (36), except that IB is an ampere value of the constant current source IB.

In an integrated circuit, relative resistance values of the two resistors can be smaller. That is, the HEMT bias circuit 18 with this configuration is advantageous in that the formula for the drain current ID is in proportional with the resistance values, thereby making it possible to reduce current unevenness. However, the unevenness of the drain voltage VD is still large because the formula (50) for the drain voltage VD has the term of R1.

The formulae (50) and (51) demonstrate that the temperature efficiencies of the drain voltage VD and the drain current ID become zero by differentiating the formulae (50) and (51) with the temperature T. Therefore, it is possible to completely eliminate the temperature dependency in the HEMT bias circuit 18.

The formulae (50) and (51) demonstrate that the temperature efficiencies of the drain voltage VD and the drain current ID become zero by differentiating the formulae (50) and (51) with the power supply voltage VDD. Therefore, it is possible to completely eliminate the power supply voltage dependency in the HEMT bias circuit 18.

Further, the HEMT bias circuit 18 has very small PSRRs from the power supply voltage VDD and the negative power supply voltage VNEG to the drain voltage VD and the gate voltage VG, thereby making it possible to attain a very high noise canceling efficiency.

Therefore, the HEMT bias circuit 18 can bring about effects similar to the HEMT bias circuit 16 of Embodiment 6 illustrated in Fig. 6, in terms of the temperature dependency, the power supply voltage dependency, and the PSRRs.

[Example 8)

Fig. 9 is a circuit diagram illustrating one exemplary configuration of an HEMT bias circuit 19.

The HEMT bias circuit 19 (bias circuit) of the present example is identical with the HEMT bias circuit 18 of Embodiment 7 except that the resistor R1 is omitted therefrom. With this configuration, a drain voltage VD and a drain current ID of an HEMT 1 become as expressed by the following formulae (52) and (53).

[Math. 25]

$$V_D \approx VREF \dots (52)$$

$$I_D \approx \frac{R_2}{R_I} * IB \dots (53)$$

.

The HEMT bias circuit 19 with this configuration is advantageous in that the drain voltage VD and the drain current ID will not be affected by uneven quality due to production process, if the reference voltage source VREF with stable quality is employed for the drain voltage VD and a current source with stable quality is employed in a constant current source IB.

The HEMT bias circuit 19 can bring about effects similar to those of the HEMT bias circuit 16 of Embodiment 6 illustrated in Fig. 6, in terms of the temperature dependency, power supply voltage dependency, and the PSRRs.

[Embodiment 9]

Fig. 10 is a circuit diagram illustrating one exemplary configuration of a HEMT bias circuit 20 of the present embodiment.

A HEMT bias circuit 20 (bias circuit) according to the present embodiment is identical with the HEMT bias circuit 16 of Embodiment 6 except that the PMOS transistors PMOS 1 and PMOS 2 are replaced with NMOS transistors NMOS 1 and NMOS 2 (first transistor and second transistor), and the positive input terminals of the operational amplifiers AMPS 2 and OPAMP 3 are connected with what the negative input terminals of the operational amplifiers AMPS 2 and OPAMP 3 are connected in Embodiment 6, and vice versa.

That is, the positive input terminal (second input terminal) of the operational amplifier AMP 2 is connected with the drain terminal of the HEMT 1. The negative input terminal (first input terminal) of the operational amplifier AMP 2 is connected with the potential VY. The output terminal AMP 2 is connected with the gate terminal of the NMOS transistor NMOS 1. The positive input terminal (second input terminal) of the operational amplifier AMP 3 is connected with the reference voltage source VREF. The negative input terminal (first input terminal) of the operational amplifier AMP 3 is connected with the source terminal of the NMOS transistor NMOS 2 via the resistor R1 and the resistor R2. The output terminal of the operational amplifier AMP 3 is connected with the gate terminal (control terminal) of the NMOS transistor NMOS 2. The drain terminal (first conduction terminal) of the NMOS transistor NMOS 1 is connected with the power supply voltage VDD. The source terminal (second conduction terminal) of the NMOS transistor NMOS 1 is connected with the gate terminal of the HEMT 1. The drain terminal of the NMOS transistor NMOS 2 is connected with the power supply voltage VDD. The source terminal of the NMOS transistor NMOS 2 is connected with ground via the resistor R2, the resistor R1, and the resistor RR in this order.

As illustrated in Fig. 10, the HEMT bias circuit 20 has a configuration very similar to the HEMT bias circuit 16 of Embodiment 6 illustrated in Fig. 6. Hence, the HEMT bias circuit 20 can bring about effects very similar to those of the HEMT bias circuit 16 in terms of the temperature dependency, the power supply voltage dependency, and the PSRRs.

[Embodiment 10]

An HEMT bias circuit of the present embodiment is identical with the HEMT bias circuit 16 of Embodiment 6 except that the PMOS transistors PMOS 1 and PMOS 2 are replaced with PNP bipolar transistors (not illustrated). The HEMT bias circuit of the present embodiment has a configuration very similar to that of the HEMT bias circuit 16 of Embodiment 6, and therefore can bring about effects very similar to those of the HEMT bias circuit 16.

[Embodiment 11]

An HEMT bias circuit of the present embodiment is identical with the HEMT bias circuit 20 of Embodiment 9 except that the NMOS transistors NMOS 1 and NMOS 2 are replaced with NPN bipolar transistors (not illustrated). The HEMT bias circuit of the present embodiment has a configuration very similar to that of the HEMT bias circuit 20 of Embodiment 9, and therefore can bring about effects very similar to those of the HEMT bias circuit 20.

[Embodiment 12]

Fig. 11 is a circuit diagram illustrating one exemplary configuration of an LNA 50 according to the present embodiment. As illustrated in Fig. 11, the LNA 50 includes an HEMT 1 and an HEMT bias circuit 51 (bias circuit). The LNA 50 is configured such that a gate terminal of the HEMT 1 is provided with an input section of the LNA 50 and a drain terminal of the HEMT 1 is provided with an output section of the LNA 50.

The HEMT bias circuit 51 is identical with the HEMT bias circuit 16 of Embodiment 6 except that the PMOS transistors PMOS 1 and PMOS 2 are replaced with active elements 52 and 53 (first transistor and second transistor). The active elements 52 and 53 each have two conduction terminals (labeled with the reference numerals 1 and 3 in Fig. 11, respectively), and one control terminal (labeled with the reference numeral 2 in Fig. 11). The active elements 52 and 53 are configured such that an electric current flows between the conduction terminals when the control terminal receives a predetermined voltage. Here, the transistors are provided merely as the active elements 52 and 53 whereby input terminals of operational amplifiers AMP 2 and AMP 3 are not questioned whether they are positive or negative in polarity in the present Embodiment.

Moreover, the HEMT bias circuit 51 is integrated (formed as an integrated circuit 54). The integrated circuit 54 has a VREF terminal for establishing connection with a reference voltage source VREF, a VNEG terminal for establishing connection with a negative power supply voltage source VNEG, a VD terminal for establishing connection with a drain terminal of the HEMT 1, a VG terminal for establishing connection with a gate terminal of the HEMT 1, and the like.

The LNA 50 provided with the HEMT 1 to which the HEMT bias circuit 51 is connected has a configuration similar to the HEMT bias circuit 16 of Embodiment 6. Hence, the LNA 50 can bring about effects similar to those of the HEMT bias circuit 16 in terms of the temperature dependencies, the power supply voltage dependency, and the PSRRs.

The transistors employable as the active elements 52 and 53 are PMOS transistors, NMOS transistors, NPN bipolar transistors, PNP bipolar transistors, and the like, which may be used in combination. That is, the HEMT bias circuit 51 may be any one of the HEMT bias circuits described in Embodiments 6, and 9 to 11, or may be a combination of any of these HEMT bias circuits.

Moreover, the reason why Fig. 11 is not specific as to whether the input terminals of the operational amplifier AMP 2 and AMP 3 are positive or negative is that the polarity of the operational amplifier AMP 2 are dependent on the polarity of the transistor serving as the active element 52, and similarly the polarity of the operational amplifier AMP 3 are dependent on the polarity of the transistor serving as the active element 53. By illustrating the configuration unspecifically as to the polarities of the input terminals of the operational amplifier AMP 2 and AMP 3, Fig. 11 can illustrate more than one combinations therein collectively. Whether the input terminals of the input terminals (labeled with the reference numerals "1" and "2" in Fig. 11) of the operational amplifier AMP 2 and AMP 3 are positive or negative is dependent on the active elements 52 and 53.

As described above, the HEMT bias circuit 51 have variations as many as the combinations of the transistors employable as the active elements 52 and 53. Moreover, the HEMT bias circuit 51 may be modified like the configurations described in Embodiment 7 or example 8. Furthermore, any one of the HEMT bias circuits of examples 1 to 5 may be the HEMT bias circuit 51.

[Embodiment 13]

In Embodiment 12, the integration of the HEMT bias circuit 51 faces a problem regarding how much voltage the active element 52 can withstand. This is because a voltage between VDD and VG is applied on the active element 52 constantly. The gate voltage VG is a negative voltage and thus a potential between the VDD to VG is higher than a potential between the VDD and GND. Therefore, reliability problem would occur if the HEMT bias circuit 51 is integrated by a production process that can ensure only the potential between VDD-GND.

Moreover, there is a risk that the active element 52 may receive a voltage between VDD to VNEG temporally at initial activation of the circuit, or at switching the circuit operation. In this case, the reliability problem of the element rises due to the negative voltage of the negative power supply voltage VNEG. Thus, it is desirable to solve those problems in the HEMT bias circuit.

Fig. 12 is a circuit diagram illustrating one exemplary configuration of an LNA 60 of the present embodiment. As illustrated in Fig. 12, the LNA 60 is identical with the LNA 50 of Embodiment 12 except that the HEMT bias circuit 51 is additionally provided with a protection element 61 for protection against voltage.

The protection element 61 is disposed between the active element 52 and the VG terminal (that is, the gate terminal of the HEMT 1). The protection element 61 may be, for example, (a) a resistor, (b) a PMOS transistor, (c) PNP bipolar transistor, (d) or the other element, as illustrated in Fig. 13.

With the configuration having the protection element 61, a voltage out of a tolerable voltage range of the active element 52 will not be applied on the active element 52 to drive it. Thus, the LNA 60 can attain excellent reliability while the LNA 60 can bring about effects similarly to those of the HEMT bias circuit 16 of Embodiment 6 in terms of the temperature dependency, the power supply voltage dependency, and the PSRRs.

[Embodiment 14]

It is necessary that the voltage source for voltage application on the VREF terminal of the HEMT bias circuits of Embodiments or examples 6 to 13 should be a voltage source independent of the temperature and power supply voltage. As one example of such a voltage source, the present embodiment therefore describes a voltage source constituted by a bandgap reference circuit.

Fig. 14 is a circuit diagram illustrating one exemplary configuration of a bandgap reference circuit 70. The bandgap reference circuit 70 has a conventional and general configuration. Such a general bandgap reference circuit is known to have a circuit configuration illustrated in Fig. 14 and noted as a voltage source capable of supplying a voltage (BGR voltage) independent of the temperature and power supply voltage.

The bandgap voltage (BGR voltage) generated by the bandgap reference circuit 70 is supplied to the VREF terminal of the HEMT bias circuit 71 (bias circuit), thereby making it possible to further reduce the temperature dependency and the power supply voltage dependency in the LNA in which the HEMT bias circuit 71 is employed.

[Embodiment 15]

The HEMT bias circuits of Embodiments and examples 1 to 14 are all circuits suitable for integration. In Embodiment 12, the integrated circuit 54 is exemplified as one example. Even though Embodiment 12 is so configured that the reference voltage source VREF and the negative power supply voltage source VNEG are provided outside the integrated circuit 54, the reference voltage source VREF and the negative power supply voltage source VNEG may be similarly and easily integrated as well, depending on the circuit constituting the voltage source.

Fig. 15 is a circuit block diagram illustrating one exemplary configuration of an LNA 80 of the present embodiment. As illustrated in Fig. 15, the LNA 80 receives a bias from an integrated circuit 81. The integrated circuit 81 is a circuit in which an HEMT bias circuit 82 (bias circuit), a reference voltage generating circuit 83, and a negative voltage generating circuit 84 are integrated. The HEMT bias circuit 82 may be any of the HEMT bias circuits described above.

As the reference voltage generating circuit 83, the bandgap reference circuit 70 described in Embodiment 14 may be employed. By this, the integration can be done by employing a standard CMOS process or bipolar process.

The negative voltage generating circuit 84 may be the negative voltage generating circuit 520 as illustrated in Fig. 23. With this configuration, it is possible to constitute the negative voltage generating circuit 84 from only a plus source, condensers, and diodes. This eliminates the need of a special production process, whereby the integration can be done by employing the CMOS process, the bipolar process, or the like.

By this, the LNA 80 is provided with the HEMT bias circuit 82, the reference voltage generating circuit 83, the negative voltage generating circuit 84 in the form that they are integrated as the integration circuit 81. This makes it possible to attain a smaller mounting area and a lower mounting cost.

[Embodiment 16]

Fig. 16 is a block diagram illustrating one exemplary configuration of an LNB 100 according to the present embodiment.

As illustrated in Fig. 16, the LNB 100 includes a feedhorn 101 (antenna), a horizontally-polarized wave LNA 104 (LNA), a vertically-polarized wave LNA 105 (LNA), 2nd LNA 106 (LNA), an image filtering BPF 107, a Ku-band amplifier 108, a mixer 109, a local oscillator 110, a low-band amplifier 111, a local frequency selector 112, a horizontal/vertical selector 113, a LNA-H HEMT bias circuit 114 (bias circuit), LNA-V HEMT bias circuit 115 (bias circuit), a 2nd LNA HEMT bias circuit 116 (bias circuit), a negative voltage generating circuit 117, a bandgap reference circuit 118, a power regulator 119, and a connector 120. The LNB 100 is configured to amplify and down-convert a signal received via the feedhorn 101, and to transmit the amplified and down-converted signal to a downstream stage such as a TV set 122 or a video set 123.

It should be noted in the present embodiment that the bias circuit for LNA using the HEMT in the LNB 100 are the HEMT bias circuits of Embodiments described above. That is, the LNA-H HEMT bias circuit 114, LNA-V HEMT bias circuit 115, and the 2nd LNA HEMT bias circuit 116 are any of the HEMT bias circuits described in Embodiments above. With this configuration, the LNB 100 is improved in the temperature dependency, power supply voltage dependency, and the PSRRs in its LNA section.

In the following, a configuration and an operation of the LNB 100 are briefly explained.

An electric wave signal transmitted over a Ku-band carrier from a communication satellite is converted into a current by the horizontally-polarized wave antenna 102 (left-handed circularly-polarized wave antenna) or the vertically-polarized wave antenna 103 (right-handed circularly-polarized wave antenna) inside the feedhorn 101. The current converted by the horizontally-polarized wave antenna 102 is supplied to the horizontally-polarized wave LNA 104. The current converted by the vertically-polarized wave antenna 103 is supplied to the vertically-polarized wave LNA 105.

The horizontally-polarized wave LNA 104 and the vertically-polarized wave LNA 105 convert the current signals into voltage signals, and amplify the voltage signals. The amplified signals are further amplified by the 2nd LNA 106, and then supplied to the image filtering BPF 107. Because the horizontally-polarized wave LNA 104, the vertically-polarized wave LNA 105, and the 2nd LNA 106 should have very low NFs, they are each provided with an HEMT.

The image filtering BPF 107 filters off an unnecessary signal such as a signal in an image band. Then, the signal is further amplified by the Ku-band amplifier 108, and then supplied to the mixer 109. Because the Ku-band amplifier 108 is not required to have a low NF, it is rare that the Ku-band amplifier 108 is provided with an HEMT.

The mixer 109 multiplies the signal of the Ku-band amplifier 108 with a local signal supplied from the local oscillator 110, thereby converting the signal of the Ku-band amplifier 108 into an L-BAND (1 to 2 GHz band) signal. Then, the L-BAND amplifier 111 amplifies the L-BAND signal. For the signal, matching at 75 Ω is done, so as to drive a coaxial cable 121.

The LNB 100 is provided with a connector 120 with which the coaxial cable 121 is connected. The LNB 100 is connected with a TV set 122 or a video set 123 via the coaxial cable 121. The coaxial cable 121 has the following four functions.

(1) The coaxial cable 121 has a function of transmitting to the TV set 122 or the video set 123 the signal received by the LNB 100. That is, the coaxial cable 121 has a function of transmitting the output signal of the L-BAND amplifier 111 to the TV set 122 or the video set 123.

(2) The coaxial cable 121 has a function of transmitting, from the TV set 122 or the video set 123 to the LNB 100, the power to drive the LNB 100. The power thus transmitted is supplied to the power regulator 119. The power thus transmitted for driving the LNB 100 is generally high in voltage; about 18 V in general. Therefore, the power regulator 119 reduces the voltage of the power. Then, the power supply voltage thus stabilized is supplied to each block in the LNB 100.

(3) The coaxial cable 121 has a function of transmitting a switching signal from the TV set 122 or the video set 123 to the LNB 100, the switching signal instructing which one of the horizontally-polarized wave (left-handed circularly-polarized wave) signal or the vertically-polarized wave (right-handed circularly-polarized wave) signal the LNB 100 should receive. The switching signal thus transmitted is supplied to the horizontal/vertical selector 113. According to the switching signal, the horizontal/vertical selector 113 selects and causes the LNA-H HEMT bias circuit 114 or the LNA-V HEMT bias circuit 115 to be driven. By this, the bias power supply is switched over between the horizontally-polarized wave LNA 104 and the vertically-polarized wave LNA 105.

(4) The coaxial cable 121 has a function of transmitting a switching signal from the TV set 122 or the video set 123 to the LNB 100, the switching signal instructing to switch over a frequency of the local oscillator 110 in order to change the band of the signal to receive. The switching signal thus transmitted is supplied to the local frequency selector 112. The local frequency selector 112 identifies a local frequency that the switching signal instructs to select, and the frequency selector 112 changes the oscillation frequency of the local oscillator 110 to the local frequency.

The LNB 100 includes the negative voltage generating circuit 117 and the bandgap reference circuit 118 in the present embodiment, but the negative voltage generating circuit 117 and the bandgap reference circuit 118 may be provided if necessary, and thus may not be provided.

Moreover, the LNB 100 has a plurality of functional blocks. The LNA-H HEMT bias circuit 114, the LNA-V HEMT bias circuit 115, and the 2nd LNA HEMT bias circuit 116 may be integrated with part or all of the functional blocks other than them. The integration reduces the component mounting area and component mounting cost, thereby making it possible to reduce size and cost of the LNB 100.

It should be noted that Fig. 16 illustrates one example in which the Ku-band amplifier 108, the mixer 109, the local oscillator 110, the low-band amplifier 111, the local frequency selector 112, the horizontal/vertical selector 113, the LNA-H HEMT bias circuit 114, the LNA-V HEMT bias circuit 115, the 2nd LNA HEMT bias circuit 116, the negative voltage generating circuit 117, and the bandgap reference circuit 118 are integrated (into the integrated circuit 124).

[Embodiment 17]

Fig. 17 is a block diagram illustrating one exemplary configuration of a communication system 150 of the present embodiment.

As illustrated in Fig. 17, the communication system 150 is a system in which a transmitter 151 (communication transmitter) and a receiver 152 (communication receiver) communicate with each other via a communication channel 153. The communication channel 153 is not limited to a specific type and may be wire-less, wired, electromagnetic coupling, optical, or the other type of communication channel.

The transmitter 151 includes a transmitting device 154, an LNA 155, a HEMT bias circuit 156 (bias circuit), and a signal processing circuit 157. The transmitter 151 is configured such that the LNA 155 amplifies a signal processed by the signal processing circuit 157, and sends the amplified signal to the transmitting device 154, and the transmitting device 154 is activated by receiving the signal from the LNA 155 and transmits the signal to the receiver 152 via the communication channel 153. On the LNA 155, a gate voltage as a bias voltage is applied from the HEMT bias circuit 156.

The receiver 152 includes a receiver device 158, an LNA 159, an HEMT bias circuit 160 (bias circuit), and a signal processing circuit 161. The receiver 152 is configured such that the receiving device 158 receives a signal transmitted via the communication channel 153, and supplies the signal to the LNA 159, and the LNA 159 amplifies the signal thus inputted therein, and supplies the amplified signal to the signal processing circuit 161. On the LNA 159, a gate voltage as a bias voltage is applied from the HEMT bias circuit 160.

The HEMT bias circuit 156 of the transmitter 151 and the HEMT bias circuit 160 of the receiver 152 are any of the HEMT bias circuits described in Embodiments above. BY this, it is possible to construct a communication system 150, which is more stable against temperature changes and power supply voltage changes than the conventional arts, and excellent in power supply noise canceling ability due to its high PSRRs.

[Embodiment 18]

Fig. 18 is a block diagram illustrating one exemplary configuration of a sensor system 170 of the present embodiment.

As illustrated in Fig. 18, the sensor system 170 includes a sensing device 171, an LNA 172, an HEMT bias circuit 173 (bias circuit), and a signal processing circuit 174. The sensing device 171 is configured to detect a change in an object that the sensing device 171 monitors, and to generate a signal based on the detected change. The sensing device 171 is not limited as to types of physical amount to detect. The sensor system 170 is configured such that the LNA 172 amplifies the signal detected and generated by the sensing device 171 and supplies the amplified signal to the signal processing circuit 174. On the LNA 172, a gate voltage as a bias voltage is applied from the HEMT bias circuit 173.

Any one of the HEMT bias may be the HEMT bias circuit 173. BY this, it is possible to construct a sensor system 170, which is more stable against temperature changes and power supply voltage changes than the conventional arts, and excellent in power supply noise canceling ability due to its high PSRRs.

In the above, Embodiments and examples 1 to 18 describes the HEMT bias circuits for HEMT. However, it should be noted that the HEMT bias circuits described above are not only applicable to HEMT but also to transistor other than HEMT. For example, the HEMT bias circuits described above are applicable to transistors in general such as JFET, MOSFET, bipolar transistors and the like, and can be used as a bias circuit for these transistors.

[Examples]

The effects of a bias circuit according to the present invention is described below quantitatively and visually. Here, results of comparison between the HEMT bias circuit 16 described in Embodiment 6 and illustrated in Fig. 6 and the conventional HEMT bias circuit 500 illustrated in Fig. 21 are discussed as one example.

Here, the specifications of the HEMTs 1 and 501 are defined as follows:

(1) VDD = 3.3 V
(2) VD (drain voltage supplied to HEMT) = 2 V
(3) ID (drain current supplied to HEMT) = 8 mA

Moreover, in the following, the HEMT bias circuit 16 of Fig. 6 is referred to as the present Example and the conventional HEMT bias circuit 500 of Fig. 21 is referred to as conventional Example.

In Fig. 26, characteristics of (a) the drain voltage of the HEMT and (b) the drain current of HEMT are plotted against a temperature change. In Fig. 27, the formulae for the drain voltage and the drain current of the HEMT, which show the curves as plotted in Fig. 26, are listed. In the conventional Example, the drain voltage and the drain current are highly dependent on the temperature as described above. On the other hand, in the present Example, the drain voltage and the drain current show very low temperature dependency.

Thus, in the present Example, the drain voltage VD and the drain current ID supplied to the HEMT are less dependent on the surrounding temperature, compared with the conventional Example. Therefore, the present Example is advantageous in that NF and gain of the LNA is stable under various temperature conditions during the usage of the LNB.

In Fig. 28, characteristics of (a) the drain voltage of the HEMT and (b) the drain current of HEMT are plotted against a power supply voltage change. In the conventional Example, the drain voltage and the drain current are highly dependent on the power supply voltage change as described above. On the other hand, in the present Example, the drain voltage and the drain current show very low power supply voltage change dependency.

Thus, in the present Example, the drain voltage VD and the drain current ID supplied to the HEMT are less dependent on the power supply voltage, compared with the conventional Example. Therefore, the present Example is advantageous in that NF and gain of the LNA is stable under various power supply voltage conditions during the usage of the LNB.

In Fig. 29, PSRR characteristics at (a) the drain terminal of the HEMT and (b) the gate terminal of HEMT are plotted against the power supply voltage VDD. In Fig. 30, the formulae for PSRRs at the drain terminal and the gate terminal of the HEMT, which show the curves as plotted in Fig. 29, are listed. In the conventional Example, the PSRRs are high for both the drain terminal and the gate terminal, thereby resulting in a poor noise canceling ratio for the noise from the power supply voltage VDD, as described above. On the other hand, in the present Example, the PSRRs against the power supply voltage VDD are very low for both the drain terminal and the gate terminal.

Therefore, in the present Example, the noise from the power supply voltage VDD to the drain terminal and the gate terminal of the HEMT is more suppressed than in the conventional Example. That is, the PSRRs against the power supply voltage VDD is sufficiently small in the present Example. Thus, the present Example is advantageous in that the signal amplification in the LNA can be performed excellently even under such situations that the power supply voltage VDD is superimposed with noise.

In Fig. 31, PSRR characteristics of (a) the drain terminal of the HEMT and (b) the gate terminal of HEMT are plotted against the negative power supply voltage VNEG. In Fig. 32, the formulae for PSRRs in the drain voltage and the drain current of the HEMT, which show the curves as plotted in Fig. 31, are listed. In the conventional Example, the PSRRs are high for both the drain terminal and the gate terminal, thereby resulting in a poor noise canceling ratio from the negative power supply voltage VNEG, as described above. On the other hand, in the present Example, the PSRRs against the negative power supply voltage VNEG are very low for both the drain terminal and the gate terminal.

Therefore, in the present Example, the noise from the negative power supply voltage VNEG to the drain terminal and the gate terminal of the HEMT is more suppressed than in the conventional Example. That is, the PSRRs against the negative power supply voltage VNEG is sufficiently small in the present Example. Thus, the present Example is advantageous in that the signal amplification in the LNA can be performed excellently even under such situations that the negative power supply voltage VNEG is superimposed with noise.

It can be understand from the above that the configuration of the present Example makes it possible to attain a HEMT bias circuit in which the drain current ID and the drain voltage VD of the HEMT are both set at desired values and which are low in temperature dependency and power supply voltage dependency and good in PSRRs.

[Example 19]

The HEMT bias circuits provided by the aforementioned techniques are advantageous in that both the drain current and drain voltage of the HEMT can be set to desired values, the temperature dependency and the power supply voltage dependency can be eliminated, and a very high noise canceling efficiency can be attained. Moreover, a special production process is not necessary, thereby making it possible to attain a higher degree of freedom in selecting the production process to use.

In signal electric waves from satellite broadcast, a horizontally-polarized wave and a vertically-polarized wave, or a left-handed circularly polarized wave and a right-handed circularly-polarized wave are used in order to effectively utilize frequency resources. Therefore, the LNB for receiving the polarized waves is provided with a horizontally-polarized wave (left-handed circularly polarized wave) antenna, a horizontally-polarized wave (left-handed circularly polarized wave) LNA connected with the horizontally-polarized wave antenna, a vertically-polarized wave (right-handed circularly polarized wave) antenna, and a vertically-polarized wave (right-handed circularly polarized wave) LNA connected with the vertically-polarized wave antenna.

Fig. 41 is a block diagram illustrating a configuration of a general LNB 1100. As illustrated in Fig. 41, the LNB 1100 includes (i) a feedhorn 1101 including a horizontally-polarized wave antenna 1102 (first polarized wave antenna) and a vertically-polarized wave antenna 1103 (second polarized wave antenna), (ii) a horizontally-polarized wave LNA 1104 (first polarized wave amplifier), a vertically-polarized wave LNA 1105 (second polarized wave amplifier), an LNA 1106, an image filtering filter 1107, a Ku-band amplifier 1108, a mixer 1109, a local oscillator 1110, an IF amplifier 1111, a frequency selector 1112, a polarized wave selector 1113, a power regulator 1114, and a connector 1115.

The LNB 1100 is configured to amplify and down-convert a signal received via the feedhorn 1101, and to transmit the amplified and down-converted signal to a downstream stage (such as a TV set 1117 or a video set 1118) connected thereto via a coaxial cable 1116. The LNB 1100 herein is configured to receive a horizontally-polarized wave and a vertically-polarized wave but may be configured to receive a left-handed circularly-polarized wave and a right-handed circularly polarized wave. That is, the horizontally-polarized wave antenna 1102 and the horizontally-polarized wave LNA 1104 may be replaced with ones for left-handed circularly polarized wave, while the vertically-polarized wave antenna 1103 and the vertically-polarized wave LNA 1105 may be replaced with ones for right-handed circularly polarized wave.

The electric waves (horizontally-polarized wave (first polarized wave) and vertically polarized wave (second polarized wave) transmitted over the Ku band from the communication satellite are received respectively by the horizontally-polarized wave antenna 1102 and the vertically-polarized wave antenna 1103 in the feedhorn 1101, and then are converted into current signals. The electric signal (first polarized wave signal) converted by the horizontally-polarized wave antenna 1102 is supplied to the horizontally-polarized wave LNA 1104. The electric signal (second polarized wave signal) converted by the vertically-polarized wave antenna 1103 is supplied to the vertically -polarized wave LNA 1105.

The current signals from the antennas are converted into voltage signals and amplified by the horizontally-polarized wave LNA 1104 and the vertically-polarized wave LNA 1105, respectively. Next, the amplified signals are further amplified by the LNA 1106 and then supplied to the image filtering filter 1107. The image filtering filter 1107 filters off an unnecessary signal such as a signal in an image band. Then, a signal from the image filtering filter 1107 is further amplified by the Ku-band amplifier 1108 and then supplied to the mixer 1109.

By the mixer 1109 the signal from the Ku-band amplifier 1108 is multiplied with a local signal outputted from the local oscillator 1110, thereby being converted in a signal of IF (1 to 2 GHz band). Then, the converted signal is amplified by the IF amplifier 1111, and then outputted. The IF amplifier 1111 is connected with a connector 1115 via a coupling capacitance, and is configured to perform matching at 75 $\Omega$ in order to drive the coaxial cable 1116.

The LNB 1100 is connected to the TV set 1117 or the video set 1118 via the coaxial cable 1116 connected with the connector 1115. By this, the signal received by the LNB 1100 is transmitted to the TV set 1117 or the video set 1118.

Moreover, the TV set 1117 and the video set 1118 are configured to transmit power or signals to the LNB 1100 via the coaxial cable 1116. In the LNB 1100, the connector 1115 is connected with the frequency selector 1112, the polarized wave selector 1113, and the power supply regulator 1114 via an inductor.

For example, from the TV set 1117 or the video set 1118, the power for driving the LNB 1100 is transmitted to LNB 1100 via the coaxial cable 1116. The transmitted power is supplied to the power regulator 1114. The power thus transmitted for driving the LNB 1100 is generally high in voltage; about 18 V in general. Therefore, the power regulator 1114 reduces the voltage of the power. Then, the power supply voltage thus stabilized is supplied to each block in the LNB 1100.

Moreover, in order to change the band of the signal to receive, the TV set 1117 of the video set 1118 sends a switching signal to the LNB 1100 via the coaxial cable 1116, the switching signal instructing the switch-over of the frequency of the local oscillator 1110. The switching signal thus transmitted is forwarded to the frequency selector 1112, which identifies a local frequency that the switching signal instructs to select, and the frequency selector 1112 changes the oscillation frequency of the oscillator 1110 to the local frequency.

Further, in order to select which one of the horizontally-polarized wave and the vertically-polarized wave the LNB 1100 receives, the TV set 1117 or the video set 1118 transmits a polarized wave selecting signal to the LNB 1100 via the coaxial cable 1116, the polarized wave selecting signal instructing which polarized wave the LNB 1100 receives. The polarized wave selecting signal thus transmitted is forwarded to the polarized wave selector 1113.

Here, in a general LNB system, the power supply to the LNB 1100 is performed by applying a voltage to the coaxial cable 1116 by the TV set 1117 or the video set 1118. The polarized wave selecting signal is realized by utilizing high and low levels of the voltage. The instructions as to which polarized wave LNB receives are described by whether the voltage is high or low. The polarized selector 1113 determines whether the voltage is high or low. Based on the determination, the polarized selector 1113 selects a polarized wave to receive. One easy way to select the polarized wave to receive is to turn on and off the horizontally-polarized wave LNA 1104 and the vertically-polarized wave LNA 1105 in such a way that the LNA for receiving the polarized wave to receive is turned on while the LNA for receiving the polarized wave not to receive is turned off.

Fig. 42 schematically illustrates a configuration of an LNA 1200, which is one example of the horizontally-polarized wave LNA 1104 and the vertically polarized wave LNA 1105. The LNA 1200 includes an HEMT 1201, the HEMT bias circuit 1202, and the switches 1203 and 1204. The horizontally-polarized wave LNA 1104 and the vertically-polarized wave LNA 1105 should have very low NF. Thus, HEMT 1201 is used herein. As the HEMT bias circuit 1202 for the HEMT 1201, any of the HEMT bias circuits according to the aforementioned technique is used, for example.

A gate terminal of the HEMT 1201 is connected with the HEMT bias circuit 1202 via the switch 1203 when the switch 1203 is turned on. When the switch 1203 is turned off, the gate terminal of the HEMT 1201 is grounded. The switch 1203 is turned on and off according to the polarized wave selecting signal outputted from the polarized wave selector 1113. By being turned on and off, the switch 1203 connects or disconnects the gate terminal of the HEMT 1201 with the HEMT bias circuit 1202. The drain terminal of the HEMT 1201 is connected with the HEMT bias circuit 1202 via the switch 1204 when the switch 1204 is turned on. When the switch 1204 is turned off, the drain terminal of the HEMT 1201 is grounded. The switch 1204 is turned on and off according to the polarized wave selecting signal. By being turned on and off, the switch 1204 connects or disconnects the drain terminal of the HEMT 1201 with the HEMT bias circuit 1202. By this, the LNA 1200 can be turned on (at operation) or turned off (at rest) by switching whether to apply the bias on the HEMT 1201.

However, in the LNA 1200, the operation with the drain voltage VD and the operation with gate voltage VG are performed concurrently at the moment of switching over the bias application from applying to not-applying or from not applying or to applying. Therefore, there is such a problem that a large shoot-through current flows through the HEMT 1201 at the moment of switching over the bias application.

Fig. 43 illustrates a timing chart for switching over whether to apply the bias on the HEMT 1201. As illustrated in Fig. 43, in order to switch over whether to apply the bias on the HEMT 1201, the polarized wave selecting signal is changed from a low level (off) to a high level (on), or from the high level to the low level (off). Upon the level change of the polarized wave selecting signal, the drain voltage VD and the gate voltage VG start to change. Until the drain voltage VD and the gate voltage VG are stabilized from the start of the change in the drain voltage VD and the gate voltage VG, that is, while the drain voltage VD and the gate voltage VG are at operation, a large shoot-through current (drain current ID) flows through the HEMT 1201. An excess shoot-through current would cause a physical damage to the HEMT 1201, thereby deteriorating a long-term reliability.

Therefore, there are demands for a bias circuit in which an excess shoot-though current occurring at switching over whether to supply the bias is prevented, and an LNA or LNB provided with the same.

(Configuration of HEMT bias circuit)

Fig. 33 is a circuit diagram illustrating one exemplary configuration of a HEMT bias circuit 1010.

The HEMT bias circuit 1010 (bias circuit) is a bias circuit for HEMT 1 (Amplification FET) whose source terminal is grounded. The HEMT 1 is configured to amplify an input signal. The HEMT bias circuit 1010 includes, as illustrated in Fig. 33, an operational amplifier AMP 1 (dual supply differential amplifier), a resistor RI (first resistor), a switch SWg (first switch), a switch SWd (second switch), a negative power supply power source VNEG, a reference voltage source VDRAIN (second reference voltage source), and a referent voltage source VREF (first reference voltage source).

The operational amplifier AMP 1 is an dual supply operational amplifier, and is constituted as a differential amplifier. A positive power supply terminal of the operational amplifier AMP 1 is connected with a power supply voltage VDD. A negative power supply terminal of the operational amplifier AMP 1 is connected with the switch SWg, which is switched over to connect the negative power supply terminal with the negative power supply voltage source VNEG or to ground the negative power supply terminal. A positive input terminal (non-reversing input terminal) of the operational amplifier AMP 1 is connected with a drain terminal of the HEMT 1. A negative input terminal (reversing input terminal) of the operational AMP 1 is connected with the reference voltage source VDRAIN. An output terminal of the operational amplifier AMP 1 is connected with a gate terminal of the HEMT 1.

The resistor RI has two terminals, one (first terminal) of which is connected with the drain terminal of the HEMT 1 and the other one (second terminal) of which is connected with the switch SWd, which is switched over to connect the other one of the terminals of the resistor RI with the reference voltage source VREF or to ground the other one of the terminals.

The switch SWg is configured to switch over according to a control signal SG an a reversing control signal /SG (SG bar; which is reverse to the control signal SG) in order to connect the negative power supply terminal of the operational amplifier AMP 1 with the negative power supply voltage source VNEG or to ground the negative power supply terminal. The switch SWg connects the negative power supply terminal of the operational amplifier AMP 1 with the negative power supply voltage source VNEG when the control signal SG is high and the reversing control signal /SG is low. The switch SWg grounds the negative power supply terminal of the operational amplifier AMP 1 when the control signal SG is low and the reversing control signal / SG is high.

The switch SWd is configured to switch over according to a control signal SD and a reversing control signal /SD (SD bar; which is reverse to the control signal SD) in order to connect the resistor RI, that is, the drain terminal of the HEMT 1 with the reference voltage source VREF or with the resistor RI. The switch SWd connects the drain terminal of the HEMT 1 with the reference voltage source VREF when the control signal SD is high and the reversing control signal /SD is low. The switch SWd grounds the drain terminal of the HEMT 1 when the control signal SD is low and the reversing control signal /SD is high.

The control signal SG, the reversing control signal /SG, the control signal SD, and the reversing control signal/SD are generated by the control signal generating circuit, and supplied to the switch SWg and the switch SWd correspondingly from the control signal generating circuit. The control signal generating circuit will be described later.

The negative power supply voltage source VNEG generates a negative power supply voltage (also called negative power supply voltage VNEG) for the negative power supply terminal of the operational amplifier AMP 1. The reference voltage source VDRAIN generates a positive voltage (also called a reference voltage VDRAIN) for the negative input terminal of the operational amplifier AMP 1. The reference voltage source VREF generates a positive voltage (also called reference voltage VREF) for the drain terminal of the HEMT 1. The reference voltage source VDRAIN and the reference voltage source VREF are totally independent of a change in the temperature T or the power supply voltage VDD. The power supply voltage VDD herein is a positive power supply voltage and may be shared with another member not within the circuit.

(Drain voltage VD and drain current ID)

The HEMT bias circuit 1010 is configured such that the HEMT 1 is part of a negative feedback loop of the operational amplifier AMP 1. By this, (i) the negative power supply terminal of the operational amplifier AMP 1 is connected with the negative power supply voltage source VNEG, and (ii) while the drain terminal of the HEMT 1 is connected with the reference voltage source VREF, the drain voltage VD and the drain current ID of the HEMT 1 are automatically determined according to the following approximation formulae (54) and (55):

[Math. 26)

$$V_D \approx V_{DRAIN} \ldots (54)$$

$$I_D \approx \frac{V_{REF} - V_{DRAIN}}{R_I} \ldots (55)$$

where the values in the formulae are as follows:

$V_D$: Voltage value of drain voltage VD
$I_D$: Ampere value of drain current ID
$V_{DRAIN}$: Voltage value of reference voltage source VDRAIN
$V_{REF}$: Voltage value of reference voltage source VREF
RI: Volt value of resistor RI

That is, the reference voltage VDRAIN terminal of the reference voltage source VDRAIN is inputted to an input terminal of the operational AMP 1, thereby to obtain a predetermined voltage (=reference voltage VDRAIN) at the drain terminal of the HEMT 1. Moreover, by providing the resistor RI between the reference voltage source VREF and the drain terminal of the HEMT 1, a potential different between the reference voltage VREF and the reference voltage VDRAIN is obtained across the resistor RI, thereby obtaining a desired drain current ID.

The formulae (54) and (55) are not functions of the temperature T and the power supply voltage VDD. Therefore, the drain voltage VD and the drain current ID of the HEMT 1 is independent of the changes in the temperature T and the power supply voltage VDD. Hence, it is possible to eliminate temperature dependency and power supply voltage dependency from the HEMT bias circuit 1010.

Moreover, PSRRs (Power Supply Rejection Ratios) at the gate terminal of the HEMT 1 against the power supply voltage VDD and the negative power supply voltage VNEG become identical with a PSRR of the operational amplifier AMP 1, thereby making it possible to attain a very high noise canceling efficiency. The PSRR is an index indicating how much a noise from a certain power supply voltage (here, the power supply voltage VDD and a negative power supply voltage VNEG) is attenuated at a terminal of interest.

Further, the operational amplifier AMP 1 can be configured without a special production process. Therefore, the HEMT bias circuit 10 can be formed with any kind of transistor, while the conventional HEMT bias circuit 500 as illustrated in Fig. 21 requires a PNP bipolar transistor. Therefore, the HEMT bias circuit 10 is high in degree of freedom in selecting a production process, and can be produced as an integrated circuit by various processes such a CMOS process, MOS process, bipolar process, BiCMOS process, and the like.

However, recently, operational amplifiers (differential amplifiers) are provided with a single power supply in most of cases. Moreover, the operational amplifier AMP 1 illustrated in Fig. 33 disadvantageously requires two power supplies whose powers are positive and negative respectively in reference with a GND level.

(LNA and LNB)

The HEMT bias circuit 1010 is applicable to LNAs (low Noise amplifiers) in which a HEMT is used. Thus, the LNAs can be realized as LNAs provided with at least the HEMT 1 and the HEMT bias circuit 1010.

Fig. 40 is a circuit block diagram illustrating one exemplary configuration of an LNA 1070. The LNA 1070 includes the HEMT 1 and the HEMT bias circuit 1010. The LNA 1070 is configured such that an input section 1071 is provided to the gate terminal of the HEMT 1 and an output section 1072 is provided to the drain terminal of the HEMT 1.

The LNA 1070 provided with such an HEMT bias circuit 1010 can drive the HEMT 1 at a proper operation point, and can bring about an effect similar to that of the HEMT bias circuit 1010 described above.

Moreover, the LNA 1070 is applicable to LNBs (Low Noise Block converters), which are for receiving satellite broadcast, for example. One example of such LNBs is the LNB 1100 illustrated in Fig. 41 and described above. When the LNA 170 is applied to the LNB 1100, the LNAs 170 are used as the horizontally-polarized wave LNA 1104 and the vertically-polarized wave LNA 1105. By adopting the LNAs 1070, gains and NFs of the horizontally-polarized wave LNA 1104 and the vertically-polarized wave LNA 1105 can be optimized in the LNB 1100. This makes it possible for the LNB 1100 to excellently receive a minute signal received via a feedhorn 1101 (horizontally-polarized wave antenna 1102 and the vertically-polarized wave antenna 1103).

Moreover, the LNB 1100 has a plurality of functional blocks. The functional blocks may be partly integrated by combining any ones of them, or may be wholly integrated. The partial or whole integration of the LNB 1100 reduces a component mounting areas and component mounting cost, thereby making it possible to realize downsizing and cost reduction of the LNB 1100.

Here, by turning on and off the switch SWg and switch SWd, the HEMT bias circuit 1010 can switch over whether to apply a bias on the HEMT 1. That is, the HEMT bias circuit 1010 can turn on and off the LNA 1070.

The LNB 1100 illustrated in Fig. 41 is configured to selectively receive the horizontally-polarized wave (left-handed circularly polarized wave) and the vertically-polarized wave (right-handed circularly polarized wave) as a signal electric wave from the satellite broadcast. According to the polarized selecting signal outputted from the polarized wave selector 113, the LNB 1100 turns on and off the horizontally-polarized wave LNA 1104 and the vertically-polarized wave LNA 1105 in such a way that the LNA for receiving the polarized wave to receive is turned on while the LNA for receiving the polarized wave not to receive is turned off.

Therefore, the LNA 1070 provided with the HEMT 1 and the HEMT bias circuit 1010 is configured to turn on and off the switch SWg and the switch SWd according to the polarized wave selecting signal, thereby making it possible to easily select which one of the polarized waves the LNA 1106 receives.

The polarized wave selecting signal is a binary signal (having high level and low level). Therefore, it is necessary to have a control signal generating circuit for generating the control signal SG, the reversing control signal /SG, the control signal SD, and the reversing control signal /SD from the polarized wave selecting signal. Therefore, the LNB 1100 is provided with the control signal generating circuits 1050 connected with the HEMT bias circuit 1010, for example, as illustrated in Fig. 40. The control signal generating circuit 1050 is provided per LNA (for the horizontally-polarized wave LNA 1104 and the vertically-polarized wave LNA 1105, respectively).

(Control Signal Generating Circuit)

Next, the control signal generating circuit 1050 is explained.

Fig. 34 is a circuit diagram illustrating one exemplary configuration of the control signal generating circuit 1050. As illustrated in Fig. 34, the control signal generating circuit 1050 includes NOT gates 1051, 1052, 1055, and 1057, and a capacitor 1053, a NOR gate 1054, and an NAND gate 1056.

Moreover, the control signal generating circuit 1050 includes an input section 1058 for receiving the polarized wave selecting signal, an output section 1059 for outputting the control signal SG, an output section 1060 for outputting the reversing control signal /SG, an output section 1061 for outputting the control signal SD, and an output section 1062 for outputting the reversing control signal /SD. The input section 1058 is connected with the polarized wave selector 1113. The output sections 1059 and 1060 are connected with the switch SWg of the HEMT bias circuit 1010. The output sections 1061 and 1062 are connected with the switch SWd of the HEMT bias circuit 1010.

The NOT gates 1051, 1052, 1055, and 1057 are logic circuits, which are for NOT operation and configured to have one output and one input. The logic circuits are also called invertors. The NOR gate 1054 is a logic circuit for NOR operation and configured to have one output and two inputs. The NAND gate 1056 is a logic circuit for NAND operation and configured to have one output and two inputs. An input section of the NOT gate 1051 is connected with the input section 1058, and an output section of the NOT gate 1051 is connected with an input section of the NOT gate 1052. An output section of the NOT gate 1052 is connected with a first input section of the NOR gate 1054 and a first input section of the NAND gate 1056. The capacitor 1053 has two terminals, one of which is connected with an output section of the NOT gate 1052 and another one of which is grounded. A second input section of the NOR gate 1054 and a second input section of the NAND gate 1056 are connected with the input section 1058. An output section of the NOR gate 1054 is connected with the input section of the NOT gate 1055 and also with the output section 1060. An output section of the NOT gate 1055 is connected with the output section 1059. An output section of the NAND gate 1056 is connected with an input section of the NOT gate 1057 and connected with the output section 1062. An output section of the NOT gate 1057 is connected with the output section 1061.

When the polarized wave selecting signal is high, the control signal generating circuit 1050 generates the control signal SG and the control signal SD with the high level and generates the reversing control signal /SG and the reversing control signal /SD with the low level. On the other hand, when the polarized wave selecting signal is low, the control signal generating circuit 1050 generates the control signal SG and the control signal SD with the low level and generates the reversing control signal /SG and the reversing control signal /SD with the high level. By this, the LNA 1070 can be turned on and off according to whether the polarized wave selecting signal is high or low.

However, the control signal generating circuit 1050 is configured such that a delay element 1063 is constituted by the NOT gates 1051 and 1502 and the capacitor 1053. With this configuration, a level change in the control signal SD and the reversing control signal /SD occurs not simultaneously with a level change in the control signal SG and the reversing control signal /SG (that is, a delay occurs between the level changes).

(Switching Timing for Turning On and Off)

Next, switching timing for switching whether to apply a bias on the LNA 1070 provided with the HEMT 1 and the HEMT bias circuit 1010.
Fig. 35 is a timing chart illustrating signal waves in the LNA 1070 when the switching as to whether to apply the bias is carried out.

<Time t1>

When the polarized wave selecting signal is changed from low to high, the second input section of the NOR gate 1054 and the second input section of the NAND gage 1056 become high. Meanwhile, the first input section of the NOR gate 1054 and the first input section of the NAND gate 1056 are still low due to the delay element 1063. As a result, the output section of the NOR gate 1054 changes to low, while the output section of the NAND gate 1056 is still high. Consequently, the control signal SG becomes high and the control signal SD becomes low.

<Time t2>

When a certain time period (period A) has passed from the change of the polarized selecting signal from low to high, the first input section of the NOR gate 1054 and the first input section of the NAND gate 1056 change to high. As a result, the output section of the NAND gate 1056 changes to low, while the output section of the NOR gate 1054 is still low. By this, the control signal SG and the control signal SD both become high.

<Time t3>

When the polarized wave selecting signal becomes high to low, the second input section of the NOR gate 1054 and the second input section of the NAND gate 1056 change to low. Meanwhile, the first input section of the NOR gate 1054 and the input section of the NAND gate 1056 are still high due to the delay element. As a result, the output section of the NAND gate 1056 changes to high, while the output section of the NOR gate 1054 is still low. Consequently, the control signal SG becomes high and the control signal SD becomes low.

<Time t4>

When a certain time period (period B) has passed since the change of the polarized wave selecting signal from high to low, the first input section of the NOR gate 1054 and the first input section of the NAND gate 1056 change to low. As a result, the output section of the NOR gate 1054 becomes high, while the output section of the NAND gate 1056 is still high. Consequently, the control signal SG and the control signal SD both become low.
As described above, the period A is provided in which, when the polarized wave selecting signal is changed from low to high in order to turn on the LNA 1070 that has been off, the control signal SG becomes high and the reversing control signal /SD becomes high, whereby the gate voltage VG is applied to the HEMT 1 while the drain voltage VD is still zero. Because of the period A, carriers present in a channel of the HEMT 1 are decreased thereby making it difficult for shoot-through electrode.
Therefore, by setting the period A to be sufficiently long or long enough to allow the HEMT 1 to reach a pinch-off, the control signal SD becomes high after the period A, whereby excess drain current ID is prevented from flowing even if the drain voltage VD is applied to the HEMT 1.
On the other hand, the period B is provided in which, when the polarized wave selecting signal is changed from high to low in order to turn off the LNA 1070 that has been on, the control signal SG becomes high and the reversing control signal /SD becomes high, whereby the drain voltage VD is kept to zero until the gate voltage VG is applied to the HEMT 1. In the period B, the gate voltage VG is still negative as a negative power supply voltage, thereby preventing an excess drain current ID from flowing. Thus, it is possible to prevent an excess drain current ID from flowing.
Note that the periods A and B can be set by the configuration of the delay element 63.
As described above, the HEMT bias circuit 1010 is configured to supply a bias to the HEMT 1 whose source terminal is grounded, and the HEMT bias circuit 1010 includes the operational amplifier AMP1, the resistor RI, the switch SWg, the switch SWd, the reference voltage source VREF, the reference voltage source VDRAIN, and the negative power supply voltage source VNEG, wherein the positive input terminal of the operational amplifier AMP 1 is connected with the drain terminal of the HEMT 1, and the negative input terminal of the operational amplifier AMP 1 is connectable with the negative power supply voltage source VNEG or with ground according to switching of the switch SWg, and the resistor RI has a first terminal and a second terminal, the first terminal being connected to the drain terminal of the HEMT 1, and the second terminal being connectable with the reference voltage source VREF or with ground according to the switching of the switch SWd.

The HEMT bias circuit 1010 is configured such (i) that, in order to switch over to biasing the HEMT 1 from not biasing the HEMT 1, (1) the switch SWg is switched to switch over the negative power supply terminal of the operational amplifier AMP 1 from being grounded to being connected with the negative power supply voltage source VNEG, and then (2) the switch SWd is switched to switch over the second terminal of the resistor RI from being grounded to being connected with the reference voltage source VREF, and (ii) that in order to switch over to not biasing the HEMT 1 from biasing the HEMT 1, (1) the switch SWd is switched to switch over the second terminal of the resistor RI from being connected with the reference voltage source VREF to being grounded, and then (2) the switch SWg is switched to switch over the negative power supply terminal of the operational amplifier AMP 1 from being connected with the negative power supply voltage source VNEG to being grounded.

With this configuration, in switching over to biasing the HEMT 1 from not biasing the HEMT 1, the gate terminal of the HEMT 1 is biased to a negative voltage and then the drain voltage is applied on the drain terminal of the HEMT 1. That is, the voltage is applied on the gate terminal of the HEMT 1 before the voltage is applied on the drain terminal of the HEMT 1. Therefore, the carriers present in the channel of the HEMT 1 are decreased in a period between starting of the voltage application on the gate terminal of the HEMT 1 and starting of the voltage application of the drain terminal of the HEMT 1, thereby making it difficult for shoot-through electrode.

On the other hand, in switching over to not biasing the HEMT 1 from biasing the HEMT 1, the drain voltage of the HEMT 1 becomes zero and then the gate voltage of the HEMT 1 becomes zero. That is, the voltage applied to the gate terminal of the HEMT 1 is faded out after the voltage applied to the drain terminal of the HEMT 1 is faded out. Therefore, the gate terminal of the HEMT 1 still receives a negative voltage in a period between the fading-out of the voltage applied to the drain terminal of the HEMT 1 and the fading-out of the voltage applied to the gate terminal of the HEMT 1, thereby making it possible to - prevent an excess drain current from flowing.

That is, the HEMT bias circuit 1010 is capable of controlling the timings of performing the voltage application to the gate terminal of the HEMT 1 and fading out the voltage applied to the gate terminal of the HEMT and the timings of performing the voltage application to the drain terminal of the HEMT 1 and fading out the voltage applied to the drain terminal of the HEMT 1 by the timings of the switching over of the switches SWg and SWd, so that a large shoot-through current will not flow.

Therefore, it is possible to perform, without the risk of an excess shoot-through current, the switching over to not biasing the HEMT 1 from biasing the HEMT 1, and the switching over to biasing the HEMT 1 from not biasing the HEMT 1.

[Embodiment 20]

(Configuration of HEMT Bias Circuit)

Fig. 36 is a circuit diagram illustrating one exemplary configuration of a HEMT bias circuit 1020 according to the present embodiment.

The HEMT bias circuit 1020 according to the present embodiment is a bias circuit for HEMT 1 whose source terminal is grounded. As illustrated in Fig. 36, the HEMT bias circuit 1020 includes an operational amplifier AMP 2 (first differential amplifier), an operational amplifier AMP 3 (second differential amplifier), a resistor RI, a resistor RG (second resistor), a resistor RGG (sixth resistor), a resistor RR (third resistor), a resistor R1 (fourth resistor), a resistor R2 (fifth resistor), a capacitor CD (first capacitor), a capacitor CG (second capacitor), an N-channel MOSFET (hereinafter, NMOS transistor) 1021 (first transistor), a P-channel MOSFET (hereinafter, PMOS transistor) 1022 (second transistor), a switch SWg, a switch SWd, a negative power supply voltage- source VNEG, and a reference voltage source VREF.

The HEMT bias circuit 1020 is configured such that the reference voltage source VDRAIN and the reference voltage source VREF used in Embodiment 19 are generated by a circuit constituted by the operational amplifier AMP 3, the PMOS transistor 1022, the resistor R2, the resistor R1, the resistor RR, and the reference voltage source VREF.

The operational amplifier AMP 2 is a single supply operational amplifier and is configured as a differential amplifier. A positive input terminal (second input terminal) of the operational amplifier AMP 2 is connected with a drain terminal of the HEMT 1. A negative input terminal (first input terminal) of the operational amplifier AMP 2 is connected with a drain terminal of the PMOS transistor 1022 via the resistor R2. Moreover, a negative input terminal of the operational amplifier AMP 2 is connected with a positive input terminal of the operational amplifier AMP 3 via the resistor R1. An output terminal of the operational amplifier AMP 2 is connected with a gate terminal (control terminal) of the NMOS transistor 1021.

The operational amplifier AMP 3 is a single supply operational amplifier and is configured as a differential amplifier. A positive input terminal (first input terminal) of the operational amplifier AMP 3 is connected with a drain terminal of the PMOS transistor 1022 via the resistors R1 and R2. Moreover, the positive input terminal of the operational amplifier AMP 3 is grounded via the resistor RR. A negative input terminal of the operational amplifier AMP 3 (second input terminal) is connected with the reference voltage source VREF. An output terminal of the operational amplifier AMP 3 is connected with a gate terminal (control terminal) of the PMOS transistor 1022. The PMOS transistor 1022, the resistor R2, and the resistor R1 are part of a negative feedback loop of the -operational amplifier AMP 3.

A drain terminal (first conduction terminal) of the NMOS transistor 1021 is connected with the power supply voltage VDD. A source terminal (second conduction terminal) of the NMOS transistor 1021 is connected with a gate terminal of the HEMT 1 via the resistor RGG. Moreover, a source terminal of the NMOS transistor 1021 is connected with the negative power supply voltage source VNEG via the resistor RG. That is, one (third terminal) of terminals of the resistor RG is connected with the gate terminal of the HEMT 1, and the other one (fourth terminal) of the terminals of the resistor RG is connected with the negative power supply voltage source VNEG.

A source terminal (first conduction terminal) of the PMOS transistor 1022 is connected with the power supply voltage VDD. A drain terminal (second conduction terminal) of the PMOS transistor 1022 is connected with ground via the resistors R2, R1, and RR in this order. Moreover, a drain terminal of the PMOS transistor 1022 is connected with a drain terminal of the HEMT 1 via the resistor R1.

The capacitor CD has two terminals, one (fifth terminal) of which is connected with the drain terminal of the HEMT 1, and the other one (sixth terminal) of which is grounded. The capacitor CG has two terminals, one (seventh terminal) of which is connected with the gate terminal of the HEMT 1, and the other one (eighth terminal) of which is connected with the source terminal of the HEMT 1.

The switch SWg has two terminals in the present embodiment. One of the two terminals of the switch SWg is connected with a node of a route electrically connected the resistor RGG and the resistor RG. The other one of the two terminals of the switch SWg is grounded. The switch SWg is turned on and off according to the reversing control signal /SG. The switch SWg is turned on when the reversing control signal /SG is high. The switch SWg is turned off when the reversing control signal /SG is low. By switching over the switch SWg, the gate terminal of the HEMT 1 is connected with the negative power supply voltage source VNEG or with ground.

The switch SWd has two terminals in the present embodiment. One of the two terminals of the switch SWd is connected with an output terminal of the operational amplifier AMP 3. The other one of the terminals of the switch SWd is connected with the power supply voltage VDD. The switch SWd is turned on and off according to the reversing control signal /SD. The switch SWd is turned on when the reversing control signal /SD is high. The switch SWd is turned off when the reversing control signal /SD is low. By switching over the switch SWd, the gate terminal of the PMOS transistor 1022 is switched over between being connected with the output terminal of the operational amplifier AMP 3 and being connected with the power supply voltage VDD.

In the present embodiment, the negative power supply voltage source VNEG is configured to generate a negative power supply voltage (negative power supply voltage VNEG) to be supplied to the gate terminal of the HEMT 1. In the present embodiment, the reference voltage source VREF is configured to generate a positive voltage (reference voltage VREF) to be supplied to the negative input terminal of the operational amplifier AMP 3.

(Drain voltage VD and Drain current ID)

The HEMT bias circuit 1020 is configured such that a first feedback loop including the operational amplifier AMP 3 and a second feedback loop including the operational amplifier AMP 2 are formed. The HEMT 1 is part of the negative feedback loop. By this, while the switches SWg and SWd are on, the drain voltage VD and the drain current ID of the HEMT 1 are automatically determined according to the following approximation formulae (56) and (57).
[Math. 27]

$$V_D \approx \frac{R_R + R_1}{R_R} * VREF \ldots (56)$$

$$I_D = \frac{1}{R_I} * \frac{R_2}{R_R} * VREF \ldots (57)$$

where the values in the formulae are as follows: $V_D$: Volt value of drain voltage VD

$I_D$: Ampere value of drain current ID

$V_{REF}$: Volt value of reference voltage source VREF

$R_I$: Resistance of resistor RI

$R_R$: Resistance of resistor RR

$R_1$: Resistance of resistor R1

$R_2$: Resistance of resistor R2

Here, temperature coefficients of the drain voltage VD and the drain current ID, which are determined by differentiating the formulae (56) and (57) with temperature T, are zero. Therefore, it is possible to perfectly eliminate the temperature dependency in the HEMT bias circuit 1020.

Moreover, coefficients of changes in the drain voltage VD and the drain current ID against the power supply voltage VDD, which are determined by differentiating the formulae (5) and (6), are zero. Therefore, it is possible to perfectly eliminate the power supply voltage dependency in the HEMT bias circuit 1020.

Further, as in the HEMT bias circuit 16 described in Embodiment 6, the HEMT bias circuit 1020 can have sufficiently small PSRRs from the power supply voltage VDD and the negative power supply voltage VNEG to the drain voltage VD and the gate voltage VG. Thus, it is possible to attain very high noise canceling efficiency in the HEMT bias circuit 1020.

(LNA and LNB)

The HEMT bias circuit 1020 is applicable to LNAs and LNBs, as in the HEMT bias circuit 1010 described in the above embodiment. Further, by configuring an LNA with the HEMT 1 and the HEMT bias circuit 1020 such that the switches SWg and SWd are switched over according to the polarized wave selecting signal, the selecting of the polarized wave to receive can be easily performed. The control signal generating circuit generates the reversing control signal /SG and the reversing control signal /SD from the polarized wave selecting signal.

(Control Signal Generating Circuit)

Next, one example of the control signal generating circuit is explained below.

Fig. 37 is a circuit diagram illustrating one exemplary configuration of a control signal generating circuit 1050a. As illustrated in Fig. 37, the control signal generating circuit 1050a includes NOT gates 1051, 1052, and 1057, a capacitor 1053, and an NAND gate 1056. That is, the control signal generating circuit 1050a is identical with the control signal generating circuit 1050 of Fig. 34 except that the NOR gate 1054 and the NOT gate 1055 are omitted from the configuration of the control signal generating circuit 1050.

An input section of the NOT gate 1051 is connected with an input section 1058. An output section of the NOT gate 1051 is connected with an input section of the NOT gate 1052 and with an output section 1060. An output section of the NOT gate 1052 is connected with a first input section of the NAND gate 1056. A second input section of the NAND gate 1056 is connected with an input section 1058. An output section of the NAND gate 1056 is connected with an input section of the NOT gate 1057 and with the output section 1062. An output section of the NOT gate 1057 is connected with the output section 1061. The output section 1059 is connected with the input section 1058.

Moreover, the output section 1060 for outputting the reversing control signal /SG is connected the switch SWg of the HEMT bias circuit 1020. The output section 1062 for outputting the reversing control signal /SD is connected with the switch SWd of the HEMT bias circuit 1020. The output section 1059 for outputting the control signal SG and the output section 1061 for outputting the control signal SD are not connected with the HEMT bias circuit 1020.

The control signal generating circuit 1050a is configured such that the control signal SG and the control signal SD become high and the reversing control signal /SG and the reversing control signal /SD become low when the polarized wave selecting signal is high. On the other hand, when the polarized wave selecting signal is low, the control signal SG and the control signal SD become low and the reversing control signal /SG and the reversing control signal /SD become high. This makes it possible to turn the LNA on and off according to whether the polarized wave selecting signal is high or low.

However, the control signal generating circuit 1050a is configured such that a delay element 1063 is constituted by the NOT gates 1051 and 1052 and the capacitor 1053. With this configuration, level changes in the control signal SD and the reversing control signal /SD occur not simultaneously with level changes in the control signal SG and the reversing control signal /SG (that is, a delay occurs between the level changes).

The HEMT bias circuit 1020 requires the reversing control signals /SG and the reversing control signal /SD, but does not require the control signal SG and the control signal SD. Therefore, the output sections 1059 and 1061 may not be provided in the control signal generating circuit 1050a. However, the control signal generating circuit 1050a herein configured to be applicable to the HEMT bias circuit 1010. If the control signal generating circuit 1050a is employed in the HEMT bias circuit 1010, the output sections 1059 and 1061 are necessary.

(Switching Timing for Turning On and Off)

Next, switching timing for switching whether to apply a bias on the LNA provided with the HEMT 1 and the HEMT bias circuit 1020.

Fig. 38 is a timing chart illustrating signal waves in the LNA when the switching as to whether to apply the bias is carried out.

<Time t1>

When the polarized-wave selecting signal changes from low to high, the control signal SG becomes high. Moreover, the second input section of the NAND gate 1056 becomes high while the first input section of the NAND gate 1056 is still low due to the delay element 1063. Consequently, the output section of the NAND gate 1056 is kept high. By this, the control signal SG becomes high while the control signal SD is low.

<Time t2>

When a certain time period (period A) has passed from the change of the polarized selecting signal from low to high, the first input section of the NAND gate 1056 changes to high. As a result, the output section of the NAND gate 1056 changes to low. By this, the control signal SG and the control signal SD both become high.

<Time t3>

When the polarized wave selecting signal changes from high to low, the control signal SG changes to low. Moreover, the second input section of the NAND gate 1056 changes to low while the first input section of the NAND gate 1056 is still high due to the delay element 1063. As a result, the output section of the NAND gate 1056 changes to high. By this, the control signal SG and the control signal SD both become low.

<Time t4>

When a certain time period (period B) has passed from the change of the polarized selecting signal from high to low, the first input section of the NAND gate 1056 changes to low. As a result, the output section of the NAND gate 1056 is kept high. By this, the control signal SG and the control signal SD both are kept low.

As described above, the period A is provided in which, when the polarized wave selecting signal is changed from low to high in order to turn on the LNA that has been off, the reversing control signal /SG becomes low and the reversing control signal /SD becomes high, whereby the gate voltage VG is applied to the HEMT 1 while the drain voltage VD is still zero. Because of the period A, carriers present in a channel of the HEMT 1 are decreased thereby making it difficult for shoot-through electrode.

Therefore, by setting the period A to be sufficiently long or long enough to allow the HEMT 1 to reach a pinch-off, the reversing control signal /SD becomes low after the period A, whereby excess drain current ID is prevented from flowing even if the drain voltage VD is applied to the HEMT 1.

On the other hand, when the polarized wave selecting signal changes from high to low in order to switch over the LNA from on to off, the reversing control signal /SG becomes high and the reversing control signal /SD becomes high in association with the change. At this time, the drain voltage VD of the HEMT 1 is accumulated in the capacitor CD as electric charge. Therefore, the change in the capacitor CD is discharged to the GND level by flowing through the resistor RI, R2, R1, and RR in this order.

Moreover, the gate voltage of the HEMT 1 is accumulated in the capacitor CG as an electric charge. Therefore, at that moment the LNA is turned off, the negative voltage in the capacitor CG is charged via the switch SWg and the resistor RGG to the GND level.

Time tD necessary for discharging the drain voltage and time tG necessary for charging the gate voltage are expressing by the following formulae (58) and (59):

[Math. 28]

$$t_D = C_D\left(R_I + R_1 + R_2 + R_R\right)\ldots(58)$$

$$t_G = C_G\left(R_{ON} + R_{GG}\right)\ldots(59)$$

Where each values in the formulae are as follows:

$R_{ON}$: On resistance of switch SWg
$R_{GG}$: Resistance of resistor RGG
$C_D$: Capacitance of capacitor CD
$C_G$: Capacitance of capacitor CG

The LNA provided with the HEMT 1 and the HEMT bias circuit 1020 is configured such that the values are set to satisfy "tD < tG". By this, the drain voltage VD reaches the GND level before the gate voltage VG does, thereby making it possible to have the period B in which the gate voltage VG is still applied. In the period B, the gate voltage VG remains in the negative power supply voltage, thereby making it possible to prevent an excess drain current ID from flowing.

In the present embodiment, the period A can be set by the configuration of the delay element 1063, and the period B is determined by the time tG predetermined.

As described above, the HEMT bias circuit 1020 is configured such that, in order to switch over to supplying the bias to the HEMT 1 from not biasing the HEMT 1, the switch SWg is switched over to disconnect the gate terminal of the HEMT 1 from the ground, and then the switch SWd is switched over to disconnect the gate terminal of the PMOS transistor 1022 from the source terminal of the PMOS transistor 1022, and that, in order to switch over to not supplying the bias to the HEMT 1 from biasing the HEMT 1, the switch SWd is switched over to connect the gate terminal of the PMOS transistor 1022 with the source terminal of the PMOS transistor 1022, and the switch SWg is switched over to connect the gate terminal of the HEMT 1 with the ground.

By this, the gate terminal of the HEMT 1 is biased to the negative voltage condition before the drain voltage is applied to the drain terminal of the HEMT 1, in order to switch over to not supplying the bias to the HEMT 1 from biasing the HEMT 1. That is, the voltage application to the gate terminal of the HEMT 1 proceeds the voltage application to the drain terminal of the HEMT 1. Therefore, in a period between starting of the voltage application to the gate terminal of the HEMT 1 and starting of the voltage application to the drain terminal of the HEMT 1, carriers present in a channel of the HEMT 1 decreases, thereby making it difficult for shoot-through electrode.

On the other hand, the HEMT bias circuit 1020 is provided with the capacitor CD and the capacitor CG. With this configuration, the switching over from supplying to the bias to the HEMT 1 to not biasing the HEMT 1 can be performed in such a way that the time necessary for discharging the drain voltage of the HEMT 1 and the time necessary for charging the gate voltage of the HEMT 1 are controlled.

Therefore, by setting the charging time for the gate voltage to be longer than the discharging time for the drain voltage, the switching over from biasing the HEMT 1 to not biasng the HEMT 1 can be such that, even if the switches SWg and SWd are switched over at once, the gate voltage of the HEMT 1 becomes zero after the drain voltage of the HEMT 1 becomes zero. This makes it possible to prevent an excess drain current from flowing.

Therefore, like the HEMT bias circuit 1010, the HEMT bias circuit 1020 makes it possible to perform, without the risk of an excess shoot-through current, the switching over to not biasing the HEMT 1 from biasing the HEMT 1, and the switching over to biasing the HEMT 1 from not biasing the HEMT 1.

The control signal generating circuit used in the HEMT bias circuit 1020 is not limited to the control signal generating circuit 1050a, and may be the control signal generating circuit 1050. In case where the control signal generating circuit 1050 is employed, the HEMT bias circuit 1020 can perform the switching over from biasing the HEMT 1 to not biasing the HEMT 1, in such a way that the switch SWd is switched over to connect the gate terminal of the PMOS transistor 1022 to the source terminal of the PMOS transistor 1022, and then the switch SWg is switched over to ground the gate terminal of the HEMT 1.

Moreover, in the case where the control signal generating circuit 1050 is employed, the HEMT bias circuit 1020 may not be provided with the capacitor CD and the capacitor CG.

With either configuration, it possible to perform, without the risk of an excess shoot-through current, the switching over to not biasing the HEMT 1 from biasing the HEMT 1, and the switching over to biasing the HEMT 1 from not biasing the HEMT 1.

As described above, in the HEMT bias circuit 1020, the switching over from biasing the HEMT 1 to not biasing the HEMT 1 in such a way that the switch SWg and the switch SWd are switched over concurrently or with time lag. This can give a greater degree of freedom to the switching control.

Moreover, the control signal generating circuits 1050 and 1050a are merely examples and the present invention is not limited to them. Any control signal generating circuit can be employed in the present invention, provided that it can generate a control signal SD, a reversing control signal /SD, a control signal SG, and a reversing control signal /SG, whose levels are changed as illustrated in Fig. 35 or 38.

In some cases, the integration of the HEMT bias circuit 1020 faces a problem regarding how much voltage the NMOS transistor 1021 can withstand. This is because a voltage between VDD and VG is applied on the NMOS transistor 1021 constantly while the switch Sg is turned off. The gate voltage VG is a negative voltage and thus a potential between the VDD to VG is higher than a potential between the VDD and GND. Therefore, reliability problem would occur if the HEMT bias circuit 1020 is integrated by a production process that can ensure only the potential between VDD-GND.

Moreover, there is a risk that NMOS transistor 1021 may receive a voltage between VDD to VNEG temporally at initial activation of the circuit, or at switching the circuit operation. In this case, the reliability problem of the element rises due to the negative voltage of the negative power supply voltage VNEG. Thus, it is desirable to solve those problems in the HEMT bias circuit.

To solve the problems, the HEMT bias circuit 1020 is provided with the resistor RGG between the source terminal of the NMOS transistor 1021 and the gate terminal of the HEMT 1. With the configuration having the resistor RGG, a voltage out of a tolerable voltage range of the NMOS transistor 1021 will not be applied on the NMOS transistor 1021 to drive it. Therefore, the HEMT bias circuit 1020 can attain- an-excellent reliability.

[Embodiment 21]

Fig. 39 is a circuit diagram illustrating one exemplary configuration of a HEMT bias circuit 1030 according to the present embodiment. As illustrated in Fig. 39, the HEMT bias circuit 1030 of the present embodiment has a configuration identical with that of the HEMT bias circuit 1020 of Embodiment 20 except that the resistor RGG is omitted in the present Embodiment.

The HEMT bias circuit 1030 is applicable to the LNA and LNB, like the HEMT bias circuit 1020 of the previous Embodiment. Further, by configuring an LNA provided with the HEMT 1 and the HEMT bias circuit 1030 in such a way that the switch SWg and the SWd are switched over according to the polarized-wave selecting signal, it becomes possible to easily select which one of the polarized waves the LNA receives. A control signal generating circuit generates the reversing control signal /SG and the reversing control signal /SD from the polarized-wave selecting signal.

The control signal generating circuit may be, for example, the control signal generating circuit 1050 illustrated in Fig. 34, or the control signal generating circuit 1050a illustrated in Fig. 37. In case either of the control signal generating circuit 1050 illustrated in Fig. 34, or the control signal generating circuit 1050a illustrated in Fig. 37 is used, the reversing control signal /SG outputted from the output section 1060 is supplied to the switch SWg and the reversing control signal /SG outputted from the output section 1062 is supplied to the switch SWd. The drain voltage and the gate voltage of the HEMT 1 changes according to the switching over as described above.

The HEMT bias circuit 1030 can bring about an effect similar to those of the HEMT bias circuits 1010 and 1020, as described above. Moreover, if it is not especially necessary to take the voltage tolerance of the NMOS transistor 1021 into consideration, it is possible to ensure the driving even by using the HEMT bias circuit 1030. With the configuration of the HEMT bias circuit 1030, it is possible to reduce a circuit area.

Finally it should be noted that the HEMT bias circuits are not limited to the HEMT and are also applicable to transistors other than the HEMT, even though Embodiments and examples 19 to 21 described above. For example, the HEMT bias circuits may used as a bias circuit for the general transistors such as JFET, MOSFET, bipolar transistors, etc. Needless to say, the HEMT bias circuits are more effective in case where they are used for HEMT. However, the HEMT bias circuits can be very similarly effective in case they are used for the other types of transistors.

Moreover, a negative logic may be employed in the present invention, while the HEMT bias circuits of the embodiments use positive logics. Further, the embodiments may be modified as below.

The HEMT bias circuits 1020 and 1030 described above are provided with the NMOS transistor 1021 and the PMOS transistor 1022. However, the present invention is not limited to this. For example, a PMOS transistor may be provided instead of the NMOS transistor 1021. An NMOS transistor may be provided instead of the PMOS transistor 1022. Furthermore, a PNP bipolar transistor, an NPN bipolar transistor, or the like may be employed instead of them.

In a case where the NMOS transistor 1021 is replaced with a PMOS transistor or a PNP bipolar transistor, the positive input terminal and the negative input terminal of the operational amplifier AMP 2 are exchanged (the positive input terminal of the operational amplifier AMP 2 is connected with the resistor R1, and the negative input terminal of the operational amplifier AMP 2 is connected with the drain terminal of the HEMT 1). In a case where the PMOS transistor 1022 is replaced with an NMOS transistor or an NPN bipolar transistor, the positive input terminal and the negative input terminal of the operational amplifier AMP 3 are exchanged (the positive input terminal of the operational amplifier AMP 3 is connected with the reference voltage source VREF, and the negative input terminal of the operational amplifier AMP 3 is connected with the resistor R1).

Moreover, the HEMT bias circuits 1020 and 1030 may be configured such that the resistor RR is replaced with a constant current source. In this case, the drain current ID satisfies $I_D = (R_2/R_1) IB$, thereby being in proportional with the resistances. This makes it possible to reduce current unevenness.

The present invention is not limited to the description of the embodiments above, but may be altered by a skilled person within the scope of the claims. An embodiment based on a proper combination of technical means disclosed in different embodiments is encompassed in the technical scope of the present invention.

A bias circuit is configured as a bias circuit comprising an amplification FET whose source terminal is grounded, comprising: a dual supply differential amplifier; a first resistor; a first reference voltage source; and a second reference voltage source, the differential amplifier having a positive input terminal, a negative input terminal, and an output terminal, the positive input terminal being connected with a drain terminal of the amplification FET, the negative input terminal being connecting with the second reference voltage source, and the output terminal being connected with a gate terminal of the amplification FET, and the first resistor having a terminal being connected with the drain terminal of the amplification FET, and another terminal being connected with the first reference voltage source.

Moreover, the bias circuit is preferably configured such that the amplification FET is an HEMT.

A bias circuit is configured as a bias circuit comprising an amplification FET whose source terminal is grounded, comprising: a single supply differential amplifier; a first reference voltage source; a second reference voltage source; a first transistor; a first resistor; a second resistor; and a negative power supply voltage source, the first transistor having a first conduction terminal, a second conduction terminal, and a control terminal, the differential amplifier having a first input terminal, a second input terminal, and an output terminal, the first input terminal being connected with the second reference voltage source, the second input terminal being connected with a drain terminal of the amplification FET, and the output terminal being connected with the control terminal of the first transistor, the first transistor being configured such that the first conduction terminal is connected with a power supply voltage and the second conduction terminal is connected with a gate terminal of the amplification FET, the first resistor having a terminal being connected with the drain terminal of the amplification FET, and another terminal being connected with the first reference voltage source, and the second resistor having a terminal being connected with the gate terminal of the amplification FET, and another terminal being connected with the negative power supply voltage source.

Moreover, the bias circuit is preferably configured such that the amplification FET is an HEMT.

Moreover, the bias circuit is preferably configured such that the first transistor is a P-channel MOSFET; the first conduction terminal, the second conduction terminal, and the control terminal of the first transistor are a source terminal, a drain terminal, and a gate terminal of the P-channel MOSFET, respectively; and the first input terminal and the second input terminal of the differential amplifier are a positive input terminal and a negative input terminal, respectively.

Moreover, the bias circuit is preferably configured such that the first transistor is a PNP bipolar transistor; the first conduction terminal, the second conduction terminal, and the control terminal of the first transistor are an emitter terminal, a collector terminal, and a base terminal of the PNP bipolar transistor, respectively; and the first input terminal and the second input terminal of the differential amplifier are a positive input terminal and a negative input terminal, respectively.

Moreover, the bias circuit is preferably configured such that the first transistor is an N-channel MOSFET; the first conduction terminal, the second conduction terminal, and the control terminal of the first transistor are a drain terminal, a source terminal, and a gate terminal of the N-channel MOSFET, respectively; and the first input terminal and the second input terminal of the differential amplifier are a negative input terminal and a positive input terminal, respectively.

Moreover, the bias circuit is preferably configured such that the first transistor is a NPN bipolar transistor; the first conduction terminal, the second conduction terminal, and the control' terminal of the first transistor are a collector terminal, an emitter terminal, and a base terminal of the NPN bipolar transistor, respectively; and the first input terminal and the second input terminal of the differential amplifier are a negative input terminal and a positive input terminal, respectively.

A bias circuit is configured as a bias circuit comprising an amplification FET whose source terminal is grounded, comprising: a first single supply differential amplifier; a second single supply differential amplifier; a first transistor; a second transistor; a first resistor; a second resistor; a third resistor; a fourth resistor; a fifth resistor; a reference voltage source; and a negative power supply voltage source, the first transistor having a first conduction terminal, a second conduction terminal, and a control terminal, the second transistor having a first conduction terminal, a second conduction terminal, and a control terminal, the first differential amplifier having a first input terminal, a second input terminal, and an output terminal, the first input terminal being connected with the second conduction terminal of the second transistor via the fifth resistor, the second input terminal being connected with a drain terminal of the amplification FET, and the output terminal being connected with the control terminal of the first transistor; the second differential amplifier having a first input terminal, a second input t terminal, and an output terminal, the first input terminal being connected with the second conduction terminal of the second transistor via the fourth resistor and the fifth resistor, the second input terminal being connected with the reference voltage source, and the output terminal being connected with the control terminal of the second transistor, the first transistor being configured such that the first conduction terminal is connected with a power supply voltage and the second conduction terminal is connected with a gate terminal of the amplification FET, the second transistor being configured such that the first conduction terminal is connected with a power supply voltage and the second conduction terminal is connected with ground via the fifth resistor, the fourth resistor, and the third resistor in this order, the first resistor having a terminal being connected with the drain terminal, and another terminal being connected with the second conduction terminal of the second transistor, and the second resistor having a terminal being connected with the gate terminal of the amplification FET, and another terminal being connected with the negative power supply voltage source.

Moreover, the bias circuit is preferably configured such that 1, wherein the amplification FET is an HEMT.

Moreover, the bias circuit is preferably configured such that the first transistor and the second transistor are P-channel MOSFETs; the first conduction terminal, the second conduction terminal, and the control terminal of each of the first transistor and the second transistor are a source terminal, a drain terminal, and a gate terminal of the P-channel MOSFETs, respectively; the first input terminal and the second input terminal of the first differential amplifier are a positive input terminal and a negative input terminal, respectively; and the input terminal and the second input terminal of the second differential amplifier are a positive input terminal and a negative input terminal, respectively.

Moreover, the bias circuit is preferably configured such that the first transistor and the second transistor are PNP bipolar transistors; the first conduction terminal, the second conduction terminal, and the control terminal of each of the first transistor and the second transistor are an emitter terminal, a collector terminal, and a base terminal of the PNP bipolar transistors, respectively; the first input terminal and the second input terminal of the first differential amplifier are a positive input terminal and a negative input terminal, respectively, and the first input terminal and the second input terminal of the second differential amplifier are a positive input terminal and a negative input terminal, respectively.

Moreover, the bias circuit is preferably configured such that the first transistor and the second transistor are N-channel MOSFETs; the first conduction terminal, the second conduction terminal, and the control terminal of each of the first transistor and the second transistor are a drain terminal, a source terminal, and a gate terminal of the N-channel MOSFETs, respectively; the first input terminal and the second input terminal of the first differential amplifier are a negative input terminal and a positive input terminal, respectively; and the first input terminal and the second input terminal of the second differential amplifier are a negative input terminal and a positive input terminal, respectively.

Moreover, the bias circuit is preferably configured such that the first transistor and the second transistor are NPN bipolar transistors; the first conduction terminal, the second conduction terminal, and the control terminal of each of the first transistor and the second transistor are a collector terminal, an emitter terminal, and a base terminal of the NPN bipolar transistors, respectively; the first input terminal and the second input terminal of the first differential amplifier are a negative input terminal and a positive input terminal, respectively; and the first input terminal and the second input terminal of the second differential amplifier are a negative input terminal and a positive input terminal, respectively.

The bias circuit is preferably configured to comprise a constant current source in replacement of the third resistor.

Moreover, the bias circuit is preferably configured such that the fourth resistor is omitted.

The bias circuit is preferably configured to comprise a constant current source in replacement of the third resistor, wherein the fourth resistor is omitted.

The bias circuit is preferably configured to comprise a protection element for protecting against voltage; the protection element being provided between the second conduction terminal of the first transistor and the gate terminal of the amplification FET.

Moreover, the bias circuit is preferably configured such that the reference voltage source is a bandgap reference circuit for outputting a bandgap voltage.

Moreover, the bias circuit is preferably configured such that the first differential amplifier, the second differential amplifier, the first transistor, the second transistor, the first resistor, the second resistor, the third resistor, the fourth resistor, the fifth resistor are integrated in an integrated circuit.

Moreover, the bias circuit is preferably configured such that one or both of the reference voltage source and the negative power supply voltage source are integrated in the integrated circuit.

A bias switching circuit is configured as a bias circuit for biasing an amplification FET which is for amplifying an input signal and whose source terminal is grounded, a dual supply differential amplifier; a first resistor; a first switch; a second switch; a first reference voltage source; a second reference voltage source; and a negative power supply voltage source, the differential amplifier having a positive input terminal, a negative input terminal, an output terminal, and a negative power supply terminal, the positive input terminal being connected with a drain terminal of the amplification FET, the negative input terminal being connected with the second reference voltage source, the output terminal being connected with a gate terminal of the amplification terminal, and the negative power source terminal being connectable with the negative power supply voltage source or with ground according to switching-over of the first switch, and the first resistor having a first terminal and a second terminal, the first terminal being connected - with the drain terminal of the amplification FET, and the second terminal being connectable with the first reference voltage source or with ground according to switching-over of the second switch.

It is desirable that the bias circuit is configured such that switching-over of the bias circuit from not biasing to biasing is carried out by switching over the first switch so as to connect the negative power supply terminal of the differential amplifier with the negative power supply voltage source instead of the ground, and then switching over the second switch so as to connect the second terminal of the first resistor with the first reference voltage source instead of the ground, and switching-over of the bias circuit from biasing to not biasing is carried out by switching over the second switch so as to connect the second terminal of the first resistor with the ground instead of the first reference voltage source, and then switching over the first switch so as to connect the negative power supply terminal of the differential amplifier with the ground instead of the negative power supply voltage source.

Moreover, the bias circuit is desirably configured such that the amplification FET is an HEMT.

A bias switching circuit is configured as a bias circuit for biasing an amplification FET which is for amplifying an input signal and whose source terminal is grounded, comprising: a first single supply differential amplifier; a second single supply differential amplifier; a first transistor; a second transistor; a first resistor; a second resistor; a third resistor; a fourth resistor; a fifth resistor; a first switch; a second switch; a reference voltage source; and a negative power supply voltage source, the first transistor having a first conduction terminal, a second conduction terminal, and a control terminal, the second transistor having a first conduction terminal, a second conduction terminal, and a control terminal, the first differential amplifier having a first input terminal, a second input terminal, and an output terminal, the first input terminal being connected with the second conduction terminal of the second transistor via the fifth resistor, the second input terminal being connected with a drain terminal of the amplification FET, and the output terminal being connected with the control terminal of the first transistor, the second differential amplifier having a first input terminal, a second input terminal, and an output terminal, the first input terminal being connected with the second conduction terminal of the second transistor via the fourth resistor and the fifth resistor in this order, the second input terminal being connected with the reference voltage source, and the output terminal being connected with the control terminal of the second transistor, the first transistor being configured such that the first conduction terminal is connected with a power supply voltage, and the second conduction terminal is connected with a gate terminal of the amplification FET, the second transistor being configured such that the first conduction terminal is connected with the power supply voltage, and the second conduction terminal is connected with ground via the fifth resistor, the fourth resistor, and the third resistor in this order, the first resistor having a first terminal and a second terminal, the first terminal being connected with the drain terminal of the amplification FET and the second terminal being connected with the second conduction terminal of the second transistor, the second resistor having a third terminal and a fourth terminal, the third terminal being connected with the gate terminal of the amplification FET, and the fourth terminal being connected with the negative power supply voltage source, the first switch being connectable with the gate terminal of the amplification FET, the first switch switching over to connect or disconnect the gate terminal of the amplification FET with ground, and the second switch being connectable with the control terminal of the second transistor, the second switch switching over to connect or disconnect the control terminal of the second transistor with the first conduction terminal of the second transistor.

Moreover, the bias circuit is desirably configured such that switching-over of the bias circuit from not biasing to biasing is carried out by switching over the first switch so as to disconnect the gate terminal of the amplification FET with the ground, and then switching over the second switch so as to disconnect the control terminal of the second transistor with the first conduction terminal of the second transistor, and switching-over of the bias circuit from biasing to not biasing is carried out by switching over the second switch so as to connect the control terminal of the second transistor with the first conduction terminal of the second transistor, and then switching over the first switch so as to connect the gate terminal of the amplification FET with the ground.

Moreover, the bias circuit is preferably configured to further comprise a first capacitor and a second capacitor, the first capacitor having a fifth terminal and a sixth terminal, the fifth terminal being connected with the drain terminal of the amplification FET, and the sixth terminal being grounded, and the second capacitor having a seventh terminal and an eighth terminal, the seventh terminal being connected with the gate terminal of the amplification FET, and the eighth terminal being connected with the source terminal of the amplification FET.

With this configuration, in which the first capacitor and the second capacitor are provided, a discharging time necessary for discharging the drain voltage of the amplification FET and a charging time necessary for charging the gate voltage of the amplification FET can be controlled in switching over from biasing to not biasing.

Therefore, by setting the charging time of the gate voltage to be longer than the discharging time of the drain voltage, the switching-over from biasing to not biasing can be performed such that, even if the first switch and the second switch are concurrently switched over, the voltage at the gate terminal of the amplification FET is faded out after the voltage at the drain terminal of the amplification FET is faded out.

Moreover, the bias circuit is desirably configured such that switching-over of the bias circuit from not biasing to biasing is carried out by switching over the first switch so as to disconnect the gate terminal of the amplification FET with the ground, and then switching over the second switch so as to disconnect the control terminal of the second transistor with the first conduction terminal of the second transistor, and switching-over of the bias circuit from biasing to not biasing is carried out by switching over the second switch so as to connect the control terminal of the second transistor with the first conduction terminal of the second transistor, and then or concurrently switching over the first switch so as to connect the gate terminal of the amplification FET with the ground.

Moreover, the bias circuit is desirably configured such that the amplification FET is an HEMT.

Moreover, the bias circuit is desirably configured such that the first transistor is an N-channel MOSFET; the first conduction terminal, the second conduction terminal, and the control terminal of the first transistor are a drain terminal, a source terminal, and a gate terminal of the N-channel MOSFET, respectively; the second transistor is a P-channel MOSFET; the first conduction terminal, the second conduction terminal, and the control terminal of the second transistor are a source terminal, a drain terminal, and a gate terminal of the P-channel MOSFET, respectively; the first input terminal and the second input terminal of the first differential amplifier are a negative input terminal and a positive input terminal, respectively; and the first input terminal and the second input terminal of the second differential amplifier are a positive input terminal and a negative input terminal, respectively.

Moreover, the bias circuit is preferably configured to further comprise: a sixth resistor, the sixth resistor being provided in a route electrically connecting the second conduction terminal of the first transistor and the gate terminal of the amplification FET with each other.

According to the above configuration, a voltage out of a tolerable voltage range of the first transistor will not be applied on the first transistor to drive it. Thus, the bias circuit can attain excellent reliability.

An LNB is configured as an LNB for receiving a signal via an antenna, amplifying and down-converting the signal, and transmitting the amplified and down-converted signal to a later stage following the LNB, comprising: a first polarized wave antenna for receiving a first polarized wave and converting the first polarized wave into a first polarized wave signal; a second polarized wave antenna for receiving a second polarized wave and converting the second polarized wave into a second polarized wave signal; a first polarized wave amplifier for amplifying the first polarized wave signal; a second polarized wave amplifier for amplifying the second polarized wave signal; and a polarized wave selector for selecting which one of the first polarized wave and the second polarized wave the LNB receives, the first polarized wave and the second polarized wave are a horizontally-polarized wave and a vertically-polarized wave, respectively, or a left-handed circularly polarized wave and a right-handed circularly polarized wave, respectively, the first polarized wave amplifier and the second polarized wave amplifier being LNAs according to the present invention, the first polarized wave amplifier and the second polarized wave amplifier switching over the first switch and the second switch according to a polarized wave selecting signal indicating which one of the first polarized wave and the second polarized wave the LNB receives, the polarized wave selecting signal being outputted from the polarized wave selector.

It is preferable that the LNB is partially integrated.

With this configuration, a mounting area and mounting cost of components can be reduced, thereby allowing the LNB to be smaller and lower in cost.

Industrial Applicability

The present invention is suitable applicable to bias circuits, LNAs, LNBs, receivers for communication, transmitters for communication, and sensor systems.

Reference Signs List

1: HEMT (Amplification FET)
11, 12, 15, 16, 18 to 20: HEMT bias circuit (bias circuit)
50, 60, 80: LNA
51, 71, 82: HEMT bias circuit (bias circuit)
52: Active element (first transistor)
53: Active element (second transistor)
54, 81: Integrated circuit
61: Protection element
70, 118: Bandgap reference circuit
83: Reference voltage generating circuit
84, 117: Negative voltage generating circuit
100: LNB
101: Feedhorn (antenna)
104: Horizontally-polarized wave LNA (LNA)
105: Vertically-polarized wave LNA (LNA)
106: 2nd LNA (LNA)
114: LNA-H HEMT bias circuit (bias circuit)

115: LNA-V HEMT bias circuit (bias circuit)

116: 2nd LNA HEMT bias circuit (bias circuit)

121: Coaxial cable

122: TV set

123: Video set

150: Communication system

151: Transmitter (transmitter for communication)

152: Receiver (receiver for communication)

153: Communication channel

154: Transmission device

155, 159: LNA

156, 160: HEMT bias circuit (bias circuit)

157, 161: Signal processing circuit

158: Receiver device

170: Sensor system

171: Sensing device

172: LNA

173: HEMT bias circuit (bias circuit)

174: Signal processing circuit

500: HEMT bias circuit

520: Negative voltage generating circuit

VD: Drain voltage

ID: Drain current

AMP 1: Operational amplifier (dual supply differential amplifier)

AMP 2: Operational amplifier (single supply differential amplifier, first differential amplifier)

AMP 3: Operational Amplifier (second differential amplifier)

PMOS 1: P-channel MOSFET (first transistor)

PMOS 2: P-channel MOSFET (second transistor)

NMOS 1: N-channel MOSFET (first transistor)

NMOS 2: N-channel MOSFET (second transistor)

RI: Resistor (first resistor)

RG: Resistor (second resistor)

RR: Resistor (third resistor)

R1: Resistor (fourth resistor)

R2: Resistor (fifth resistor)

IB: Constant current source

VDD: Power supply voltage

VX: First reference voltage source

VY: Second reference voltage source

VREF: Reference voltage source

VNEG: Negative power supply source

1010, 1020, 1030: HEMT bias circuit (bias circuit)

1021: NMOS transistor (first transistor)

1022: PMOS transistor (second transistor)

1050, 1050a: Control signal generating circuit

1100: LNB

1102: Horizontally-polarized wave antenna (first polarized wave antenna)

1103: Vertically polarized wave antenna (second polarized wave antenna)

1104: Horizontally-polarized wave LNA (first polarized wave amplifier)

1105: Vertically-polarized wave LNA (second polarized wave amplifier)

1113: Polarized wave selector

1116: Coaxial cable

1117: TV set

1118: Video set

RGG: Resistor element (sixth resistor)

SWg: Switch (first switch)

SWd: Switch (second switch)

CD: Capacitor (first capacitor)

CG: Capacitor (second capacitor)
VREF: Reference voltage source (first reference voltage source)
VDRAIN: Reference voltage source (second reference voltage source)

**Claims**

1. A bias circuit (16, 20) comprising an amplification FET (1) whose source terminal is grounded, comprising:

    a first single supply differential amplifier (AMP2);
    a second single supply differential amplifier (AMP3) ;
    a first transistor (PMOS1, NMOS1);
    a second transistor (PMOS2, NMOS2);
    a first resistor (RI);
    a second resistor (RG);
    a third resistor (RR);
    a fourth resistor (R1);
    a fifth resistor (R2);
    a reference voltage source (VREF); and
    a negative power supply voltage source (VNEG),
    the first transistor (PMOS1, NMOS1) having a first conduction terminal, a second conduction terminal, and a control terminal,
    the second transistor (PMOS2, NMOS2) having a first conduction terminal, a second conduction terminal, and a control terminal,
    the first differential amplifier (AMP2) having a first input terminal, a second input terminal, and an output terminal, the first input terminal being connected with the second conduction terminal of the second transistor (PMOS2, NMOS2) via the fifth resistor (R2), the second input terminal being connected with a drain terminal of the amplification FET (1), and the output terminal being connected with the control terminal of the first transistor (PMOS1, NMOS1);
    the second differential amplifier (AMP3) having a first input terminal, a second input terminal, and an output terminal, the first input terminal being connected with the second conduction terminal of the second transistor via the fourth resistor (R1) and the fifth resistor (R2), the second input terminal being connected with the reference voltage source (VREF), and the output terminal being connected with the control terminal of the second transistor (PMOS2, NMOS2),
    the first transistor (PMOS1, NMOS1) being configured such that the first conduction terminal is connected with a power supply voltage (VDD) and the second conduction terminal is connected with a gate terminal of the amplification FET (1),
    the second transistor (PMOS2, NMOS2) being configured such that the first conduction terminal is connected with a power supply voltage (VDD) and the second conduction terminal is connected with ground via the fifth resistor (R2), the fourth resistor (R1), and the third resistor (RR) in this order,
    the first resistor (RI) having a terminal being connected with the drain terminal, and another terminal being connected with the second conduction terminal of the second transistor (PMOS2, NMOS2),
    the second resistor (RG) having a terminal being connected with the gate terminal of the amplification FET (1), and another terminal being connected with the negative power supply voltage source (VNEG),
    said bias circuit (16, 20) comprising
    a first negative feedback loop including the second differential amplifier (AMP3) and a second negative feedback loop including the first differential amplifier (AMP2), and
    the second transistor (PMOS2, NMOS2), the fifth resistor (R2), and the fourth resistor (R1) are part of the first negative feedback loop, and the first transistor (PMOS1, NMOS1) and the amplification FET (1) are part of the second negative feedback loop.

2. The bias circuit (16, 20) as set forth in claim 1, wherein the amplification FET is an HEMT (1).

3. The bias circuit (16) as set forth in claim 1, wherein:
    the first transistor and the second transistor are P-channel MOSFETs (PMOS1, PMOS2);
    the first conduction terminal, the second conduction terminal, and the control terminal of each of the first transistor and the second transistor are a source terminal, a drain terminal, and a gate terminal of the P-channel MOSFETs (PMOS1, PMOS2), respectively;

the first input terminal and the second input terminal of the first differential amplifier are a positive input terminal and a negative input terminal, respectively; and
the first input terminal and the second input terminal of the second differential amplifier (AMP3) are a positive input terminal and a negative input terminal, respectively.

4.  The bias circuit as set forth in claim 1, wherein:

    the first transistor and the second transistor are PNP bipolar transistors;
    the first conduction terminal, the second conduction terminal, and the control terminal of each of the first transistor and the second transistor are an emitter terminal, a collector terminal, and a base terminal of the PNP bipolar transistors, respectively;
    the first input terminal and the second input terminal of the first differential amplifier (AMP2) are a positive input terminal and a negative input terminal, respectively, and
    the first input terminal and the second input terminal of the second differential amplifier (AMP3) are a positive input terminal and a negative input terminal, respectively.

5.  The bias circuit (20) as set forth in claim 1, wherein:

    the first transistor and the second transistor are N-channel MOSFETs (NMOS1, NMOS2);
    the first conduction terminal, the second conduction terminal, and the control terminal of each of the first transistor and the second transistor are a drain terminal, a source terminal, and a gate terminal of the N-channel MOSFETs (NMOS1, NMOS2), respectively;
    the first input terminal and the second input terminal of the first differential amplifier (AMP2) are a negative input terminal and a positive input terminal, respectively; and
    the first input terminal and the second input terminal of the second differential amplifier (AMP3) are a negative input terminal and a positive input terminal, respectively.

6.  The bias circuit as set forth in claim 1, wherein:

    the first transistor and the second transistor are NPN bipolar transistors;
    the first conduction terminal, the second conduction terminal, and the control terminal of each of the first transistor and the second transistor are a collector terminal, an emitter terminal, and a base terminal of the NPN bipolar transistors, respectively;
    the first input terminal and the second input terminal of the first differential amplifier are a negative input terminal and a positive input terminal, respectively; and
    the first input terminal and the second input terminal of the second differential amplifier are a negative input terminal and a positive input terminal, respectively.

7.  The bias circuit (16, 20) as set forth in claim 1, further comprising:

    a protection element for protecting against voltage;
    the protection element being provided between the second conduction terminal of the first transistor (PMOS1, NMOS1) and the gate terminal of the amplification FET (1).

8.  The bias circuit (16, 20) as set forth in claim 1, wherein the reference voltage source is a bandgap reference circuit for outputting a bandgap voltage.

9.  The bias circuit (16, 20) as set forth in claim 1, wherein the first differential amplifier (AMP2), the second differential amplifier (AMP3), the first transistor (PMOS1, NMOS1), the second transistor (PMOS2, NMOS2), the first resistor (RI), the second resistor (RG), the third resistor (RR), the fourth resistor (R1), the fifth resistor (R2) are integrated in an integrated circuit.

10. The bias circuit (16, 20) as set forth in claim 1, wherein one or both of the reference voltage source (VREF) and the negative power supply voltage source (VNEG) are integrated in the integrated circuit.

11. An LNA (50), comprising:

    the amplification FET (1) whose source terminal is grounded;

a bias circuit (51) as set forth in any one of claims 1 to 10,
the gate terminal of the amplification FET serving as an input terminal of the LNA (50) and the drain terminal of the amplification FET (1) serving as an output terminal of the LNA (50).

12. An LNB (100) for receiving a signal via an antenna (101), amplifying and down-converting the signal, and transmitting the amplified and down-converted signal to a later stage following the LNB, comprising:

at least one LNA (104, 105, 106) for performing the amplification of the signal,
the LNA (104, 105, 106) being an LNA (50) as set forth in claim 11.

13. A receiver (152) for communication, comprising:

a receiver device (158) for receiving a signal from a communication channel;
an LNA (159) for amplifying a signal outputted from the receiver device (158);
the LNA (159) being an LNA (50) as set forth in claim 11.

14. A transmitter (151) for communication, comprising:

an LNA (155) for amplifying a signal to transmit; and
a transmitter device (154) for transmitting to a communication channel the signal amplified by the LNA (155),
the LNA (155) being an LNA (50) as set forth in claim 11.

15. A sensor system (170), comprising:

a sensing device (171) for detecting a change in an object and generating a signal based on the detected change;
an LNA (172) for amplifying the signal outputted from the sensing device (171),
the LNA (172 being an LNA (50) as set forth in claim 11.

## Patentansprüche

1. Vorspannungsschaltung (16, 20) mit einem Verstärkungs-FET (1), dessen Sourceanschluss geerdet ist, umfassend:

einen ersten Differenzverstärker (AMP2) mit Einfacheinspeisung;
einen zweiten Differenzverstärker (AMP3) mit Einfacheinspeisung;
einen ersten Transistor (PMOS1, NMOS1);
einen zweiten Transistor (PMOS2, NMOS2);
einen ersten Widerstand (RI);
einen zweiten Widerstand (RG);
einen dritten Widerstand (RR);
einen vierten Widerstand (R1);
einen fünften Widerstand (R2);
eine Referenzspannungsquelle (VREF); und
eine Spannungsquelle (VNEG) einer negativen Stromversorgung,
wobei der erste Transistor (PMOS1, NMOS1) einen ersten Leitungsanschluss, einen zweiten Leitungsanschluss und einen Steuerungsanschluss aufweist,
wobei der zweite Transistor (PMOS2, NMOS2) einen ersten Leitungsanschluss, einen zweiten Leitungsanschluss und einen Steuerungsanschluss aufweist,
wobei der erste Differenzverstärker (AMP2) einen ersten Eingangsanschluss, einen zweiten Eingangsanschluss und einen Ausgangsanschluss aufweist, wobei der erste Eingangsanschluss über den fünften Widerstand (R2) mit dem zweiten Leitungsanschluss des zweiten Transistors (PMOS2, NMOS2) verbunden ist, der zweite Eingangsanschluss mit einem Drainanschluss des Verstärkungs-FET (1) verbunden ist und der Ausgangsanschluss mit dem Steuerungsanschluss des ersten Transistors (PMOS1, NMOS1) verbunden ist,
wobei der zweite Differenzverstärker (AMP3) einen ersten Eingangsanschluss, einen zweiten Eingangsanschluss und einen Ausgangsanschluss aufweist, wobei der erste Eingangsanschluss über den vierten Widerstand (R1) und den fünften Widerstand (R2) mit dem zweiten Leitungsanschluss des zweiten Transistors verbunden ist, der zweite Eingangsanschluss mit der Referenzspannungsquelle (VREF) verbunden ist und der Ausgangsanschluss mit dem Steuerungsanschluss des zweiten Transistors (PMOS2, NMOS2) verbunden ist,

wobei der erste Transistor (PMOS1, NMOS1) so konfiguriert ist, dass der erste Leitungsanschluss mit einer Stromversorgungsspannung (VDD) verbunden ist und der zweite Leitungsanschluss mit einem Gateanschluss des Verstärkungs-FET (1) verbunden ist,

wobei der zweite Transistor (PMOS2, NMOS2) so konfiguriert ist, dass der erste Leitungsanschluss mit der Stromversorgungsspannung (VDD) verbunden ist und der zweite Leitungsanschluss über den fünften Widerstand (R2), den vierten Widerstand (R1) und den dritten Widerstand (RR) in dieser Reihenfolge mit Masse verbunden ist,

wobei der erste Widerstand (RI) einen Anschluss aufweist, der mit dem Drainanschluss verbunden ist, und einen anderen Anschluss, der mit dem zweiten Leitungsanschluss des zweiten Transistors (PMOS2, NMOS2) verbunden ist,

wobei der zweite Widerstand (RG) einen Anschluss aufweist, der mit dem Gateanschluss des Verstärkungs-FET (1) verbunden ist, und einen anderen Anschluss, der mit der Spannungsquelle (VNEG) einer negativen Stromversorgung verbunden ist,

wobei die Vorspannungsschaltung (16, 20) eine erste negative Rückkopplungsschleife, die den zweiten Differenzverstärker (AMP3) enthält, und eine zweite negative Rückkopplungsschleife, die den ersten Differenzverstärker (AMP2) enthält, aufweist, und

der zweite Transistor (PMOS2, NMOS2), der fünfte Widerstand (R2), und der vierte Widerstand (R1) Teil der ersten negativen Rückkopplungsschleife sind und der erste Transistor (PMOS1, NMOS1) und der Verstärkungs-FET (1) Teil der zweiten negativen Rückkopplungsschleife sind.

2. Vorspannungsschaltung (16, 20) nach Anspruch 1, wobei der Verstärkungs-FET (1) ein HEMT (1) ist.

3. Vorspannungsschaltung (16) nach Anspruch 1, wobei:

der erste Transistor und der zweite Transistor p-Kanal-MOSFETs (PMOS1, PMOS2) sind;
der erste Leitungsanschluss, der zweite Leitungsanschluss und der Steuerungsanschluss von jedem des ersten Transistors und des zweiten Transistors ein Sourceanschluss, ein Drainschluss bzw. ein Gateanschluss der p-Kanal-MOSFETs (PMOS1, PMOS2) sind;
der erste Eingangsanschluss und der zweite Eingangsanschluss des ersten Differenzverstärkers ein positiver Eingangsanschluss bzw. ein negativer Eingangsanschluss sind; und
der erste Eingangsanschluss und der zweite Eingangsanschluss des zweiten Differenzverstärkers (AMP3) ein positiver Eingangsanschluss bzw. ein negativer Eingangsanschluss sind.

4. Vorspannungsschaltung nach Anspruch 1, wobei:

der erste Transistor und der zweite Transistor pnp-Bipolartransistoren sind;
der erste Leitungsanschluss, der zweite Leitungsanschluss und der Steuerungsanschluss von jedem des ersten Transistors und des zweiten Transistors ein Emitteranschluss, ein Kollektoranschluss bzw. ein Basisanschluss der pnp-Bipolartransistoren sind;
der erste Eingangsanschluss und der zweite Eingangsanschluss des ersten Differenzverstärkers (AMP2) ein positiver Eingangsanschluss bzw. ein negativer Eingangsanschluss sind, und
der erste Eingangsanschluss und der zweite Eingangsanschluss des zweiten Differenzverstärkers (AMP3) ein positiver Eingangsanschluss bzw. ein negativer Eingangsanschluss sind.

5. Vorspannungsschaltung (20) nach Anspruch 1, wobei
der erste Transistor und der zweite Transistor n-Kanal-MOSFETs (NMOS1, NMOS2) sind;
der erste Leitungsanschluss, der zweite Leitungsanschluss und der Steuerungsanschluss von jedem des ersten Transistors und des zweiten Transistors ein Drainanschluss, ein Sourceanschluss bzw. ein Gateanschluss der n-Kanal-MOSFETs (NMOS1, NMOS2) sind;
der erste Eingangsanschluss und der zweite Eingangsanschluss des ersten Differenzverstärkers (AMP2) ein negativer Eingangsanschluss bzw. ein positiver Eingangsanschluss sind; und
der erste Eingangsanschluss und der zweite Eingangsanschluss des zweiten Differenzverstärkers (AMP3) ein negativer Eingangsanschluss bzw. ein positiver Eingangsanschluss sind.

6. Vorspannungsschaltung nach Anspruch 1, wobei:

der erste Transistor und der zweite Transistor npn-Bipolartransistoren sind;
der erste Leitungsanschluss, der zweite Leitungsanschluss und der Steuerungsanschluss von jedem des ersten Transistors und des zweiten Transistors ein Kollektoranschluss, ein Emitteranschluss bzw. ein Basisanschluss der npn-Bipolartransistoren sind;

der erste Eingangsanschluss und der zweite Eingangsanschluss des ersten Differenzverstärkers ein negativer Eingangsanschluss bzw. ein positiver Eingangsanschluss sind, und

der erste Eingangsanschluss und der zweite Eingangsanschluss des zweiten Differenzverstärkers ein negativer Eingangsanschluss bzw. ein positiver Eingangsanschluss sind.

7. Vorspannungsschaltung (16, 20) nach Anspruch 1, ferner umfassend:

ein Schutzelement, um gegen Spannung zu schützen;
wobei das Schutzelement zwischen dem zweiten Leitungsanschluss des ersten Transistors (PMOS1, NMOS1) und dem Gateanschluss des Verstärkungs-FET (1) vorgesehen ist.

8. Vorspannungsschaltung (16, 20) nach Anspruch 1, wobei die Referenzspannungsquelle eine Bandlücken-Referenzschaltung zum Abgeben einer Bandlücken-Spannung ist.

9. Vorspannungsschaltung (16, 20) nach Anspruch 1, wobei der erste Differenzverstärker (AMP2), der zweite Differenzverstärker (AMP3), der erste Transistor (PMOS1, NMOS1), der zweite Transistor (PMOS2, NMOS2), der erste Widerstand (RI), der zweite Widerstand (RG), der dritte Widerstand (RR), der vierte Widerstand (R1), der fünfte Widerstand (R2) in einer integrierten Schaltung integriert sind.

10. Vorspannungsschaltung (16, 20) nach Anspruch 1, wobei eine oder beide der Referenzspannungsquelle (VREF) und der Spannungsquelle (VNEG) einer negative Stromversorgung in der integrierten Schaltung integriert sind.

11. LNA (50), umfassend:

den Verstärkungs-FET (1), dessen Sourceanschluss geerdet ist;
eine Vorspannungsschaltung (51) nach einem der Ansprüche 1 bis 10,
wobei der Gateanschluss des Verstärkungs-FET (1) als ein Eingangsanschluss des LNA (50) dient und der Drainanschluss des Verstärkungs-FET (1) als ein Ausgangsanschluss des LNA (50) dient.

12. LNB (100) zum Empfangen eines Signals über eine Antenne (101), Verstärken und Abwärtswandeln des Signals und Senden des verstärkten und abwärtsgewandelten Signals an eine spätere Stufe, die dem LNB folgt, umfassend:

zumindest einen LNA (104, 105, 106), um die Verstärkung des Signals durchzuführen,
wobei der LNA (104, 105, 106) ein LNA (50) nach Anspruch 11 ist.

13. Empfänger (152) für eine Kommunikation, umfassend:

eine Empfängervorrichtung (158), um ein Signal von einem Kommunikationskanal zu empfangen;
einen LNA (159), um ein von der Empfängervorrichtung (158) abgegebenes Signal zu verstärken;
wobei der LNA (159) ein LNA (50) nach Anspruch 11 ist.

14. Sender (151) für eine Kommunikation, umfassend:

einen LNA (155), um ein Signal zur Übertragung zu verstärken; und
eine Sendervorrichtung (154), um das durch den LNA (155) verstärkte Signal an einen Kommunikationskanal zu senden;
wobei der LNA (155) ein LNA (50) nach Anspruch 11 ist.

15. Sensorsystem (170), umfassend:

eine Erfassungsvorrichtung (171), um eine Änderung in einem Objekt zu detektieren und ein auf der detektierten Änderung basierendes Signal zu erzeugen;
einen LNA (172), um das von der Erfassungsvorrichtung (171) abgegebene Signal zu verstärken;
wobei der LNA (172) ein LNA (50) nach Anspruch 11 ist.

**Revendications**

1. Circuit de polarisation (16, 20) comprenant un FET d'amplification (1) dont la borne de source est mise à la terre, comprenant :

   un premier amplificateur différentiel d'alimentation unique (AMP2) ;
   un deuxième amplificateur différentiel d'alimentation unique (AMP3) ;
   un premier transistor (PMOS1, NMOS1) ;
   un deuxième transistor (PMOS2, NMOS2) ;
   une première résistance (RI) ;
   une deuxième résistance (RG) ;
   une troisième résistance (RR) ;
   une quatrième résistance (R1) ;
   une cinquième résistance (R2) ;
   une source de tension de référence (VREF) ; et
   une source de tension d'alimentation négative (VNEG),
   le premier transistor (PMOS1, NMOS1) comportant une première borne de conduction, une deuxième borne de conduction, et une borne de commande,
   le deuxième transistor (PMOS2, NMOS2) comportant une première borne de conduction, une deuxième borne de conduction et une borne de commande,
   le premier amplificateur différentiel (AMP2) comportant une première borne d'entrée, une deuxième borne d'entrée et une borne de sortie, la première borne d'entrée étant reliée à la deuxième borne de conduction du deuxième transistor (PMOS2, NMOS2) par l'intermédiaire de la cinquième résistance (R2), la deuxième borne d'entrée étant reliée à une borne de drain du FET d'amplification (1), et la borne de sortie étant reliée à la borne de commande du premier transistor (PMOS1, NMOS1) ;
   le deuxième amplificateur différentiel (AMP3) comportant une première borne d'entrée, une deuxième borne d'entrée et une borne de sortie, la première borne d'entrée étant reliée à la deuxième borne de conduction du deuxième transistor par l'intermédiaire de la quatrième résistance (R1) et de la cinquième résistance (R2), la deuxième borne d'entrée étant reliée à la source de tension de référence (VREF), et la borne de sortie étant reliée à la borne de commande du deuxième transistor (PMOS2, NMOS2),
   le premier transistor (PMOS1, NMOS1) étant conçu de telle sorte que la première borne de conduction soit reliée à une tension d'alimentation (VDD) et que la deuxième borne de conduction soit reliée à une borne de grille du FET d'amplification (1),
   le deuxième transistor (PMOS2, NMOS2) étant conçu de telle sorte que la première borne de conduction soit reliée à une tension d'alimentation (VDD) et que la deuxième borne de conduction soit reliée à la terre par l'intermédiaire de la cinquième résistance (R2), de la quatrième résistance (R1) et de la troisième résistance (RR), dans cet ordre,
   la première résistance (R1) comportant une borne qui est reliée à la borne de drain, et une autre borne qui est reliée à la deuxième borne de conduction du deuxième transistor (PMOS2, NMOS2),
   la deuxième résistance (RG) comportant une borne qui est reliée à la borne de grille du FET d'amplification (1), et une autre borne qui est reliée à la source de tension d'alimentation négative (VNEG),
   ledit circuit de polarisation (16, 20) comprenant
   une première boucle d'asservissement négative qui contient le deuxième amplificateur différentiel (AMP3), et une deuxième boucle d'asservissement négative qui contient le premier amplificateur différentiel (AMP2), et
   le deuxième transistor (PMOS2, NMOS2), la cinquième résistance (R2) et la quatrième résistance (R1) faisant partie de la première boucle d'asservissement négative, tandis que le premier transistor (PMOS1, NMOS1) et le FET d'amplification (1) font partie de la deuxième boucle d'asservissement négative.

2. Circuit de polarisation (16, 20) tel qu'il est présenté dans la revendication 1, dans lequel le FET d'amplification est un HEMT (1).

3. Circuit de polarisation (16) tel qu'il est présenté dans la revendication 1, dans lequel le premier transistor et le deuxième transistor sont des MOSFET (MPOS1, PMOS2) ;
   la première borne de conduction, la deuxième borne de conduction et la borne de commande de chacun des premier et deuxième transistors sont une borne de source, une borne de drain et une borne de grille du canal p, respectivement ;
   la première borne d'entrée et la deuxième borne d'entrée du premier amplificateur différentiel sont une borne d'entrée positive et une borne d'entrée négative, respectivement ; et

la première borne d'entrée et la deuxième borne d'entrée du deuxième amplificateur différentiel (AMP3) sont une borne d'entrée positive et une borne d'entrée négative, respectivement.

4. Circuit de polarisation tel qu'il est présenté dans la revendication 1, dans lequel :

le premier transistor et le deuxième transistor sont des transistors bipolaires PNP ;
la première borne de conduction, la deuxième borne de conduction et la borne de commande de chacun des premier et deuxième transistors sont une borne émettrice, une borne collectrice et une borne de base des transistors bipolaires PNP, respectivement ;
la première borne d'entrée et la deuxième borne d'entrée du premier amplificateur différentiel (AMP2) sont une borne d'entrée positive et une borne d'entrée négative, respectivement, et
la première borne d'entrée et la deuxième borne d'entrée du deuxième amplificateur (AMP3) sont une borne d'entrée positive et une borne d'entrée négative, respectivement.

5. Circuit de polarisation (20) tel qu'il est présenté dans la revendication 1, dans lequel :

le premier transistor et le deuxième transistor sont des MOSFET à canal N (NMOS1, NMOS2) ;
la première borne de conduction, la deuxième borne de conduction et la borne de commande de chacun des premier et deuxième transistors sont une borne de drain, une borne de source et une borne de grille des MOSFET à canal N (NMOS1, NMOS2), respectivement ;
la première borne d'entrée et la deuxième borne d'entrée du premier amplificateur différentiel (AMP2) sont une borne d'entrée négative et une borne d'entrée positive, respectivement ; et
la première borne d'entrée et la deuxième borne d'entrée du deuxième amplificateur différentiel (AMP3) sont une borne d'entrée négative et une borne d'entrée positive, respectivement.

6. Circuit de polarisation tel qu'il est présenté dans la revendication 1, dans lequel :

le premier transistor et le deuxième transistor sont des transistors bipolaires NPN ;
la première borne de conduction, la deuxième borne de conduction et la borne de commande de chacun des premier et deuxième transistors sont une borne collectrice, une borne émettrice et une borne de base des transistors bipolaires NPN, respectivement ;
la première borne d'entrée et la deuxième borne d'entrée du premier amplificateur différentiel sont une borne d'entrée négative et une borne d'entrée positive, respectivement, et
la première borne d'entrée et la deuxième borne d'entrée du deuxième amplificateur différentiel sont une borne d'entrée négative et une borne d'entrée positive, respectivement.

7. Circuit de polarisation (16, 20) tel qu'il est présenté dans la revendication 1, comprenant également :

un élément de protection pour protéger de la tension ;
l'élément de protection étant prévu entre la deuxième borne de conduction du premier transistor (PMOS1, NMOS1) et la borne de grille du FET d'amplification (1).

8. Circuit de polarisation (16, 20) tel qu'il est présenté dans la revendication 1, dans lequel la source de tension de référence est un circuit de référence de tension interdite pour la sortie d'une tension interdite.

9. Circuit de polarisation (16, 20) tel qu'il est présenté dans la revendication 1, dans lequel le premier amplificateur différentiel (AMP2), le deuxième amplificateur différentiel (AMP3), le premier transistor (PMOS1, NMOS1), le deuxième transistor (PMOS2, NMOS2), la première résistance (RI), la deuxième résistance (RG), la troisième résistance (RR), la quatrième résistance (R1), la cinquième résistance (R2) sont intégrés dans un circuit intégré.

10. Circuit de polarisation (16, 20) tel qu'il est présenté dans la revendication 1, dans lequel la source de tension de référence (VREF) ou la source de tension d'alimentation négative (VNEG), ou les deux, sont intégrées dans le circuit intégré.

11. Amplificateur à faible bruit LNA (50) comprenant :

le FET d'amplification (1) dont la borne de source est mise à la terre ;
un circuit de polarisation (51) tel qu'il est présenté dans l'une quelconque des revendications 1 à 10,

la borne de grille du FET d'amplification servant de borne d'entrée de l'amplificateur à faible bruit (50) tandis que la borne de drain du FET d'amplification (1) sert de borne de sortie de l'amplificateur à faible bruit (50) .

12. Bloc convertisseur à faible bruit LNB (100) pour recevoir un signal par l'intermédiaire d'une antenne (101), amplifier et abaisser la fréquence du signal, et pour transmettre le signal amplifié et abaissé en fréquence à un étage ultérieur qui suit le bloc convertisseur à faible bruit, comprenant :

au moins un amplificateur à faible bruit (104, 105, 106) pour réaliser l'amplification du signal, l'amplificateur à faible bruit (104, 105, 106) étant un amplificateur à faible bruit (50) tel qu'il est présenté dans la revendication 11.

13. Récepteur (152) pour la communication, comprenant :

un dispositif récepteur (158) pour recevoir un signal provenant d'un canal de communication ; un amplificateur à faible bruit (159) pour amplifier un signal émis à partir du dispositif récepteur (158) ; l'amplificateur à faible bruit (159) étant un amplificateur à faible bruit (50) tel qu'il est présenté dans la revendication 11.

14. Transmetteur (151) pour la communication, comprenant :

un amplificateur à faible bruit (155) pour amplifier un signal à transmettre ; et un dispositif transmetteur (154) pour transmettre à un canal de communication le signal amplifié par l'amplificateur à faible bruit (155), l'amplificateur à faible bruit (155) étant un amplificateur à faible bruit (50) tel qu'il est présenté dans la revendication 11.

15. Système de détection (170) comprenant :

un dispositif de détection (171) pour détecter un changement d'objet et générer un signal sur la base du changement détecté ; un amplificateur à faible bruit (172) pour amplifier le signal émis à partir du dispositif de détection (171), l'amplificateur à faible bruit (172) étant un amplificateur à faible bruit (50) tel qu'il est présenté dans la revendication 11.

FIG. 1

FIG. 2

FIG. 3

FIG. 4

FIG. 5

FIG. 6

FIG. 7

FIG. 8

FIG. 9

FIG. 10

58

FIG. 11

EP 2 541 763 B1

FIG. 12

FIG. 13

0

(a)                    (b)                    (c)

1

2

FIG. 14

70

BGR voltage
BGR=Vbe+(Rp/Ri)*VT*ln(N)

71

VREF terminal          HEMT bias circuit

Ri

VT*ln(N)          Rp          (Rp/Ri)*VT*ln(N)

1 : N          Vbe

FIG. 15

FIG. 16

EP 2 541 763 B1

FIG. 17

150

Receiver
device
158

LNA 159

Signal
processing
circuit
161

152

VG terminal    VD terminal

HEMT
bias circuit 160

153

Communication
channel

HEMT
bias circuit 156

151

VG terminal    VD terminal

154

transmitter
device

LNA

155

157

Signal
processing
circuit

FIG. 18

170

171

Sensing device

172

LNA

174

Signal
processing
circuit

VG terminal    VD terminal

HEMT
bias circuit

173

FIG. 19

FIG. 20

VG=-0.4V when
ID=8mA and VD=2V

Drain current of HEMT (mA)

35mA
30mA
25mA
20mA
15mA
10mA
5mA
0mA

-1.5V    -1.0V    -0.5V    0.0V

Gate voltage of HEMT (V)

FIG. 21

FIG. 22

FIG. 23

520

521                              VNEG

Pulse generating
source

522

FIG. 24

Time ($\mu$ sec)

FIG. 25

FIG. 26

(a)　Drain Voltage

(b)　Drain Current

FIG. 27

| | Conventional Art | Present Example |
|---|---|---|
| HEMT drain voltage | $V_D \approx \dfrac{R_1}{R_1 + R_2} * VDD + V_{BE}$ | $V_D \approx \dfrac{R_R + R_1}{R_R} * VREF$ |
| HEMT drain current | $I_D \approx \dfrac{1}{R_E}\left(\dfrac{R_2}{R_1 + R_2} * VDD - V_{BE}\right)$ | $I_D \approx \dfrac{1}{R_I} * \dfrac{R_2}{R_R} * VREF$ |
| | Sensitive to change in temp. & power supply voltage | Not sensitive to change in temp. & power supply voltage |

FIG. 28

(a) Drain Voltage

(b) Drain Current

FIG. 29

(a) Drain Terminal

(b) Gate Terminal

FIG. 30

| | Conventional Art | Present Example |
|---|---|---|
| HEMT drain terminal | $PSRR_{V_D}\big|_{VDD} \approx 20 * \log\left(\dfrac{R_1}{R_1 + R_2}\right)$ | $PSRR_{V_D}\big|_{VDD} \approx 20 * \log\left(\dfrac{1}{A2}\right)$ |
| HEMT gate terminal | $PSRR_{V_G}\big|_{VDD} \approx 20 * \log\left(\dfrac{1}{R_E * Gm} * \left(\dfrac{R_2}{R_1 + R_2}\right)\right)$ | $PSRR_{V_G}\big|_{VDD} \approx 20 * \log\left(\dfrac{1}{A2} * \dfrac{1}{Gm * R_I}\right)$ |
| | Sensitive to change in power supply voltage VDD | Not sensitive to change in power supply voltage VDD |

## FIG. 31

( a ) Drain Terminal

( b ) Gate Terminal

FIG. 32

| | Conventional Art | Present Example |
|---|---|---|
| HEMT drain terminal | $PSRR_{V_D}\big|_{VNEG} \approx 20*\log\left(\dfrac{1}{1+gm*R_C}\right)$ | $PSRR_{V_D}\big|_{VNEG} \approx 20*\log\left(\dfrac{1}{A2}*\dfrac{1}{gm*R_G}\right)$ |
| HEMT gate terminal | $PSRR_{V_G}\big|_{VNEG} \approx 20*\log\left(\dfrac{1}{1+Gm*R_C}\right)$ | $PSRR_{V_G}\big|_{VNEG} \approx 20*\log\left(\dfrac{1}{A2}*\dfrac{1}{Gm*gm*R_G*R_I}\right)$ |
| | Sensitive to change in negative power supply voltage VNEG | Not sensitive to change in negative power supply voltage VNEG |

FIG. 33

FIG. 34

FIG. 35

FIG. 36

FIG. 37

FIG. 38

EP 2 541 763 B1

FIG. 39

FIG. 40

FIG. 41

EP 2 541 763 B1

82

FIG. 42

Polarized wave
selecting signal

1204  VD

1202 — HEMT bias circuit

ON

OFF

ON

OFF

1203

VG

ID

1200

1201:HEMT

FIG. 43

Polarized wave
selecting signal

OFF          ON          OFF

VD

VG

Shoot-through
current

ID

Shoot-through
current

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 59194522 A
- JP 2006081009 A
- JP 60119107 A
- JP 4120906 A
- JP H03117930 U
- US 20030038679 A1